Europäisches Patentamt

European Patent Office

Office européen des brevets

(19)

(11) Publication number: **0 188 866**
**A2**

(12) **EUROPEAN PATENT APPLICATION**

(21) Application number: 85305224.9

(22) Date of filing: 23.07.85

(51) Int. Cl.⁴: **G 05 B 11/06**, G 05 F 1/575

(30) Priority: 09.01.85 GB 8500481

(43) Date of publication of application: 30.07.86
Bulletin 86/31

(84) Designated Contracting States: **AT BE CH DE FR IT LI LU NL SE**

(71) Applicant: **Miller, Gary, 20 Prospect Road, Severn Beach Avon BS12 3QB (GB)**

(72) Inventor: **Miller, Gary, 20 Prospect Road, Severn Beach Avon BS12 3QB (GB)**

(54) Multiple loop feedback systems.

(57) A multiple loop feedback system arrangement as typically shown in the diagram which may be used to construct a control system, electronic amplifier or electronic regulator. The input signal combiners G1(s) and G2(s) are selected to be either summing, summing inverting or differential and G3(s) is selected to be either inveting or noninverting so that the signal loop formed by G1(s), and G2(s) has a net phase shift of zero degrees and the signal loop formed by G1(s), G3(s), B(s) and G2(s) has a net phase shift of 180 degrees. By setting the gain of the zero phase shift loop to unity a balanced condition occurs where the error signals generated in G3(s) do not appear at the output Qo. Other embodiments of this invention include an arrangement where the input of G3(s) is coupled to the output of G2(s).

## MULTIPLE LOOP FEEDBACK SYSTEMS

### TECHNICAL FIELD

This invention relates to the following technical fields :

(a) Closed loop control systems as difined in Feedback and Control Systems Analysis and Synthesis by J.J D'Azzo and C.H Houpis published by Mc Graw Hill (Ref 1 ) .

(b) Electronic Amplifiers .

(c) Electronic Regulators .

### PRIOR ART CLOSED LOOP CONTROL SYSTEMS

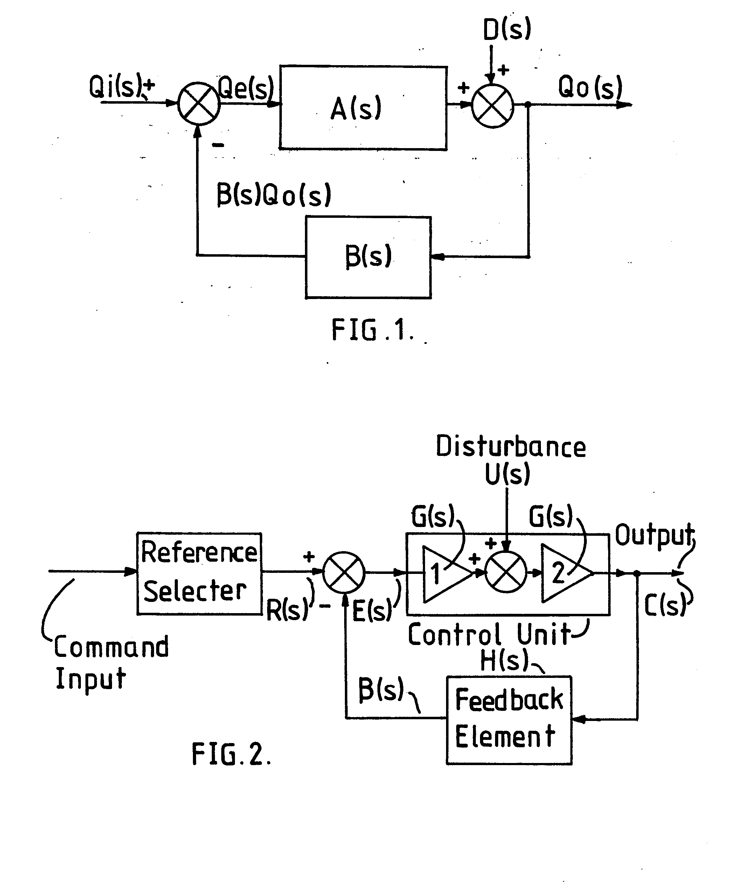

Present art closed loop control systems are described in Ref 1 but are included here to illustrate the fundimental limitations of the present art . Fig 2 shows in a basic block diagram form a closed loop control system .

The output $C(s)$ is related to the input $R(s)$ by the solution of the following simultaneous equations:

$$C(s) = U(s)G2(s) + E(s)G1(s)G2(s)$$
$$E(s) = R(s) - B(s)$$
$$B(s) = H(s)C(s)$$

ie

$$C(s) = \frac{U(s)G2(s)}{1 + H(s)G1(s)G2(s)} + \frac{R(s)G1(s)G2(s)}{1 + H(s)G1(s)G2(s)}$$

The output controlled variable $C(s)$ ideally equals:

$$\frac{R(s)}{H(s)}$$

and is therefore not effected by any other variables in the equation . In a practical control system $H(s)$ has a stable characteristic and as far as possible defines the control ratio . The external disturbance $U(s)$ must be reduced as far as possible and this is accomplised by making $G1(s)$ as large as possible. Looking at the first term of the equation:

$$C(s) = \frac{U(s)G2(s)}{1 + H(s)G1(s)G2(s)} = \frac{U(s)}{\dfrac{G1(s)}{\dfrac{1}{G1(s)G2(s)} + H(s)}}$$

To reduce $U(s)$ to zero at the output $C(s)$ , $G1(s)$ would have to be infinite . Looking at the second term :

$$\frac{R(s)G1(s)G2(s)}{1 + H(s)G1(s)G2(s)} = \frac{R(s)}{\dfrac{1}{G1(s)G2(s)} + H(s)}$$

For the gain variations to have no effect on C(s) the gain of either G1(s) or G2(s) would have to be infinite.

Under the condition:

$$\left| G1(s) \right| = \infty$$
$$C(s) = \frac{R(s)}{H(s)}$$

In practice finite gains are only available and G1(s),G2(s) and U(s) will effect the output C(s) to some degree . This then is one of the basic limitations of the present art ie large gain requirements and only partial reduction of the errors introduced by G1(s),G2(s) and U(s) .

A further limitation, given a finite gain ( G1(s) and G2(s) ), is that the loop gain cannot be increased indefinately because the stability of the system will be dangerousely impaired . The gain elements G1(s) and G2(s) will have in the majority of cases multiple Poles associated with them in the left half of the S Plane . As the loop gain is increased by increaseing H(s) and so reduce the effects of G1(s),G2(s) and U(s) on the output C(s) , a point is reached where the Poles cross to the Right half of the S Plane and oscillation occurs. Poles and/or Zeros can be added to the system which will bring about stability but these will reduce the loop gain at higher frequencys.

Another limitation of the preasent art is that increasing H(s) also reduces the magnitude of the control ratio to a point where it becomes less than useful.

Looking at the second term of the system equation again ;

$$\frac{R(s)G1(s)G2(s)}{1 + H(s)G1(s)G2(s)}$$

If $\left| H(s)G1(s)G2(s) \right| \gg 1$

as is the case to approach the condition;

$$C(s) \approx \frac{R(s)G1(s)G2(s)}{H(s)G1(s)G2(s)} = \frac{R(s)}{H(s)}$$

then $\left| 1 + H(s)G1(s)G2(s) \right| > 1$

This will give $\left| \dfrac{C(s)}{R(s)} \right| < \left| G1(s)G2(s) \right|$

The feedback therefore reduces the magnitude of the overall system gain ( $C(s)/R(s)$ ) to a value which is much less than the open loop transfer function , $G1(s)G2(s)$ .

When        $1 + H(s)G1(s)G2(s) > 1$

the resulting feedback is termed NEGATIVE or DEGENERATIVE FEEDBACK .

## PRIOR ART FEEDBACK AMPLIFIERS

Fig 1 shows in a basic block diagram form a feedback amplifier with $Qo(s)$ and $Qi(s)$ representing either voltages or currents depending on the exact method of closing the feedback loop. The output $Qo(s)$ is related to the input $Qi(s)$ by the solution of the following simultaneous equations;

$$Qo(s) = Qe(s)A(s) + D(s)$$
$$Qe(s) = Qi(s) - B(s)Qo(s)$$

ie:

$$Qo(s) = \frac{Qi(s)A(s)}{1 + B(s)A(s)} + \frac{D(s)}{1 + B(s)A(s)}$$

The output voltage/current $Qo(s)$ ideally equals:

$$\frac{Qi(s)}{B(s)}$$

and is therefore not effected by any other variables in the equation. In a practical feedback amplifier $B(s)$ is usally a resistor network and as far as possible defines the closed loop gain. The error variable $D(s)$ isan internally generated voltage/current in $A(s)$ which repreasents harmonic distortion , intermodulation distortion , noise , supply ripple etc which must be reduced as far as possible. This is accomplised by making $A(s)$ as large as possible. Looking at the second term of closed loop equation:

$$Qo(s) = \frac{D(s)}{1 + B(s)A(s)}$$

To reduce $D(s)$ to zero at the output $Qo(s)$ , $A(s)$ would have to be infinite. Looking at the first term of the closed loop equation:

$$Qo(s) = \frac{Qi(s)A(s)}{1 + B(s)A(s)} = \frac{Qi(s)}{\frac{1}{A(s)} + B(s)}$$

For the gain variations to have no effect on the output $Qo(s)$ the gain of $A(S)$ in it self would have to be infinite.

Under the condition:

$$|A(s)| = \infty$$

$$Qo(s) = \frac{Qi(s)}{B(s)}$$

With finite gain in $A(s)$, $A(s)$ and $D(s)$ will effect the closed loop gain and increasing the loop gain by increasing $B(s)$ will eventually cause oscillation as in the control system case. Poles and/or zeros can added to bring about stability but these will reduce the loop gain at high frequencys . A further disadvantage of increasing $B(s)$ and so reduce the effects of $A(s)$ and $D(s)$, is that a point is reached where the closed loop gain becomes less than useful .

If

$$1 + B(s)A(s) > 1$$

as is usual then:

$$\frac{Qo(s)}{Qi(s)} < A(s)$$

and the resulting feedback is termed NEGATIVE or DEGENERATIVE FEEDBACK.

### PRIOR ART FEEDBACK REGULATORS

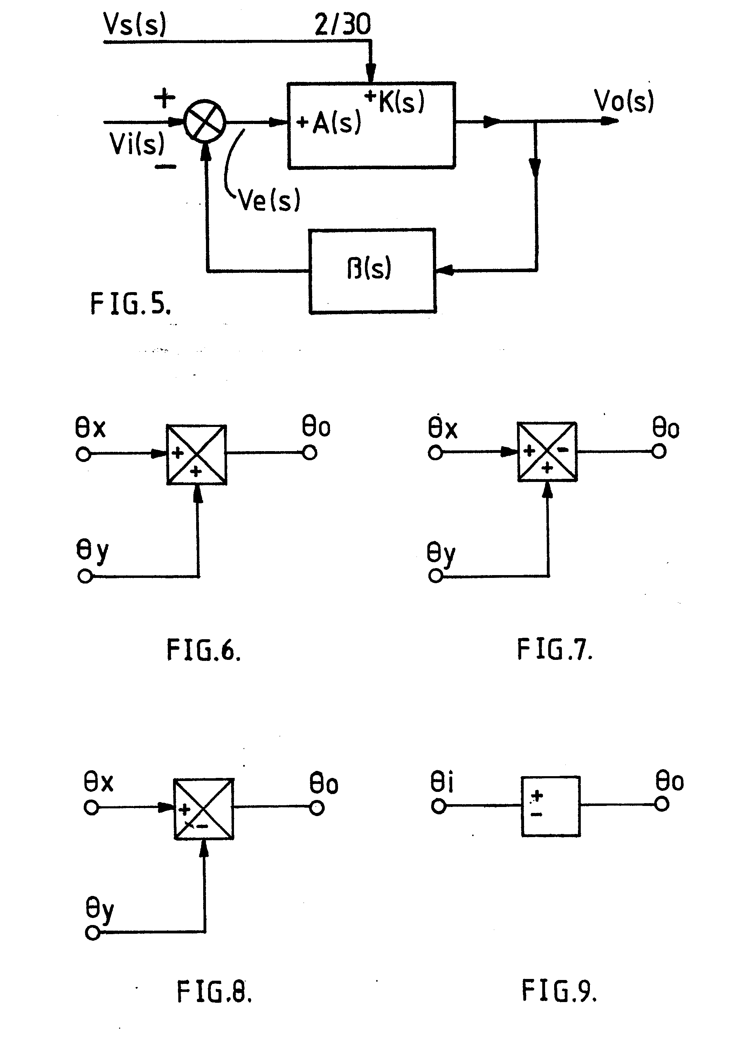

Fig 5 shows in a basic block diagram form a feedback regulator with $Qo(s)$ , $Qi(s)$ and $Qs(s)$ representing either voltages or current depending on the exact method of closeing the feedback loop. The output $Qo(s)$ is related to the input reference $Qi(s)$ by the solution of the following simultaneous equations.

$$Qo(s) = Qe(s)A(s) + Qs(s)K(s)$$
$$Qe(s) = Qi(s) - B(s)Qo(s)$$

ie:

$$Qo(s) = \frac{Qi(s)A(s)}{1 + B(s)A(s)} + \frac{Qs(s)K(s)}{1 + B(s)A(s)}$$

The output voltage/current $Qo(s)$ ideally equals:

$$\frac{Qi(s)}{B(s)}$$

and is therefore not effected by any other variables in the equation. In a practical feedback regulator $B(s)$ is a resistor network and as far as possible defines the closed loop gain. The variable $Qs(s)$ is the supply voltage/current whose variations must be reduced at the output $Qo(s)$.

Looking at the second term of the closed loop equation:

$$Qo(s) = \frac{Qs(s)K(s)}{1 + B(s)A(s)}$$

To reduce $Qs(s)$ to zero at the output $Qo(s)$, $A(s)$ would have to be infinite. Looking at the first term of the closed loop equation:

$$Qo(s) = \frac{Qi(s)A(s)}{1 + B(s)A(s)} = \frac{Qi(s)}{\frac{1}{A(s)} + B(s)}$$

For the gain variations to have no effect on the output $Qo(s)$ the gain of $A(s)$ in its self would have to be infinite. Under the condition:

$$\left| A(s) \right| = \infty$$
$$Qo(s) = \frac{Qi(s)}{B(s)}$$

With finite gain in $A(s)$, $A(s)$ and $Qs(s)$ willeffect the output $Qo(s)$ and increasing the loop gain by increasing $B(s)$ will cause oscillation as in the control system case. Poles and/or zeros can be added to bring about stability but these will reduce the loop gain at high frequencys. A further disadvantage of increasing $B(s)$ and so reduce the effects of $A(s)$ and $Qs(s)$, is that a point is reached where the closed loop gain becomes less than useful.

If

$$1 + B(s)A(s) > 1$$

as is usual then

$$\frac{Qo(s)}{Qi(s)} < A(s)$$

and the resulting feedback is termed NEGATIVE or DEGENERATIVE FEEDBACK.

---

### Discription of Multiple Loop Feedback Systems

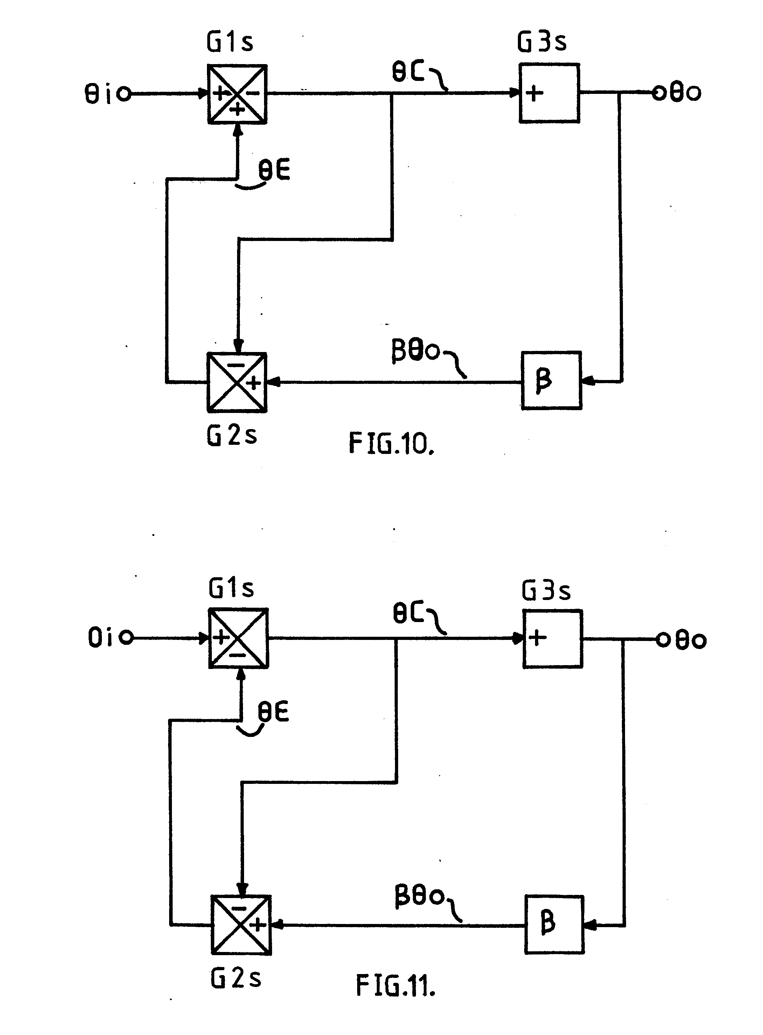

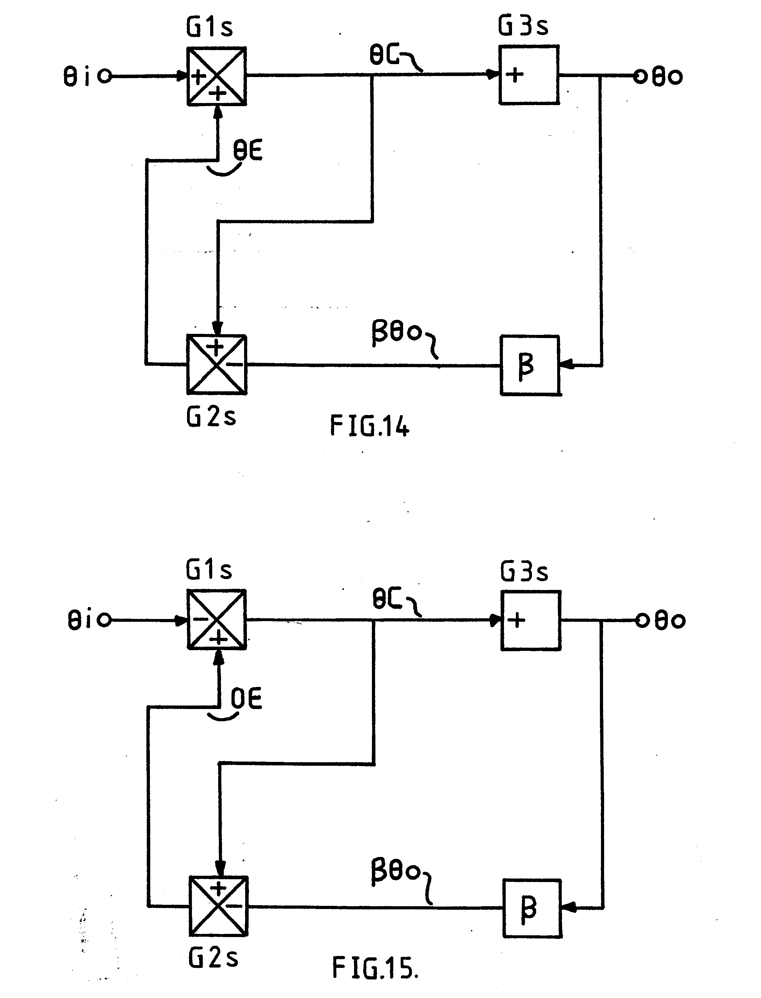

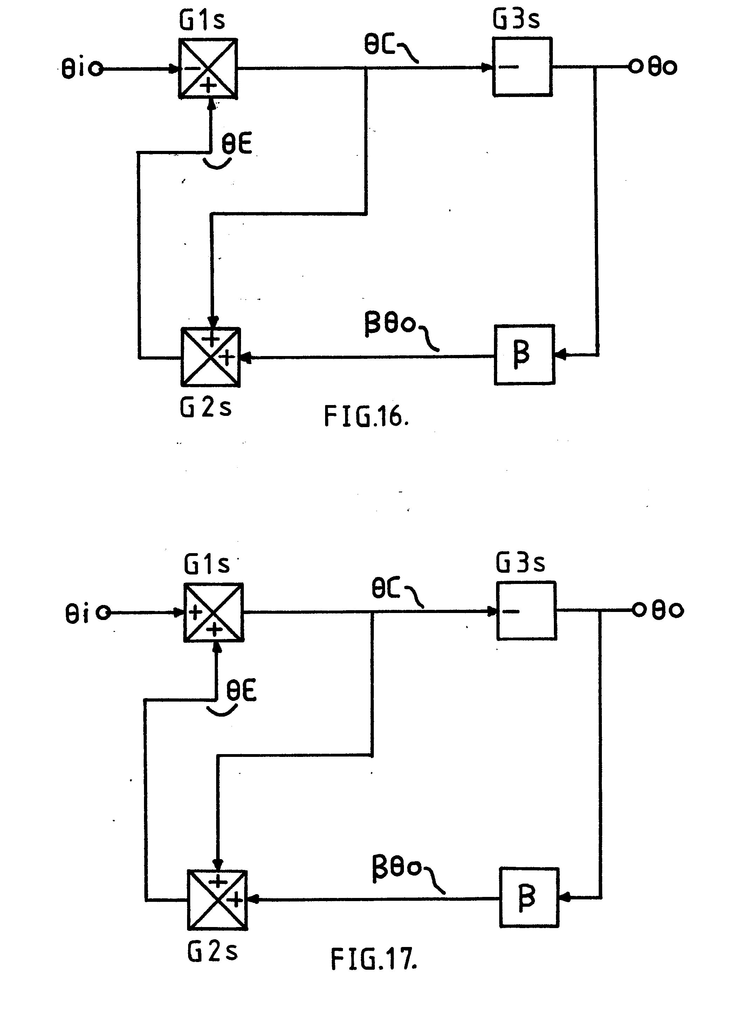

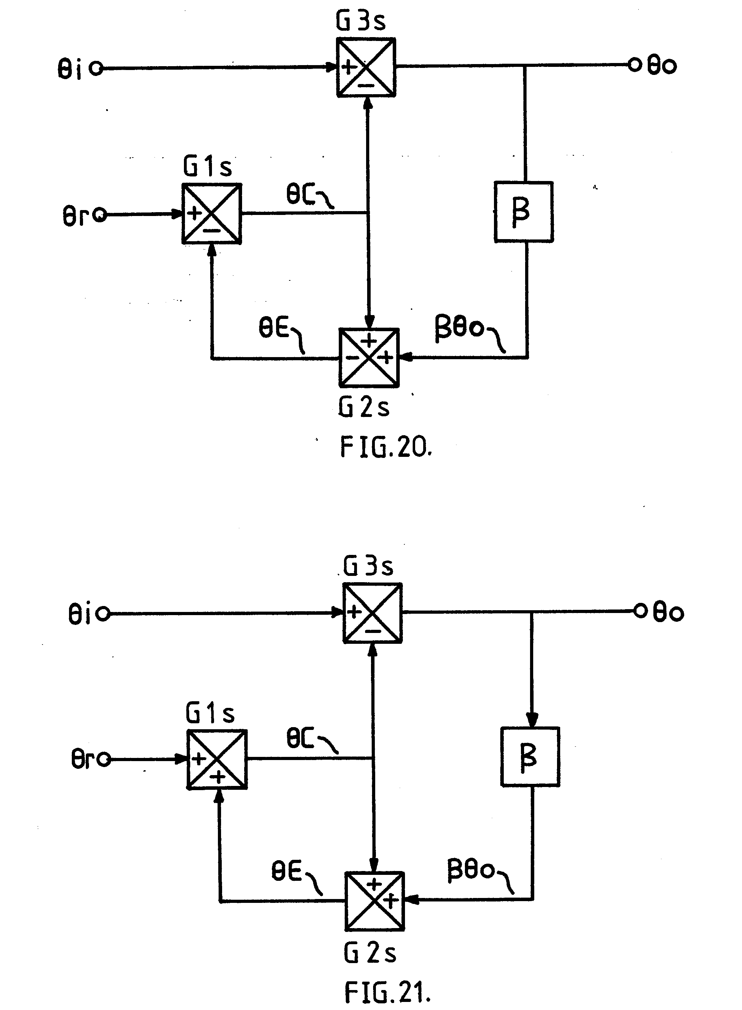

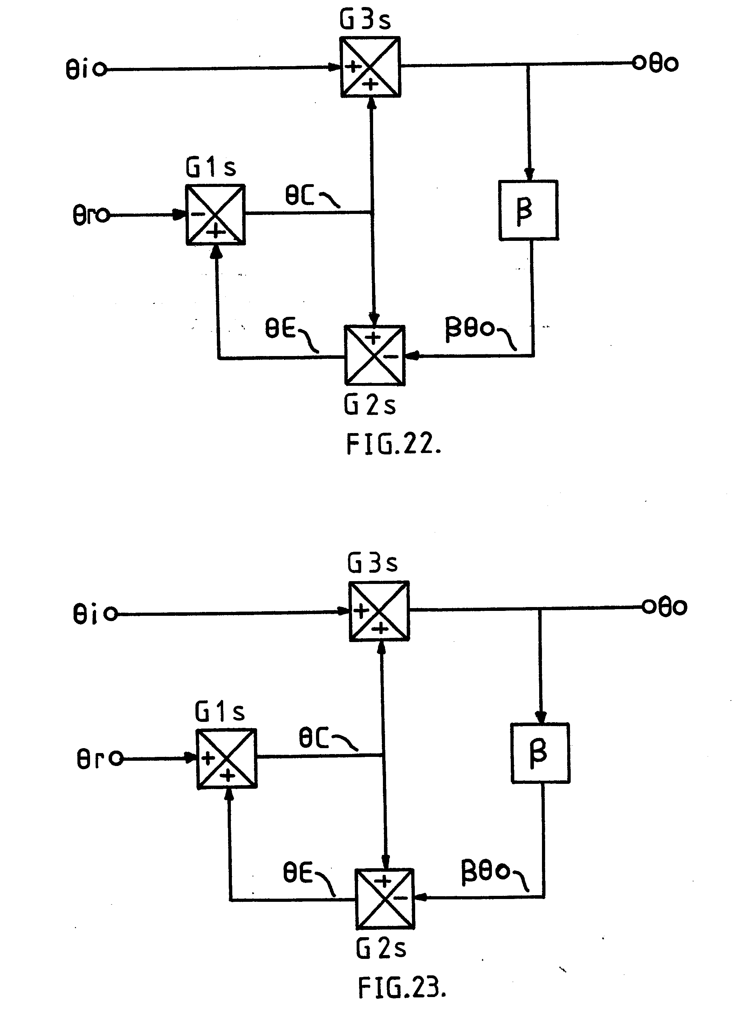

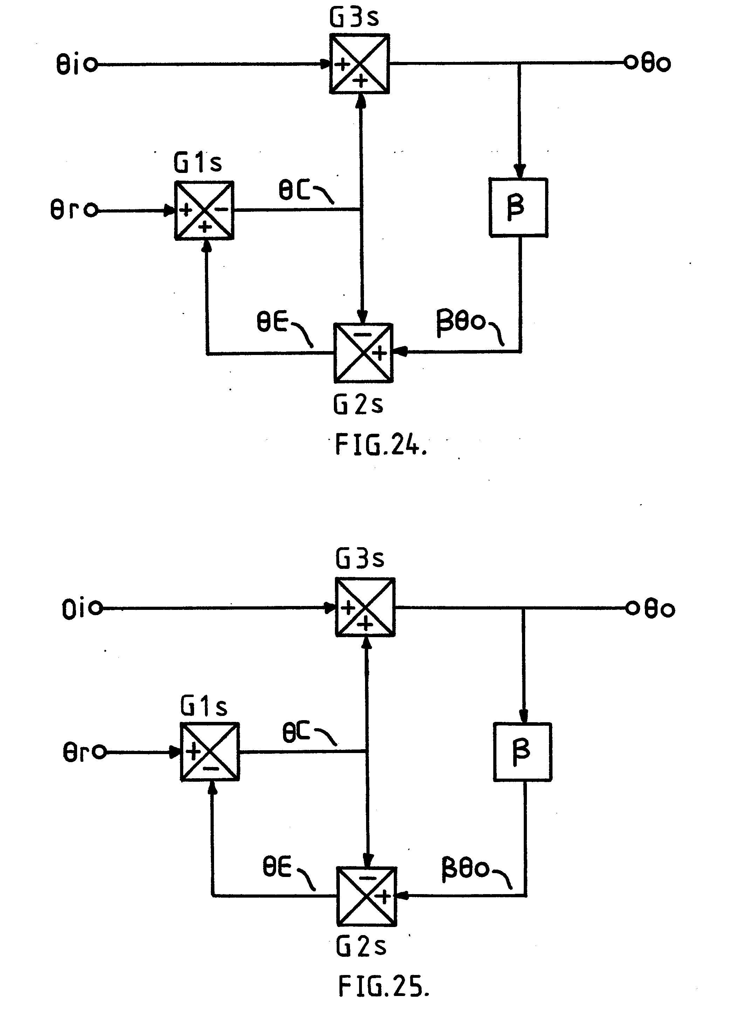

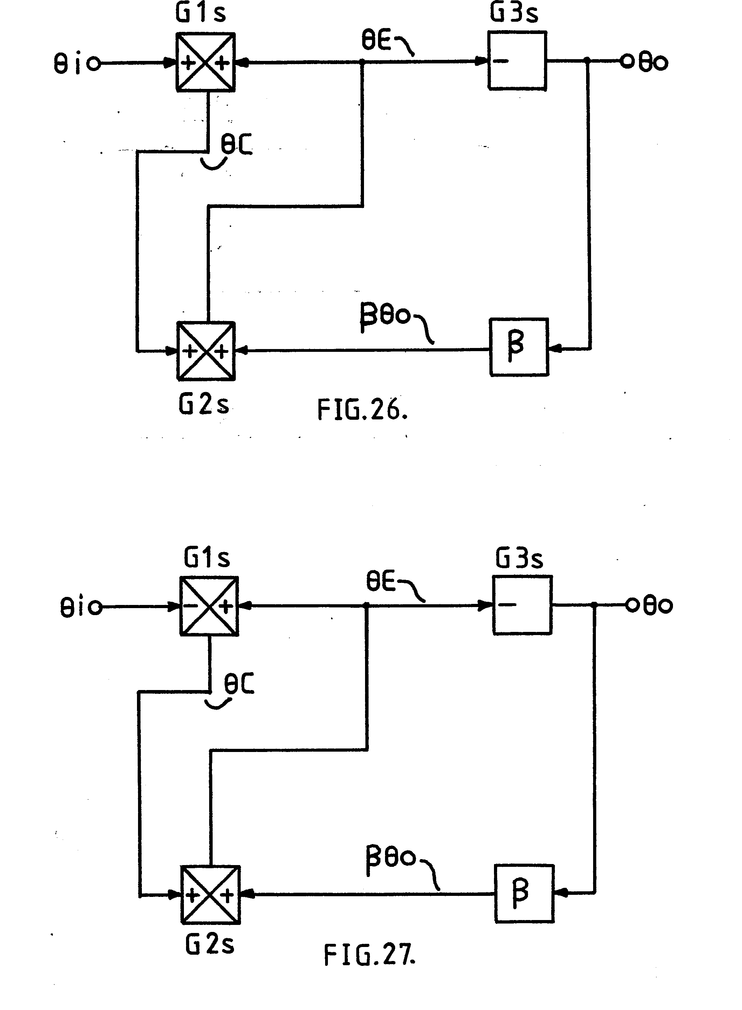

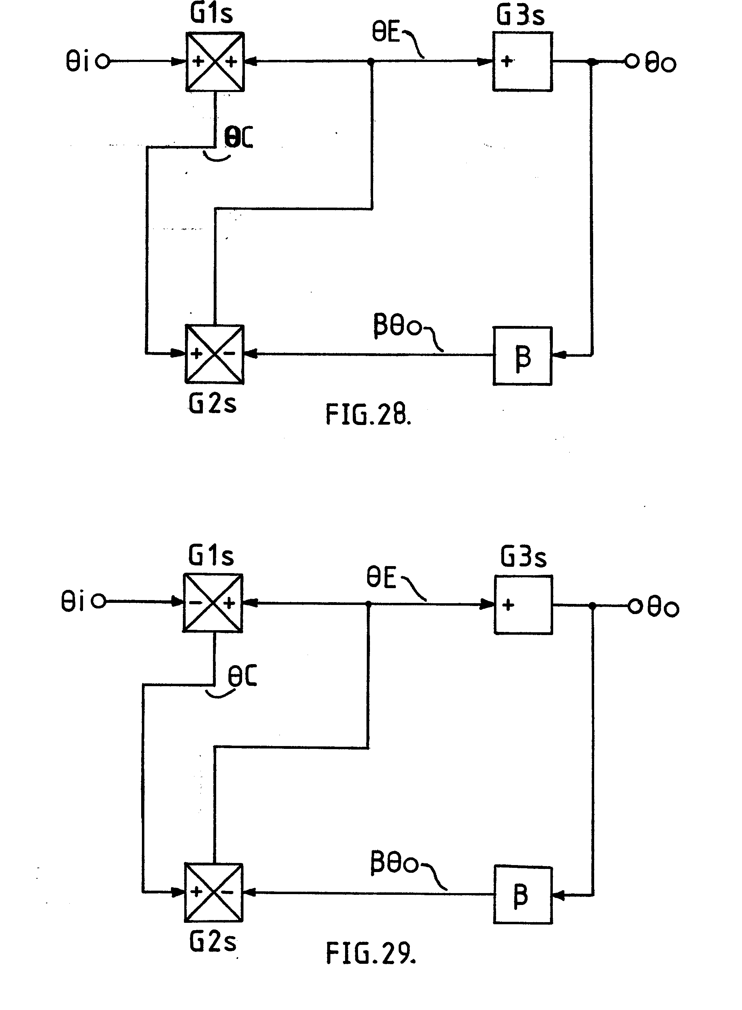

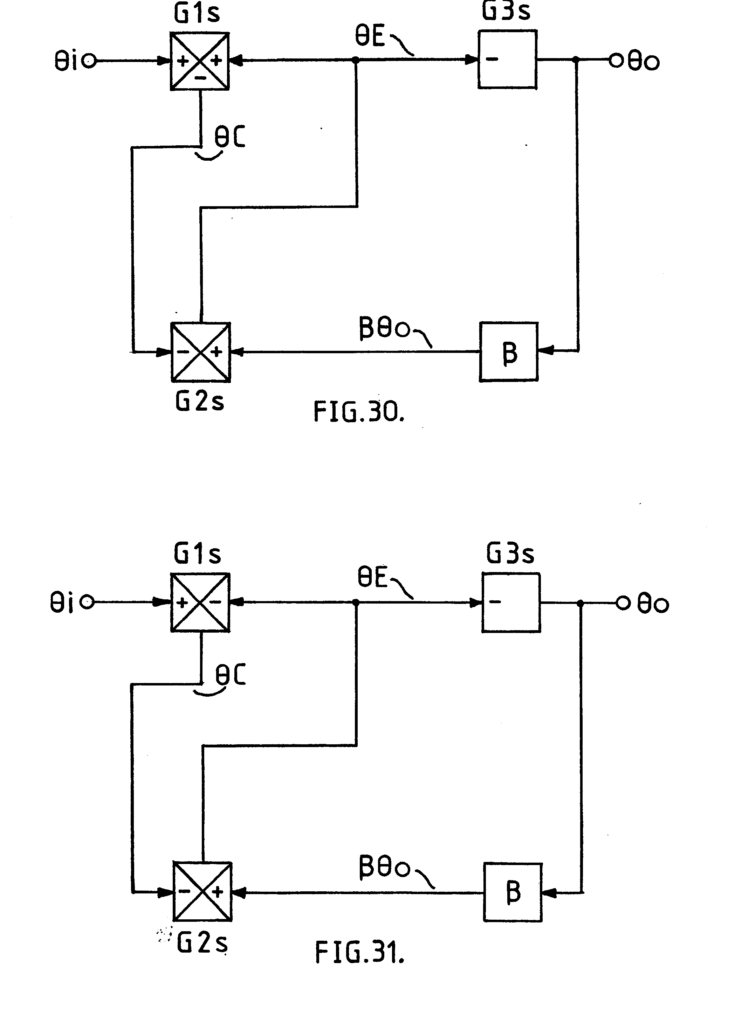

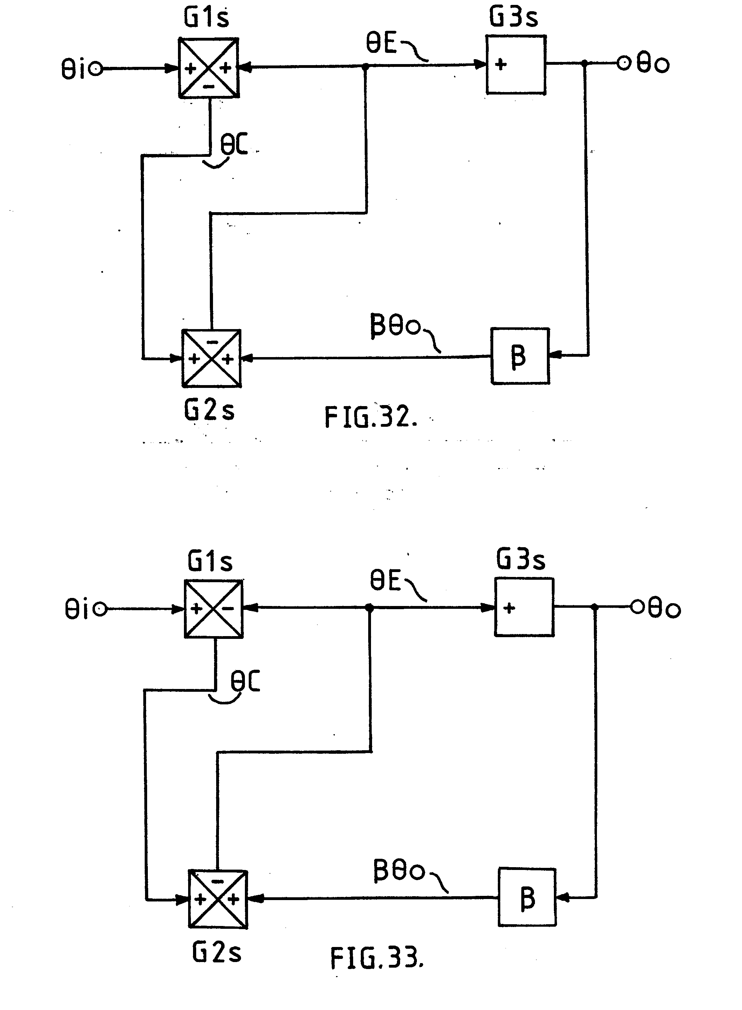

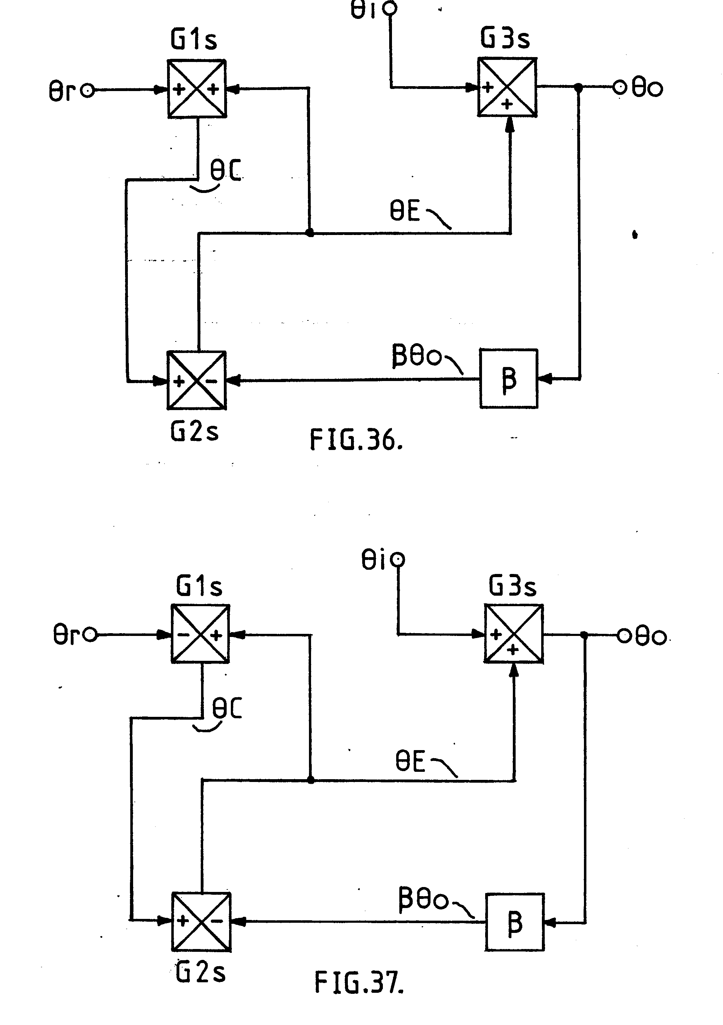

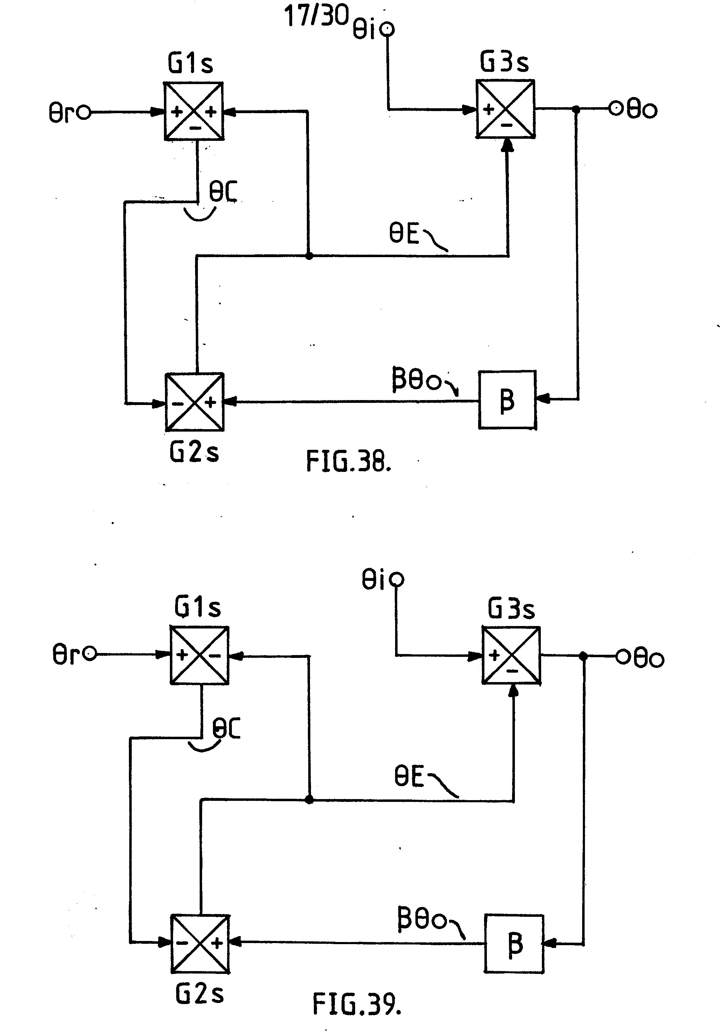

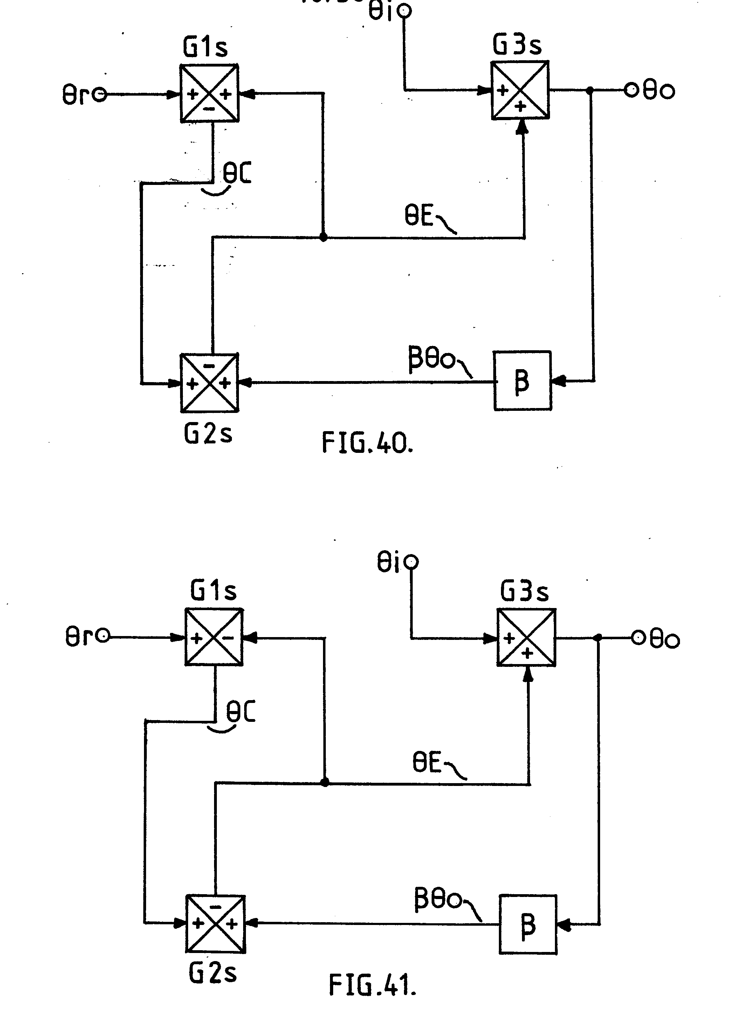

Fig 10 to Fig 41 is the new feedback technique in a block diagram form. Fig 10 to 25 is designated as a type A multiple loop feedback system, where the input of G3(s) is connected to the output of G1(s). Fig 26 to 41 is designated as a type B multiple loop feedback system, where the input of G3(s) is connected to the output of G2(s). These diagrams can either represent a closed loop feedback control system, a voltage/current/power amplifier or a voltage/current regulator. The signal combiners or combining blocks G1(s) and G2(s) are also shown in Figs 6 , 7 and 8 and can either be additiveor summing as in Fig 6 , summing inverting as in Fig 7 or differential as in Fig 8 . All other combinations of input and output signs ( + or - ) being capable of convertion to one of these three form -s . The quantitys being applied to the inputs of G1(s) and G2(s) are in the same form ie two voltages can be applied but a voltage and force cannot. The combining blocks are either active as in the case of a semiconductor circuit amplifier , valve amplifier etc or passive as in the case of a resistor network.

For Fig 6

$$Qo = Qx\ G(s)a + QyG(s)b$$

For Fig 7

$$-Qo = QxG(s)\ a + QyG(s)b$$

For Fig 8

$$Qo = QxG(s)\ a - Qy(s)b$$

where $Q = \theta$ .

The variables a and b have added to take into account different transfer functions for each input. In the system arrangments ( fig 10 to 41 ) , G1(s) and G2(s) are represented by either figs6 , 7 or 8 , with c and d input transfer functions for G2(s) The output block G3(s) is shown in figs 6 , 8 or 9.

### Type A Multiple loop feedback system

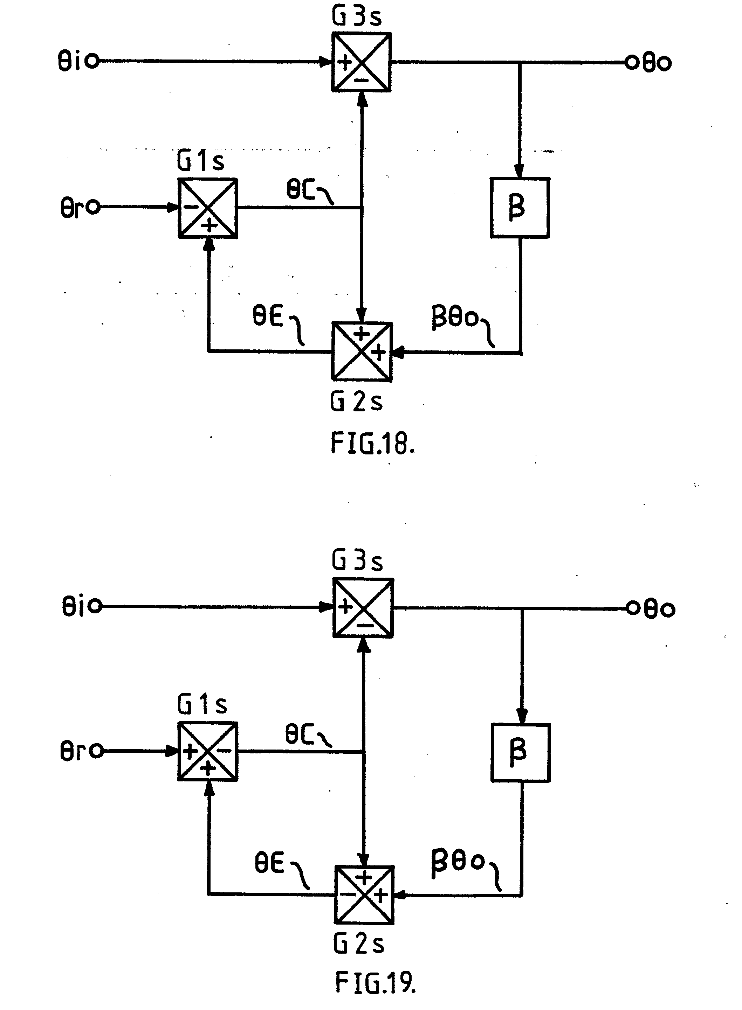

Figs 10 to 25 are block diagrams of the type A system ,Figs 10 to 17can be used to represent either a control system , an amplifier or a regulator. Figs 18 to 25 are block diagrams of a more specific use as a voltage/current regulator where throughtput is controlled or may be used to show the effect of an external disturbance to G3(s) .

## Type B  Multiple  Loop  Feedback  system

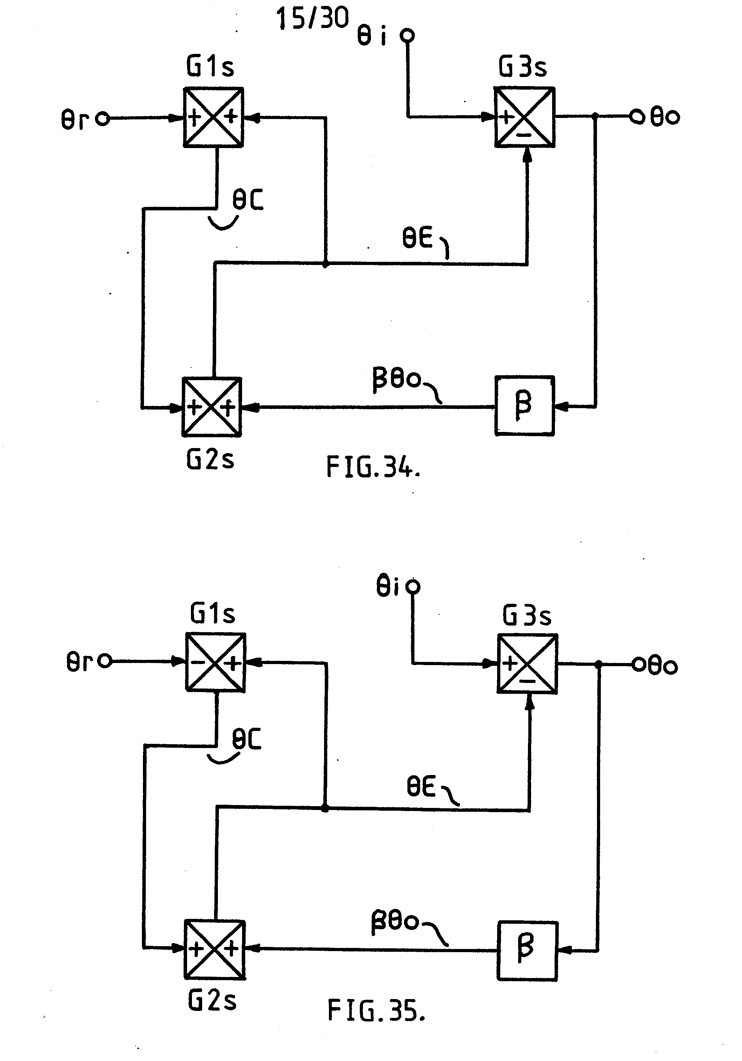

Fig 26  to  41  are  block  diagrams  of  the  type  B  system . Figs  26  to  33  can  be  used  to  represent  either  a  control  system ,  an  amplifier  or  a  regulator . Figs 34  to  41  are  block  diagrams  of  a  more  specific  use  as  a  voltage/current  regulator  where  throughtput  is  controlled  or  may  be  used  to  show  the  effect  of  an  external  disturbance  to  $G3(s)$ .

The  object  of  the  invention  is  to  provide  a  control  system,  electronic  amplifier  or  electronic  regulator  whose  output  $Qo$  is  only  dependent  on  $Qi$  and  $Bs$ for  Figs 10  to  17   ,   26  to  33  and  $Qi$  and  $Bs$ for  Figs 18  to 25  ,  34  to  41 .  Any  internally  generated  error  signals  in  $G3(s)$  or  externally  generated  error  signals  coupled  to  $G3(s)$  are  totally  rejected  and  donot  appear  at  the  output  $Qo(s)$. The  multiple  loop  feedback  arrangment  thus  provides  a  signal  input  to  $G3(s)$  which  comprises  the  required  output  plus  a  correction  signal  which  cancels  the  errors  in  $G3(s)$ . The  system  gain  is  as  far  as  possible  provide  by  $G3(s)$  as  its  errors  are  totally  rejected  from  $Qo(s)$ .  $G1(s)$  and  $G2(s)$  are  assumed  to  have  linear  characteristics  or  operated on  linear  portions  of  there  characteristics  and  are  stable.

In  accordance  with  the  invention  there  is  provided  a  multiple  loop  feedback  system  arrangment  as  in  Figs 10  to  17  comprising :
an  output  amplifier ( or  Control unit )  $G3(s)$ ,
a  feedback  network ( or  element )  $B(s)$  whose  input  is  coupled  to  the  output  of  the  said  output  amplifier ( or control unit ) ,
a  signal  combining  block $G2(s)$  having  two  inputs  $Gc$  and  $Gd$  respectively  coupled  to  the  input  of  said  output  amplfier ( or  control unit )  and  to  the  output  of  the  said  feedback  network ( or  element  )  $B(s)$ ,  a  combining  block $G1(s)$  having  a  input  $Gb$  coupled  to  the  output  of  said  combining  block $G2(s)$  and  a  input  $Ga$  forming  the  signal  input  $Qi$ of  said  arrangment  and  a  output  coupled  to  the  input  of  said  output  amplfier (or  control  unit ) , the  output  of  said  output  amplifier ( or  control unit )  forming  the  output  $Qo$  of  said  arrangment .

For  figs 10  to 17  the  signal  path  around  the  loop  for-mend  by  $Gb(s).Gc(s)$  is  non  inverting .

Using Fig 10 for example it can be seen that $Gb(s)$ and $Gc(s)$ are both inverting . Therefore :

$$\underline{/Gb(s)} + \underline{/Gc(s)} = \underline{/180^{\circ}} + \underline{/180^{\circ}} = \underline{/0^{\circ}}$$

ie a positive feedback loop is formed by $Gb(s)$ and $Gc(s)$ with a combined phase shift around the loop of $\underline{/0^{\circ}}$ .

With the input to $Gd(s)$ disconnected the positive feedback loop will cause $G1(s)$ and $G2(s)$ to saturate at some positive or negative values of $Qc(s)$ and $Qe(s)$ under the conditions :

$$|Gb(jw)| \cdot |Gc(jw)| > 1$$

and if the loop is zero frequency coupled.

If the loop is not zero frequency coupled , the loop oscillate at a frequency where:

$$\left|Gb(jw)\right| \cdot \left|Gc(jw)\right| > 1$$

and

$$\underline{/Gb(jw)} + \underline{/Gc(jw)} = \underline{/0^{\circ}} \qquad \text{Where } s = jw$$

Under normal operating conditions $Gd(s)$ is connected and so providing a stable system.

For Figs 10 to 17 the signal path around the loop formed by $Gb(s).G3(s)B(s).Gd(s)$ is inverting . Using Fig 10 for example $Gb(s)$ , $G3(s)$ and $Gd(s)$ are all inverting , with $B(s)$ noninverting Therefore :

$$\underline{/Gb(s)} + \underline{/G3(s)} + \underline{/B(s)} + \underline{/Gd(s)} = \underline{/180^{\circ}} + \underline{/180^{\circ}} + \underline{/0^{\circ}} + \underline{/180^{\circ}} = \underline{/180^{\circ}}$$

ie a negative feedback loop is formed with a net phase shift of $\underline{/180^{\circ}} . = -1$

For the type A system $Qe(s)$ is the difference between $Qc(s)$ and $B(s) Qo(s)$ , if $Qc(s) = B(s)$ then $Qe(s) = 0$ , clearly $Qe(s)$ is the error between $Qc(s)$ and $B(s)Qo(s)$ and the type A system can be called a Error feedback system.

To construct the said arrangment then the signal combiners and $G3(s)$ are chosen such that the said noninverting feedback loop and the said inverting feedback loop are obtained as in Figs 10 to 17 . $B(s)$ is only shown in a noninverting form as it would most likly be in the case of a electronic amplifier or electronic regulator, where it would be passive ie a resistor attenuatorUnder the two said conditions:

With $s = jw$

$$\frac{Qo}{Qi} = \frac{Ga(jw) \; G3(jw)}{1 - Gb(jw) \; Gc(jw) + B(jw) \; Gb(jw) \; Gd(jw) \; G3(jw)}$$

and

$$\frac{Qo}{Qi} = \frac{- Ga(jw)G3(jw)}{1 - Gb(jw)\ Gc(jw) + B(jw)\ Gb(jw)\ Gd(jw)\ G3(jw)}$$

These two equations as derived from lines 718 to 921 , with there assciated system diagrams , differ by the change in sign in the nominator and so provide said systems arrangments which are noninverting or inverting .

If G1(jw) and G2(jw) are linear or are operated on linear portions of there characteristics then there gains can be adjusted so that:

$$Gb(jw)\ Gc(jw) = 1 \underline{/0^o}$$

ie

$$\left|Gb(jw)\right| . \left|Gc(jw)\right| = 1$$

and

$$\underline{/Gb(jw)}\ \ \underline{/Gc(jw)} = \underline{/0^o}$$

Then under these conditions of unity gain and zero phase shift the denominator will reduce ie:

$$1 - Gb(jw)\ Gc(jw) + B(jw)\ Gb(jw)\ Gd(jw)\ G3(jw)$$
$$= B(jw)\ Gb(jw)\ Gd(jw)\ G3(jw)$$

as $1 - Gb(jw)\ Gc(jw) = 0$

Then
$$\frac{Qo}{Qi} = \frac{Ga(jw)G3(jw)}{B(jw)Gb(jw)Gd(jw)G3(jw)} = \frac{Ga(jw)}{B(jw)Gb(jw)Gd(jw)}$$

and
$$\frac{Qo}{Qi} = \frac{-Ga(jw)G3(jw)}{B(jw)Gb(jw)Gd(jw)G3(jw)} = \frac{- Ga(jw)}{B(jw)Gb(jw)Gd(jw)}$$

The output Qo is therefore independant of G3(s) under the balanced condition , 1   Gb(jw)Gc(jw) = 0 , any errors generated in or coupled to G3(s) will not appear at the output . This then is one of the features of the said system and is a advance over the present art which requires infinite gain to reduce system errors to zero.

In accordance with the invention there is provided a multiple loop feedback system arrangment as in Figs 18 to 25 comprising:

an output amplifier ( or control unit ) G3(s) having two inputs Ge and Gf ,
a feedback network ( or element ) B(s) whose input is coupled to the output of the said output amplifier ( or control unit ) ,
a signal combining block G2(s) having two inputs Gc and Gd respectively coupled to the Gf input of said output amplifier ( or control unit ) and to the ouput of said feedback network ( or element ) B(s) , a signal combining block G1(s) having two inputs Gb and Ga repectively coupled to the output of said signal combining block G2(s) and a signal input forming the first input Qr to said arrangment and a output which is coupled to the Gf input of said output amplifier ( or control unit ) , the Ge input of said output amplifier ( or control unit ) forming the second input Qi to the said arrangment , the output of said output amplifier ( or control unit ) forming the output of said arrangment.

Lines 187 to 223 also apply to Figs 18 to 25 but G3(s) must be replaced by Gf(s) in the script and can be read again if required .

With s=jw

$$Q_o = Q_i \, G_e(jw) + \frac{Q_r \, G_a(jw)G_f(jw) - Q_i \, B(jw)G_b(jw)G_d(jw)G_e(jw)G_f(jw)}{1 - G_b(jw)G_c(jw) + B(jw) \, G_b(jw) \, G_d(jw) \, G_f(jw)}$$

and

$$Q_o = Q_i \, G_e(jw) - \frac{Q_r \, G_a(jw)G_f(jw) - Q_i \, B(jw)G_b(jw)G_d(jw)G_e(jw)G_f(jw)}{1 - G_b(jw)G_c(jw) + B(jw) \, G_b(jw) \, G_d(jw) \, G_f(jw)}$$

These two equations as derived from lines 922 to 1115 , with there associated system diagrams , differ by the change in sign in Qr and so provide said systems arrangments which are noninverting or inverting .

If             $G_b(jw) \, G_c(jw) = 1\underline{/0^o}$

Then the denominator will reduce ie:

$1 - G_b(jw)G_c(jw) + B(jw)G_b(jw)G_d(jw)G_f(j_w) = B(jw)G_b(jw)G_d(jw)G_f(jw)$

as $1 - G_b(jw)G_c(jw) = 0$

Then

$$Q_o = Q_i G_e(jw) + \frac{Q_r G_a(jw)G_f(jw)}{B(jw)G_b(jw)G_d(jw)G_f(jw)} - \frac{Q_i B(jw)G_b(jw)G_d(jw)G_e(jw)G_f(jw)}{B(jw)G_b(jw)G_d(jw)G_f(jw)}$$

$$Q_o = \frac{Q_r \, G_a(jw)}{B(jw) \, G_b(jw) \, G_d(jw)}$$

Also for the other system equation:

$$Q_o = \frac{-Q_r \, G_a(jw)}{B(jw) \, G_b(jw) \, G_d(jw)}$$

The ouput Qo is therefore independant of G3(s) ( Ge(s) and Gf(s)) under the balanced condition , $1 - G_b(jw) \, G_c(jW) = 0$ , any errors in or coupled ( Qi ) to G3(s) will not appear at the output. In the case of this said arrangment being used as a voltage/ current regulator it can be seen that the supply Qi has no effect on the output Qo and is dependent on the reference Qr . This then is an advance over the present art which requires infinite gain to reduce the effects of the supply to zero at the system output.

In accordance with the invention there is provided a multiple loop feedback system arrangment as in Figs 26 to 33 comprising:

an output amplifier ( or control unit ) G3(s) , a feedback network ( or element ) B(s) whose input is coupled to the output of said output amplifier ( or control unit ) , a signal combining block G1(s) having a input Gb coupled to the input of said output amplifier ( or control unit ) and a input Ga forming the signal input Qi of said arrangment , a signal combining block G2(s) having two inputs Gc and Gd respectively coupled to the output of said signal combining block G1(s) and to the output of said feedback network ( or element ) B(s) and a output coupled to the input of said amplifier ( or control unit ) , the output of said amplifier ( or control unit ) forming the output of said arrangment.

Lines 187 to 205 also apply to figs 26 to 33 and can read again if required.

For Figs 26 to 33 the signal path around the loop formed by Gd(s).G3(s).B(s) is inverting . Using Fig 26 for example Gd(s) and B(s) are all noninverting and G3(s) is inverting . Therefore:

$$\underline{/Gd(s)} + \underline{/G3(s)} + \underline{/B(s)} = \underline{/0^o} + \underline{/180^o} + \underline{/0^o} = \underline{/180^o}$$

ie a negative feedback loop is formed with a net phase shift of $\underline{/180^o} = -1$

To construct the said arrangment then the signal combiners and G3(s) are chosen such that the said noninverting and inverting feedback loops are obtained as in Figs 26 to 33 . B(s) is only shown in a noninverting form as it would most likly be in the case of a electronic amplifier or electronic regulator, where it would be passive ie a resistor attenuator. Under the two said conditions:

With s=jw

$$\frac{Qo}{Qi} = \frac{Ga(jw)\ Gc(jw)\ G3(jw)}{1 - Gb(jw)\ Gc(jw) + B(jw)\ Gd(jw)\ G3(jw)}$$

and

$$\frac{Qo}{Qi} = \frac{-Ga(jw)\ Gc(jw)\ G3(jw)}{1 - Gb(jw)\ Gc(jw) + B(jw)\ Gd(jw)\ G3(jw)}$$

These two equations are derived from lines 1116 to 1308 , with there assciated system diagrams , differ by the change in sign in the denominator and so provide said system arrangments which are noninverting and inverting.

If $\qquad Gb(jw).\ Gc(jw) = 1\underline{/\!\!\underline{0^o}}$

Then the denominator will reduce ie:

$$1 - Gb(jw)Gc(jw)+ B(jw)Gd(jw)G3(jw) = B(jw)Gd(jw)G3(jw)$$

as $\qquad 1 - Gb(jw)Gc(jw) = 0$

Then $\qquad \dfrac{Qo}{Qi} = \dfrac{Ga(jw)Gc(jw)G3(jw)}{B(jw)Gd(jw)G3(jw)} = \dfrac{Ga(jw)\ Gc(jw)}{B(jw)\ Gd(jw)}$

and $\qquad \dfrac{Qo}{Qi} = \dfrac{-Ga(jw)Gc(jw)G3(jw)}{B(jw)Gd(jw)G3(jw)} = -\dfrac{Ga(jw)\ Gc(jw)}{B(jw)\ Gd(jw)}$

The output Qo is therefore independant of G3(s) under the balanced condition , $1 - Gb(jw)\ Gc(jw) = 0$ , any errors generated in or coupled to G3(s) will not appear at the output . This then is one of the features of the said arrangment and is a advance over the present art which requires infinite gain to reduce system errors to zero .

In accordance with the invention there is provided a multiple loop feedback system arrangment as in Figs 34 to 41 comprising:

an output amplifier ( or control unit ) G3(s) having two inputs Ge and Gf , a feedback network ( or element ) B(s) whose input is coupled to the output of said output amplifier ( or control unit ) , a signal combining block G1(s) having a input Gb coupled to the said input Gf of the output amplifier (or control unit ) and a input Ga forming the signal input Qr of said arrangment , a signal combining block G2(s) having two inputs Gc and Gd respectively coupled to the output of said combining block G1(s) and to the output of said feedback network ( or element ) B(s) and a output coupled to the said input Gf of the output amplifier ( or control unit ) , the Ge input of said output amplifier ( or control unit ) forming the second signal input Qi to said arrangment , the output of said output amplifier ( or control unit) forming the ouput of said arrangment.

Lines 187 to 205 also apply to Figs 34 to 41 and can read again if required.

For Figs 34 to 41 the signal path around the loop formed by $Gd(s).Gf(s)B(s)$ is inverting . Using Fig 34 for example $Gd(s)$ and $B(s)$ are both noninverting ,with $Gf(s)$ inverting . Therefore:

$$\underline{/Gd(s)} + \underline{/Gf(s)} + \underline{/B(s)} = \underline{/0^o} + \underline{/180^o} + \underline{/0^o} = \underline{/180^o}$$

ie a negative feedback loop is formed with a net phase shift of $\underline{/180^o} = -1$

To construct the said arrangment then the signal combiners and $G3(s)$ are chosen such that the said noninverting and inverting feedback loops are obtained as in Figs 34 to 41 . $B(s)$ is only shown in a noninverting form as it would most likly be in the case of a electronic amplifier or electronic regulator , where it would be passive ie a resistor attenuator. Under the two said conditions:

With $s = jw$

$$Qo = QiGe(jw) + \frac{QrGa(jw)Gc(jw)Gf(jw) - QiB(jw)Gd(jw)Ge(jw)Gf(jw)}{1 - Gb(jw)\ Gc(jw) + B(jw)\ Gd(jw)\ Gf(jw)}$$

and $$Qo = QiGe(jw) - \frac{QrGa(jw)Gc(jw)Gf(jw) - QiB(jw)Gd(jw)Ge(jw)Gf(jw)}{1 - Gb(jw)\ Gc(jw) + B(jw)\ Gd(jw)\ Gf(jw)}$$

These two equations are derived from lines 1309 to 1502 , with there associated system diagrams , differ by the change in of $Qr$ and so provide said systems arrangments which are noninverting or inverting .

If $\qquad Gb(jw) . Gc(jw) = 1\underline{/0^o}$

Then the denominator will reduce ie:

$$1 - Gb(jw)Gc(jw) + B(jw)Gd(jw)Gf(jw) \qquad = B(jw)Gd(jw)Gf(jw)$$

as $\quad 1 - Gb(jw)\ Gc(jw) = 0$

Then

$$Qo = QiGe(jw) + \frac{QrGa(jw)Gc(jw)Gf(jw)}{B(jw)Gd(jw)Gf(jw)} - \frac{QiB(jw)Gd(jw)Ge(jw)Gf(jw)}{B(jw)Gd(jw)Gf(jw)}$$

$$Qo = \frac{Qr\ Ga(jw)}{B(jw)\ Gd(jw)\ Gf(jw)}$$

The output $Qo$ is Therefore independent of $G3(s)$ ( $Ge(s)$ and $Gf(s)$ ) under the balanced condition , $1 - Gb(jw.Gc(jw) = 0$ , any errors in or coupled ( $Qi$ ) to $G3(s)$ will not appear at the output. In the case of this said arrangment being used as a voltage/current regulator it can be seen that the supply Qi has no effect on the output and is dependent on the referance Qr . This is an advance over the present art which requires infinite gain to reduce the effects of the supply to zero at the system output .

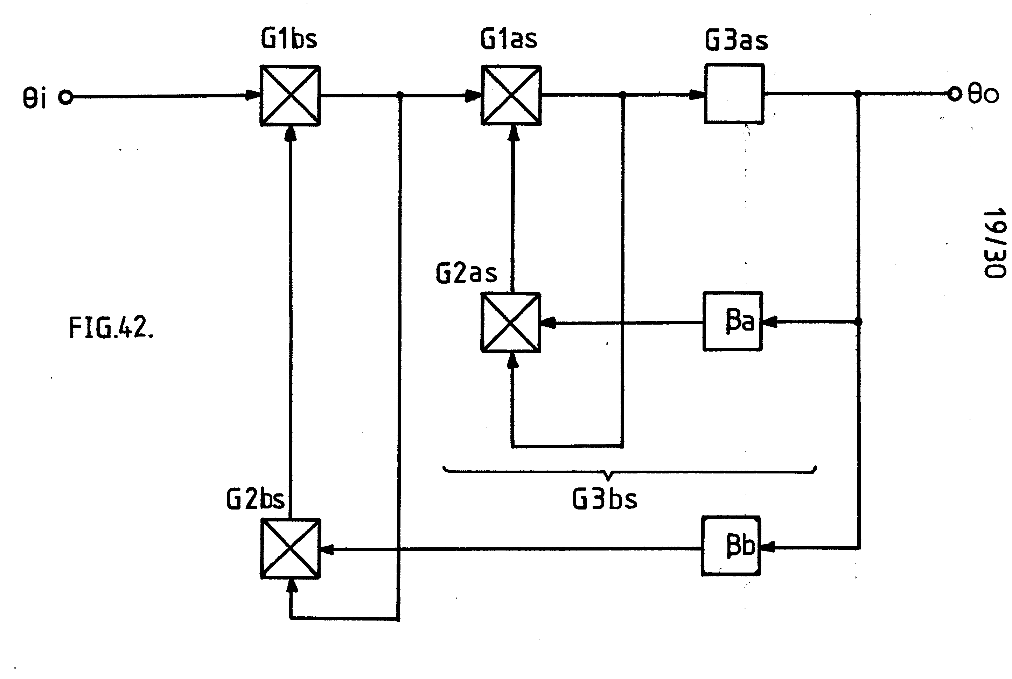

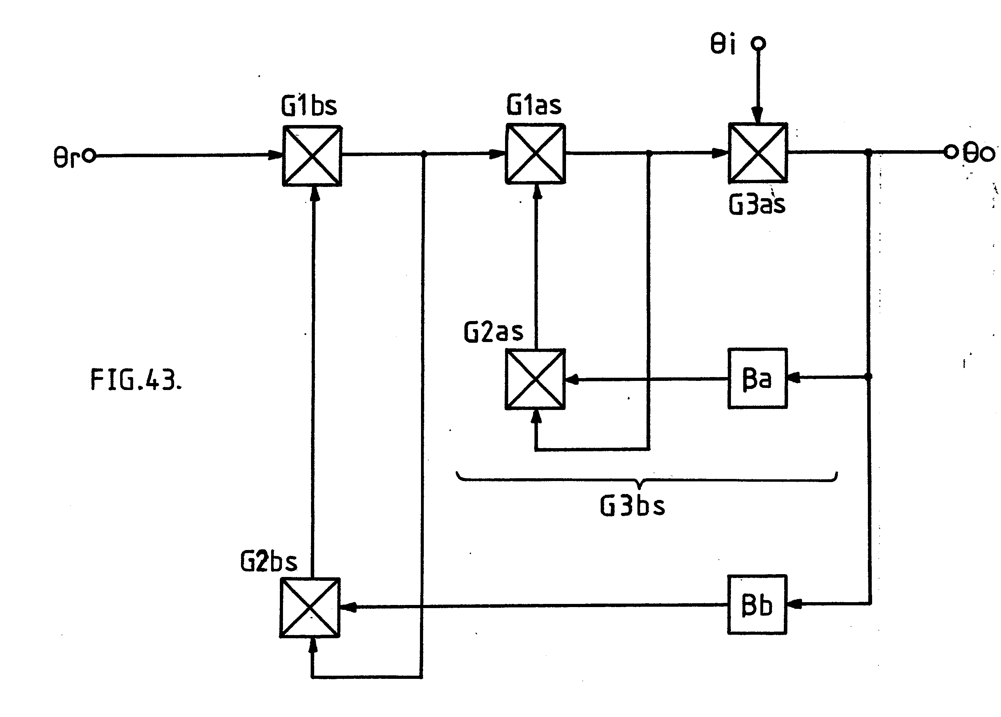

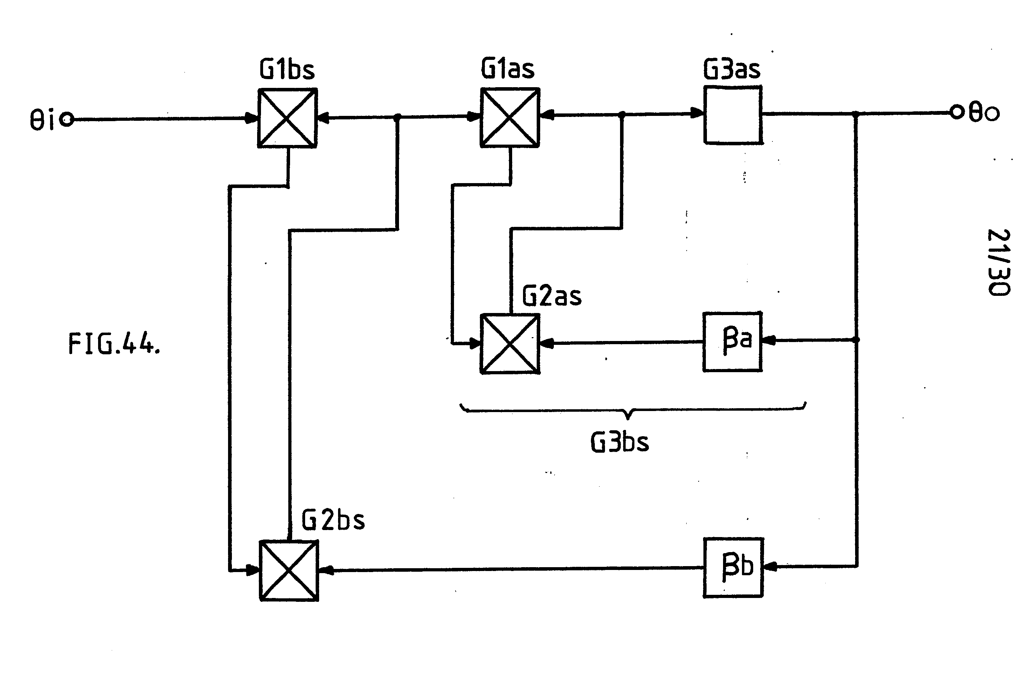

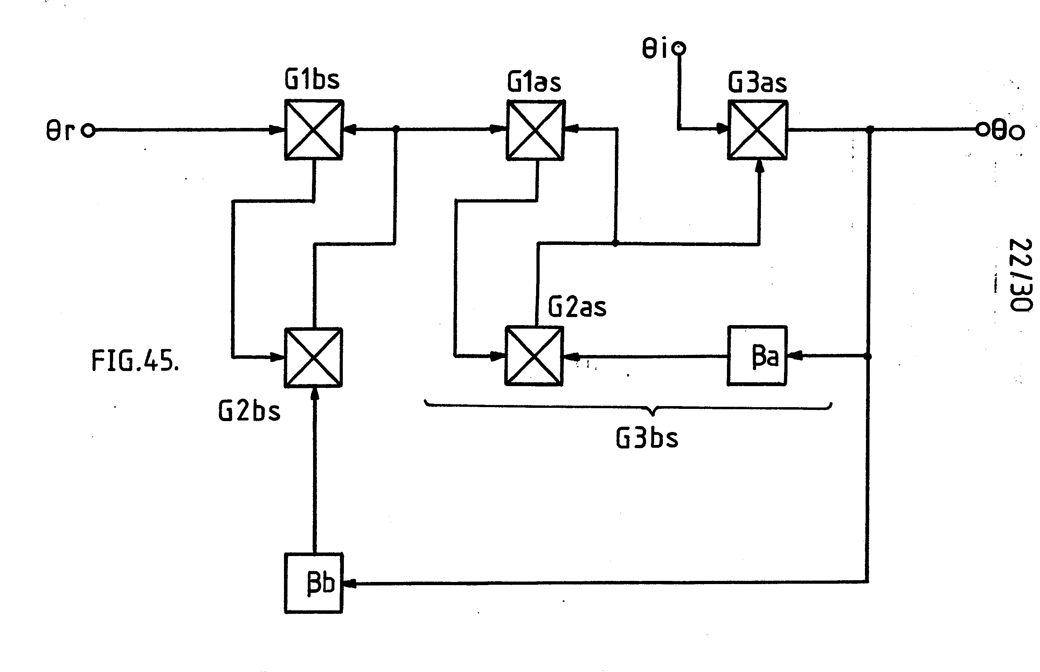

Figs 42 to 45 are nested multiple loop feedback systems .

A typical gain selection for the said arrangments would be Gb(jw) and Gc(jw) both having unity gains and have any overall gain for the said arrangments provided by G3(jw) , which would be typically be 10 to 1000 . B(jw) would be chosen so that : 1 / $\dot{B}$(jw) $\approx$ G3(jw)  so that only internal errors in G3(s) would be feed back and not signals present in Qi or Qr ( this reduces Qc and Qe and helps to reduce errors in G1(s) and G2(s ) ) . Under the said balanced condition any errors in or coupled to G3(s) will be totally rejected from Qo . In the case of G3(s) being the output stage of a electronic power amplifier for example , these errors would include harmonic distortion , intermodulation distortion , supply ripple , 1/f noise , gaussian noise , load impedance variations etc . The object of total rejection of errors associated with G3(s) has thus been achived without having infinite gain but at the cost of additional parts  G1(s) and G2(s) and also having to have the balanced condition . G1(s) and/or G2(s) may in themselfs use negative feedback to stabilise there gains and so provide the stable said balanced condition and provide reduction in there own internal errors. In the case of an electronic amplifier or electronic regulator for example , using said arrangments , they would use shunt or series current/voltage feedback as required . The advantage     of using negative feedback in G1(s) and G2(s) is that where as prior art arrangments require very large loop gains to reduce errors to a tolerable level and also have sufficient closed loop gain to be useful , the said invention only requires typically unity closed loop gains in G1(s) and G2(s) which means that for any given open loop gain, the loop gain will be greater in the multiple loop feedback arrangments and so provide greater reduction in errors in the gain sections and provide greater gain stabilty in G1(s) and G2(s) .

## Multiple Loop Feedback Voltage/Power Amplifier Designs Two system arrangments have been chosen to illustrate in more detail more practical voltage/power amplifier

### System A voltage/power amplifier

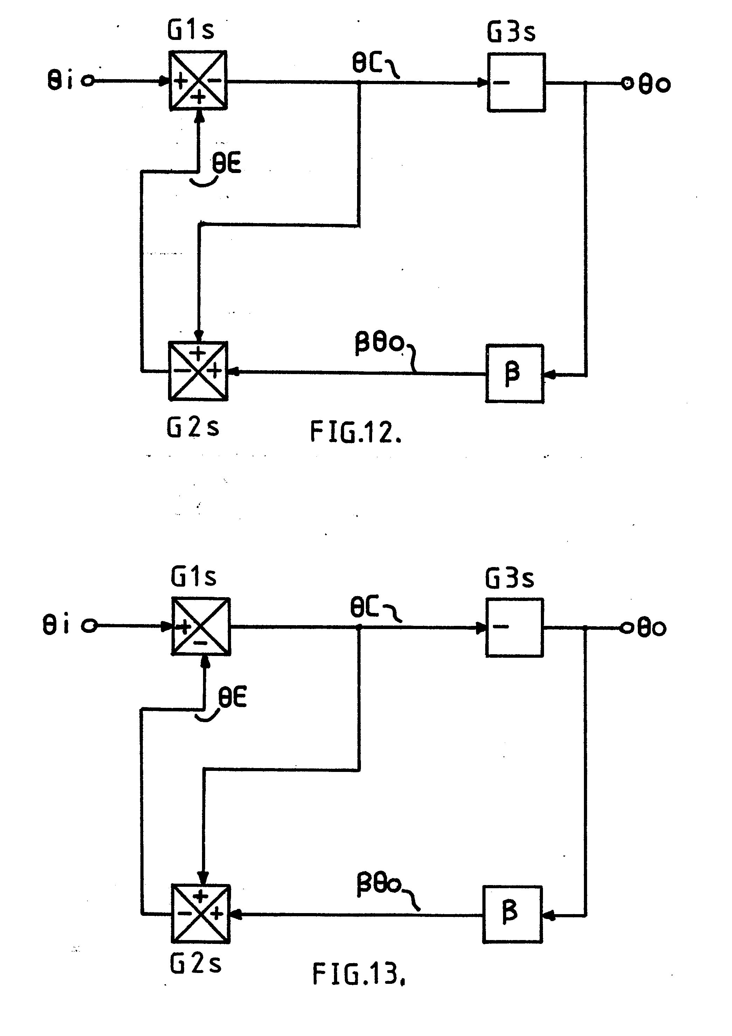

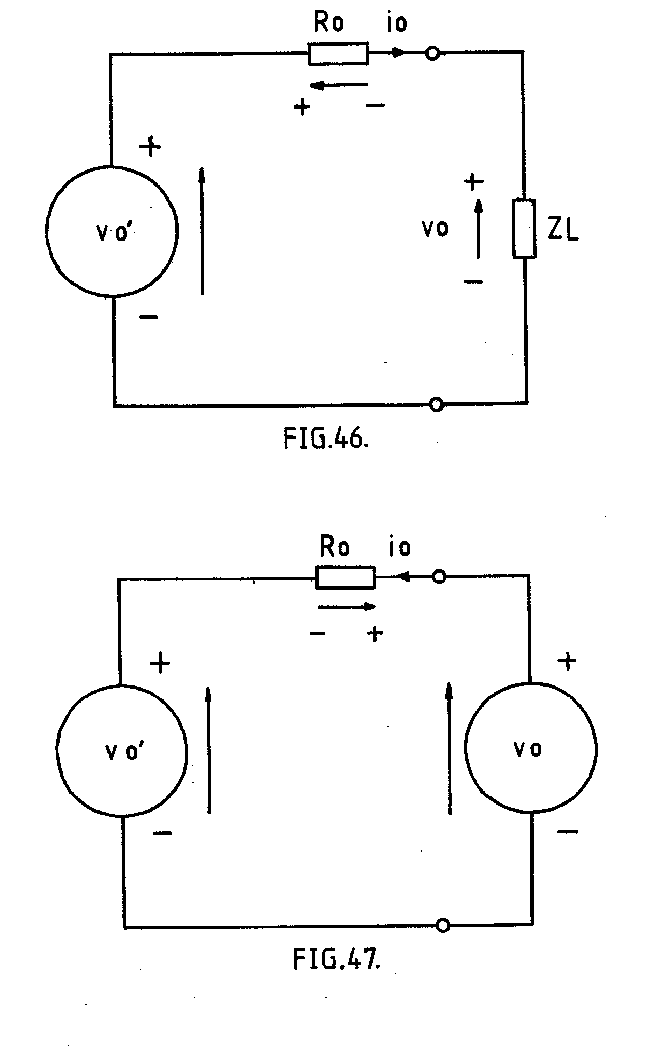

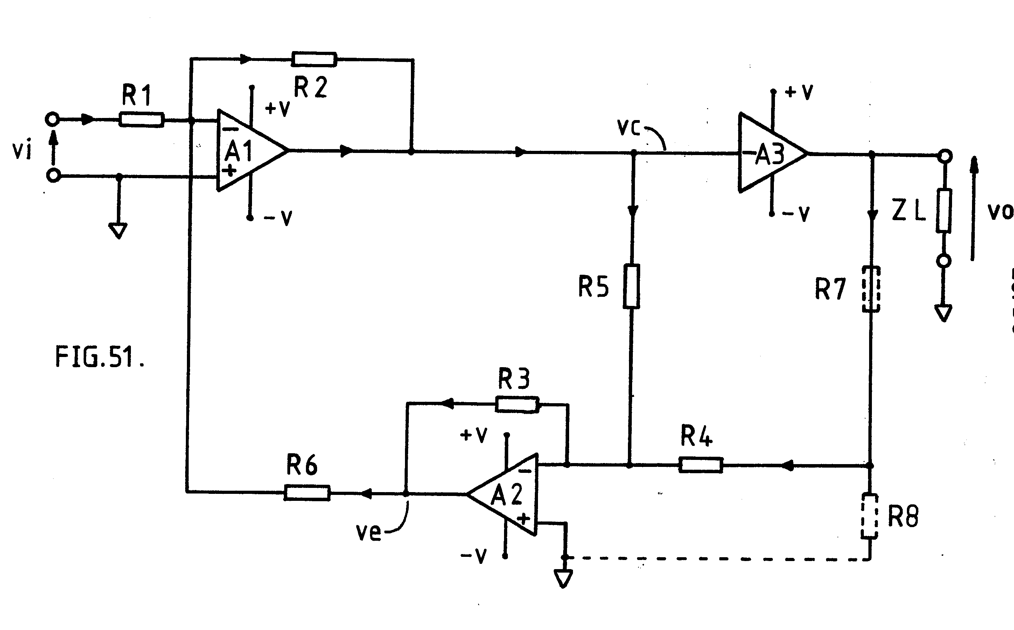

The amplifier is based on the system arrangment shown in Fig 12 Fig 51 shows the amplifier and Fig 46 the output circuit . Now $G1(s) = A1(s)$ , $G2(s) = A2(s)$ and $G3(s) = A3(s)$ . The B network is R7 and R8 , which may or may not be used and is therefore shown dotted .

Fig 48 refers to $A1(s)$ with lines 1503 to 1537, which derive the output of $A1(s)$ , vc .

### Amplifier without the B network

Fig 49 refers to $A2(s)$ and with lines 1538 to 1568, are used to derive the output voltage ve . These two derivations for vc and ve are used in the derivation of the overall transfer gain which is detailed from lines 1655 to 1754 . Operational amplifier techniques are used for $A1(s)$ and $A2(s)$ ie $A1(s)$ and $A2(s)$ are summing , inverting amplifiers and may be discrete , hybrid or monolithic in design .

### Amplifier with the B network

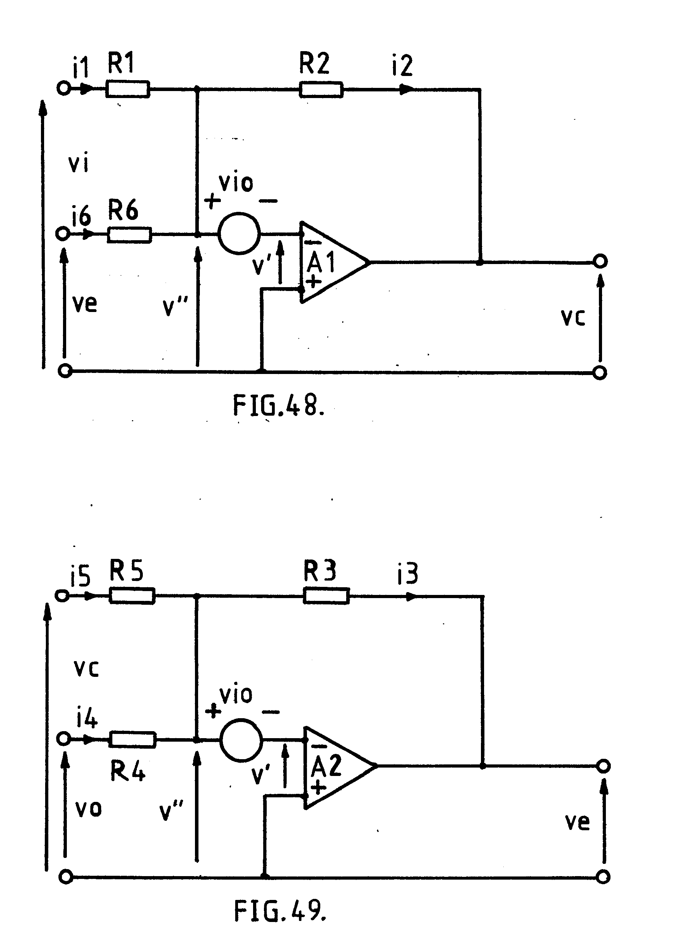

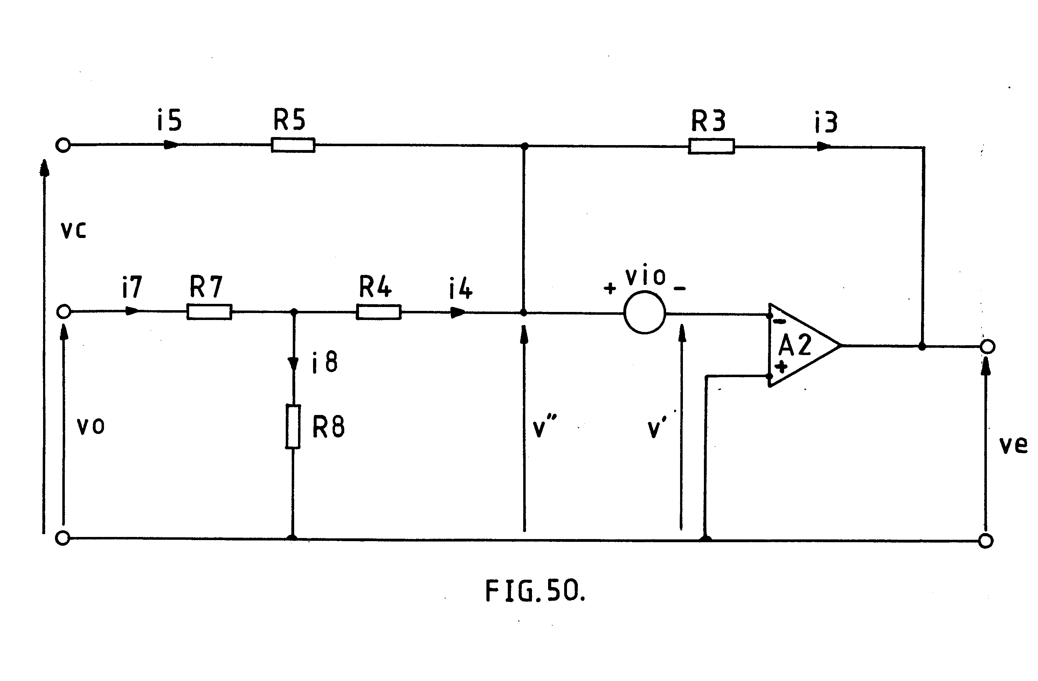

With this amplifier R7 and R8 are connected . Fig 50 refers to $A2(s)$ and with lines 1569 to 1654, are used to derive the output ve . This derivation for ve and the derivation for vc ( Fig 48 , lines 1503 to 1537 ) are used in the derivation of the overall transfer gain which is detailed from lines 1755 to 1809 .

### Output impedance with and without the B network

With the circuit of Fig 47 and the derivations detailed from lines 1810 to 1856 the output impedance with and without the B network connected is given .

### Voltage offsets of $A1(s)$ and $A2(s)$

Lines 1857 to 1905 show how the voltage offsets of $A1(s)$ and $A2(s)$ can effect the output equation and how these voltage offsets cancel in the output equation and therefore donot appear at the output .

### General results for the A system voltage/power amplifier

( 1 ) Under normal operating conditions $K2.K5 = 1$ ( unity ). With sufficiently high open loop gain for $A1(s)$ and $A2(s)$ ( typical greater than 100 ) the equations for K2 and K5 can be reduced to a form which allows $R2 = R3 = R5 = R6$ .

510 to 599 are blank .

Also R1 can be made equal to these resistors which means under mass production all five resistor will track each other over the designed temperature range if they have matched temperature coefficients .

( 2 ) Without a B network connected gain is obtained by making R4 greater than R ( R = R1 = R2 = R3 = R5 = R6 )

( 3 ) With a B network connected R4 can be made equal to R and with B less than 1 gain is obtained .

( 4 ) With K2.K5 = 1, A3(s) has no effect on the output vo with in the general frequency and saturation limits of the amplifier. Any distortion components , noise etc produced by A3(s) willnot appear at the output as the error feedback predistorts the vc signal voltage.

( 5 ) With K2.K5 = 1 the output impedance is zero and within the output amplifiers A3(s) voltage and current output limits any load impedance variation willnot effect vo . A typical applicatio n for the amplifier is in a High Fidility system for driving a loadspeaker load. The load speaker ideally requires to be driven from a zero impedance source and therefore is well suited to the amplifier .

( 6 ) Without the B network ,if gain is required, either the voltage offset of A1(s) or A2(s) is adjusted so as to reduce the output voltage to zero , even if the voltage offsets are equal. With the B network the voltage offsets can be made to cancel.

( 7 ) The input impedance is equal to R1

System B voltage/power amplifier

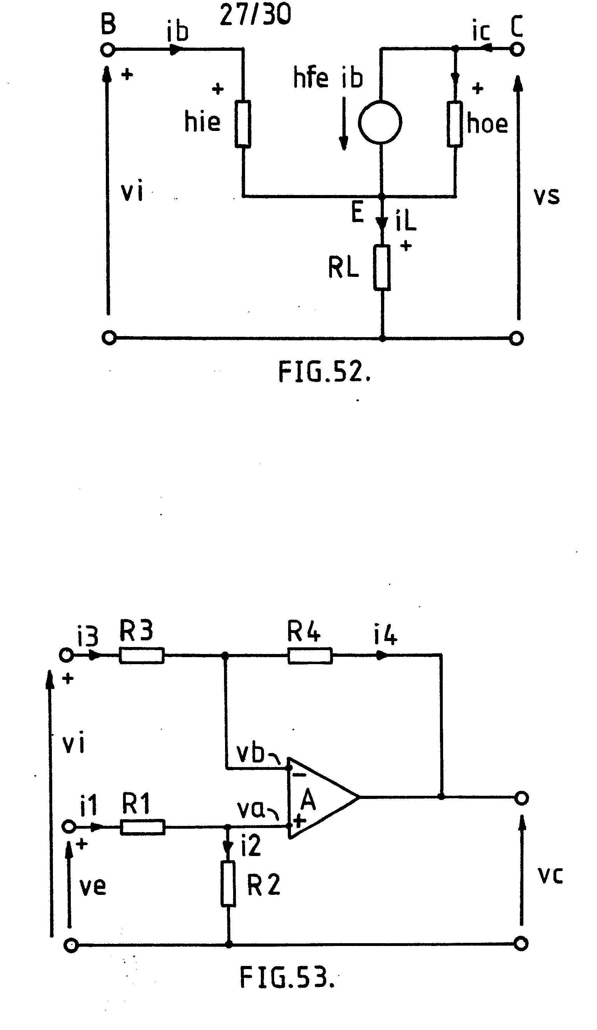

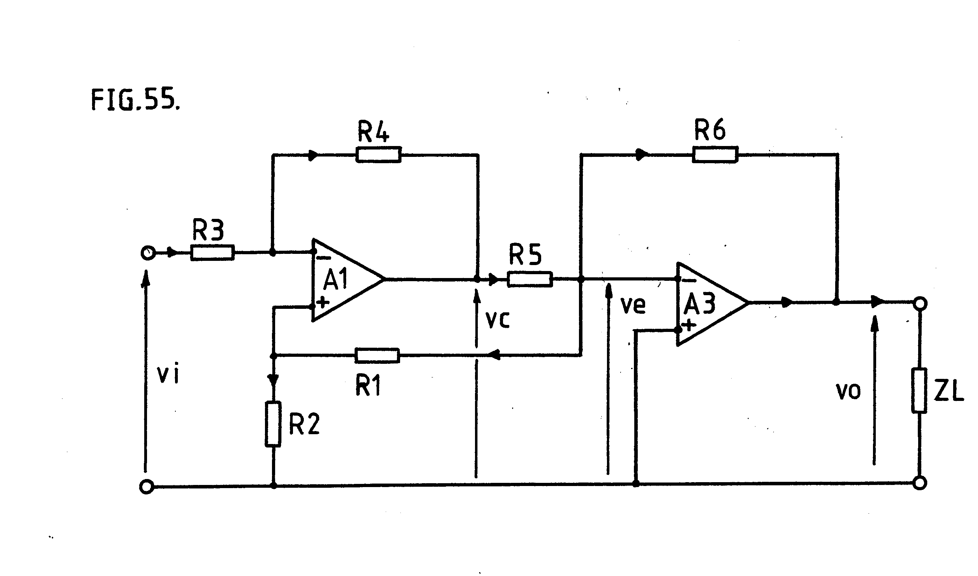

The amplifier is based on the system arrangment shown in Fig 27 Fig 55 shows the amplifier circuit diagram. Now G1(s) = A1(s) , G2(s) = R5 and R6 , G3(s) = A3(s). The B network is not used . Fig 53 refers to A1(s) and in conjunction withh lines 1936 to 1982 , derive the output of A1(s) , vc . The derivation for ve is detailed from lines 2070 to 2094 . The two derivations for vc and ve are used in the derivation of the overall transfer gain of the amplifier which is detailed from lines 2095 to 2144 .

General results for the B system voltage/power amplifier

( 1 ) Under normal operating conditions K9 . K11 = 1 ( unity ) . With K9 . K11 = 1 , A3(s) has no effect on the output vo within the general frequency and saturation limits of the amplifier. Any distortion components , noise etc produced byA3(s) will not appear at the output.

( 2 ) Lines 2171 to 2226 detail the procedure of finding the values of resistors given a required gain .

( 3 ) The input impedance is equal to R3 .

( 4 ) With K9 . K11 = 1 , The output impedance Ro doesnot appear in the output equation , this implies that the output impedance is zero and within the output amplifiers ( A3(s) ) voltage and current output limits any variation in the load impedance ZL will not effect vo .

( 5 ) Gain is obtained by the selection of the values of R5 and R6 .

## Multiple Loop Feedback Voltage Regulators

Two system arrangments have been chosen to illustrate in more detail more practical voltage regulators .

### System A voltage regulator

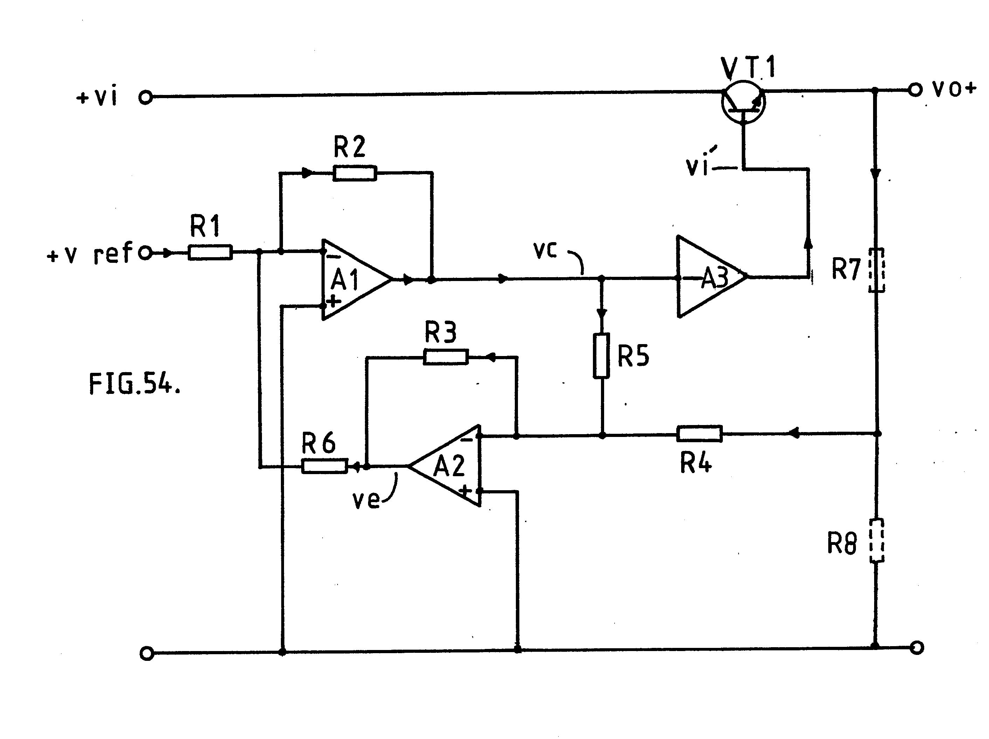

The regulator is based on the system arrangment shown in Fig 19. Fig 54 shows the regulator circuit diagram and Fig 52 the series control transistor VT1 . Now G1(s) = A1(s) , G2(s) = A2(s) and G3(s) = VT1 . A series control unit has been chosen for this example but a shunt control unit could have been chosen instead. The B network is R7 and R8 , which may or may not be used and is therefore shown dotted . Fig 48 refer to A1(s) and in conjunction with lines 1503 to 1537 derive the output of A1(s), vc . For the regulator vi = vr , vi = the supply voltage to be regulated . In conjunction with Fig 52 the output of the series control unit VT1 is derived from lines 1906 to 1935

### Regulator without the B network

Fig 49 in conjunction with lines 1538 to 1568 detail the derivation of the output of A2(s) , ve . This derivation for ve and the two derivations for vc and vo are used to obtain the output voltage vo , in terms of vi and vr and is detailedfrom lines 1983 to 2034 .

### Regulator with the B network

With this regulator R7 and R8 are connected . Fig 50 is the circuit diagram for A2(s) and in conjunction with 1569 to 1654 detail the derivation of the output of A2(s) , ve . This deriv ation for ve and the two derivations for vc and vo are used to obtain the output voltage vo , in terms of vi and vr and is detailed from lines 1983 to 2005 and lines 2036 to 2069 .

## General results for the A system voltage regulator

( 1 ) Under normal operating conditions K2.K5 = 1 ( unity ). With sufficiently high open loop gain for A1(s) and A2(s) (typically greater than 100 ) the equations for K2 and K5 can be reduced to a form which allows R2 = R3 = R5 = R6 = R . Also R1 can be made equal to these resistors

( 2 ) Without a B network connected, gain ( vo / vr ) is obtained by making R4 greater than R . If however vo = vr then R4 = R ( 3 ) Under the conditions K2.K5 = 1 , A3(s) , K7 and K8 donot effect the output vo within the frequency and saturation limits of the regulator . Any ripple voltage on vi and variations in transistor parameters will therefore not effect the output .

( 4 ) With K2.K5 = 1 , the output impedance of the regulator is zero and within the voltage and current limits of VT1 any load impedance variation will not effect vo .

( 5 ) With the B network connected gain ( vo / vr ) is obtained and R4 can be made equal to R .

( 6 ) For the voltage offsets of A1(s) and A2(s) to cancel and therefore not to appear at vo with the B network connected or without either one of the voltage offsets can be adjusted .

## System B voltage regulator

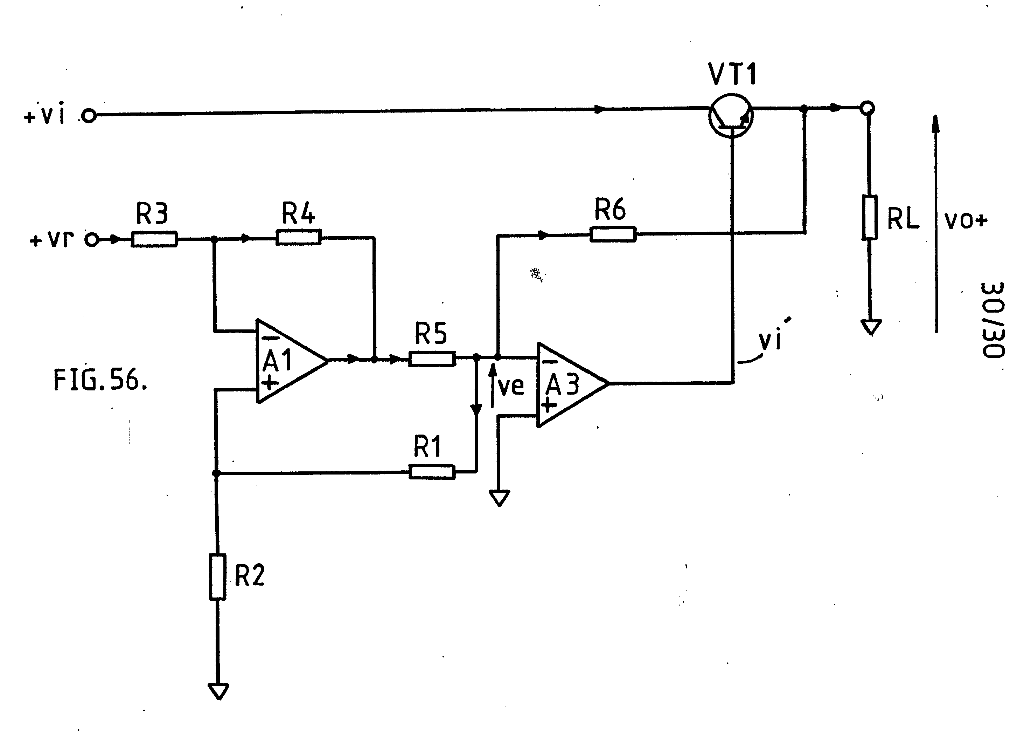

The regulator is based on the system arrangment shown in Fig 35 Fig 56 shows the regulator circuit diagram and Fig52the series control transistor VT1 . A series control unit has been chosen for this example but a shunt control unit could have been chosen instead . Fig 53 refers to A1(s) and in conjunction with lines 1936 to 1982 derive the output of A1(s) , vc . Now G1(s) = A1 , G2(s) = R5 and R6 , G3(s) = A3(s) and VT1 . The derivation ve is detailed from lines 2070 to 2094 . The two derivations for vc and ve are used in the derivation of vo in terms of vi and vr ( The B network is not used ) from lines 2146 to 2170 .

## General results for the B system regulator

( 1 ) Under normal operating conditions K9 . K11 = 1 ( unity ). With this equality A3(s) , K7 and K8 have no effect on the output vo within the frequency and saturation limits of the regulator. Any ripple voltage on vi and variations in transistor parameter will not effect the output voltage vo .

( 2 ) Lines 2171 to 2226 detail the procedure of finding the values resistors given a required gain ( where gain = vo / vi = vo / vr )

718  $-Q_c = Q_i G_1(s)a + Q_e G_1(s)b = Q_i G_a + Q_e G_b$ — — — — — 1

$Q_e = B Q_o G_2(s)d - Q_c G_2(s)c = -Q_c G_c + B Q_o G_d$ — — 2

$Q_o = Q_c G_3(s) = Q_c G_3$ — — — — 3

SUBSTITUTING 3 INTO 2

722  $Q_e = -Q_c G_c + B G_d Q_c G_3$ — — — — 4

SUBSTITUTING 4 INTO 1

$-Q_c = Q_i G_a + G_b ( - Q_c G_c + B G_d Q_c G_3 )$

$-Q_c = Q_i G_a + G_b B G_d Q_c G_3 - G_b Q_C G_c$

726  $Q_c = - Q_i G_a - G_b B G_d Q_c G_3 + G_b Q_c G_c$

$Q_c + Q_c B G_d G_3 - Q_c G_b G_c = -Q_i G_a$

$Q_c ( 1 - G_b G_c + B G_d G_3 G_b) = -Q_i G_a$

$$Q_c = \frac{-Q_i G_a}{1 - G_b G_c + B G_3 G_b G_d}$$ — — — — — 5

730

SUBSTITUTING 5 INTO 3

$$Q_o = G_3 \left( \frac{- Q_i G_a}{1 - G_b G_c + B G_3 G_b G_d} \right)$$

734  $$\frac{Q_o}{Q_i} = \frac{- G_a G_3}{1 - G_b G_c + B G_3 G_b G_d}$$

TO ELIMINATE THE EFFECT ON THE OUTPUT, $Q_o$ BY $G_3(s)$

$1 - G_b G_c = 0$  ie $G_b G_c = 1$

738  $$\frac{Q_o}{Q_i} = \frac{- G_a G_3}{B G_3 G_b G_d}$$

$$\frac{Q_o}{Q_i} = \frac{-G_a}{B G_b G_d}$$

$$Qc = Qi\ G1(s)a - Qe\ G1(s)b = Qi\ Ga - Qe\ Gb ----1$$

$$Qe = - Qc\ G2(s)c + B\ Qo\ G2(s)d = - Qc\ Gc + B\ Qo\ Gd ----2$$

$$Qo = Qc\ G3(s) = Qc\ G3 ---- 3$$

SUBSTITUTING  3  INTO  2

$$Qe = - Qc\ Gc + B\ Gd\ (\ Qc\ G3\ )$$

$$Qe = - Qc\ Gc + B\ Gd\ Qc\ G3 ----4$$

SUBSTITUTING  4  INTO  1

$$Qc = Qi\ Ga - Gb\ (\ - Qc\ Gc + Qc\ B\ G3\ Gd\ )$$

$$Qc = Qi\ Ga + Qc\ Gb\ Gc - Qc\ B\ G3\ Gb\ Gd$$

$$Qc - Qc\ Ga\ Gb + Qc\ B\ G3\ Gb\ Gd = Qi\ Ga$$

$$Qc\ (\ 1 - Gb\ Gd + B\ G3\ Gb\ Gd\ ) = Qi\ Ga$$

$$Qc = \frac{Qi\ Ga}{1 - Gb\ Gd + B\ G3\ Gb\ Gd} ----5$$

SUBSTITUTING  5  INTO  3

$$Qo = G3\ (\ \frac{Qi\ Ga}{1 - Gb\ Gd + B\ G3\ Gb\ Gd}\ )$$

$$Qo = \frac{Qi\ Ga\ G3}{1 - Gb\ Gc + B\ G3\ Gb\ Gd}$$

TO  ELIMINATE  THE  EFFECT  ON  THE  OUTPUT  Qo,  BY  G3(s)

$$1 - Gb\ Gc = 0 \quad ie \quad Gb\ Gc = 1$$

$$Qo = \frac{Qi\ Ga\ G3}{B\ G3\ Gb\ Gd}$$

$$Qo = \frac{Qi\ Ga}{B\ Gb\ Gd}$$

$$\frac{Qo}{Qi} = \frac{Ga}{B\ Gb\ Gd}$$

$$- Q_c = Q_i G1(s)a + Q_e G1(s)b = Q_i Ga + Q_e Gb ------ 1$$

$$- Q_e = Q_c G2(s)c + B Q_o G2(s)d = Q_c Gc + B Q_o Gd ---- 2$$

$$- Q_o = Q_c G3(s) = Q_c G3 ----- 3$$

SUBSTITUTING 3 INTO 2

$$- Q_e = Q_c Gc + B Gd ( - Q_c G3 )$$

$$- Q_e = Q_c Gc - Q_c G3 BGd$$

$$Q_e = Q_c G3 BGd - Q_c Gc ----- 4$$

SUBSTITUTING 4 INTO 1

$$- Q_c = Q_i Ga + ( Q_c B G3Gd - Q_c Gc ) Gb$$

$$- Q_c = Q_i Ga + Q_c B G3 Gd Gb - Q_c Gc Gb$$

$$Q_c = - Q_i Ga - Q_c B G3 Gd Gb + Q_c Gc Gb$$

$$Q_c + Q_c B G3 Gd Gb - Q_c Gc Gb = -Q_i Ga$$

$$Q_c = \frac{- Q_i Ga}{1 - Gb Gc + B G3 Gb Gd} ----- 5$$

SUBSTITUTING 5 INTO 3

$$Q_o = - G3 \left( - \frac{Q_i Ga}{1 - Gb Gc + B G3 Gb Gd} \right)$$

$$Q_o = \frac{Q_i Ga G3}{1 - Gb Gc + B G3 Gb Gd}$$

TO ELIMINATE THE EFFECT ON THE OUTPUT, $Q_o$ BY G3(s)

$$1 - Gb Gc = 0 \quad ie \quad Gb Gc = 1$$

$$Q_o = \frac{Q_i Ga G3}{B \cdot G3 Gb Gd}$$

$$Q_o = \frac{Q_i Ga}{B Gb Gd}$$

$$Qc = Qi \; G1(s)a - Qe \; G1(s)b = Qi \; Ga - Qe \; Gb \;-\;-\;-\;-\;-\;1$$

$$- Qe = Qc \; G2(s)c + B \; Qo \; G2(s)d = Qc \; Gc + B \; Qo \; Gd \;-\;-\;2$$

$$- Qo = Qc \; G3(s) = Qc \; G3 \;-\;-\;-\;-\; 3$$

SUBSTITUTING 3 INTO 2

$$- Qe = Qc \; Gc + B \; Gd \; ( - Qc \; G3 )$$

$$- Qe = Qc \; Gc - Qc \; G3 \; B \; Gd$$

$$Qe = Qc \; G3 \; B \; Gd - Qc \; Gc \;-\;-\;-\;-\;4$$

SUBSTITUTING 4 INTO 1

$$Qc = Qi \; Ga - Gb \; ( \; Qc \; G3 \; B \; Gd - Qc \; Gc \; )$$

$$Qc = Qi \; Ga - Qc \; B \; G3 \; Gb \; Gd + Qc \; Gb \; Gc$$

$$Qc - Qc \; Gb \; Gc + Qc \; B \; G3 \; Gb \; Gd = Qi \; Ga$$

$$Qc = \frac{Qi \; Ga}{1 - Gb \; Gc + B \; G3 \; Gb \; Gd} \;-\;-\;-\;-\;5$$

SUBSTITUTING 5 INTO 3

$$Qo = - G3 \; \left( \frac{Qi \; Ga}{1 - Gb \; Gc + B \; G3 \; Gb \; Gd} \right)$$

$$Qo = \frac{- Qi \; G3 \; Ga}{1 - Gb \; Gc + B \; G3 \; Gb \; Gd}$$

TO ELIMINATE THE EFFECT ON THE OUTPUT, $Qo$ BY $G3(s)$

$$1 - Gb \; Gc = 0 \quad ie \quad Gb \; Gc = 1$$

$$Qo = \frac{- Qi \; G3 \; Ga}{B \; G3 \; Gb \; Gd}$$

$$Qo = \frac{- Qi \; Ga}{B \; Gb \; Gd}$$

$$\frac{Qo}{Qi} = \frac{- Ga}{B \; Gb \; Gd}$$

$$Qc = Qi\ G1(s)a + Qe\ G1(s)b = Qi\ Ga + Qe\ Gb \quad ------\ 1$$

$$Qe = Qc\ G2(s)c - B\ Qo\ G2(s)d = Qc\ Gc - B\ Qo\ Gd \quad ----\ 2$$

$$Qo = Qc\ G3(s) = Qc\ G3 \quad ------\ 3$$

SUBSTITUTING  3  INTO  2

$$Qe = Qc\ Gc - B\ Gd\ (\ Qc\ G3\ )$$

$$Qe = Qc\ Gc - B\ Gd\ Qc\ G3 \quad ----\ 4$$

SUBSTITUTING  4  INTO  1

$$Qc = Qi\ Ga + Gb\ (\ QC\ Gc - B\ Gd\ Qc\ G3\ )$$

$$Qc = Qi\ Ga + Gb\ Gc\ Qc - Qc\ Gb\ Gd\ B\ G3$$

$$Qc - Qc\ Gb\ Gc + Qc\ Gb\ Gd\ B\ G3 = Qi\ Ga$$

$$Qc\ (\ 1 - Gb\ Gc + B\ Gb\ Gd\ G3\ ) = Qi\ Ga$$

$$Qc = \frac{Qi\ Ga}{1 - Gb\ Gc + B\ Gb\ Gd\ G3} \quad -----\ 5$$

SUBSTITUTING  5  INTO  3

$$Qo = G3\ \left(\ \frac{Qi\ Ga}{1 - Gb\ Gc + B\ Gb\ Gd\ G3}\ \right)$$

$$Qo = \frac{Qi\ Ga\ G3}{1 - Gb\ Gc + B\ Gb\ Gd\ G3}$$

TO  ELIMINATE  THE  EFFECT  ON THE  OUTPUT,  $Qo$  BY  $G3(s)$

$$1 - Gb\ Gc = 0 \quad ie\ Gb\ Gc = 1$$

$$Qo = \frac{Qi\ Ga\ G3}{B\ Gb\ Gd\ G3}$$

$$\frac{Qo}{Qi} = \frac{Ga}{B\ Gb\ Gd}$$

$$Qc = -Qi\ G1(s)a + Qe\ G1(s)b = -Qi\ Ga + Qe\ Gb \ ----\ 1$$

$$Qe = Qc\ G2(s)c - B\ Qo\ G2(s)d = Qc\ Gc - B\ Qo\ Gd \ ---\ 2$$

$$Qo = Qc\ G3(s) = Qc\ G3 \ ----\ 3$$

SUBSTITUTING 3 INTO 2

$$Qe = Qc\ Gc - B\ Gd\ (\ Qc\ G3\ )$$

$$Qe = Qc\ Gc - Qc\ B\ G3\ Gd \ ----\ 4$$

SUBSTITUTING 4 INTO 1

$$Qc = -Qi\ Ga + Gb\ (\ Qc\ Gc -Qc\ B\ G3\ Gd\ )$$

$$Qc = -Qi\ Ga + Qc\ Gb\ Gc - Qc\ B\ G3\ Gb\ Gd$$

$$Qc - Qc\ Gb\ Gc + Qc\ B\ G3\ Gb\ Gd = -Qi\ Ga$$

$$Qc\ (\ 1 - Gb\ Gc + B\ G3\ Gb\ Gd\ ) = -Qi\ Ga$$

$$Qc = \frac{-Qi\ Ga}{1 - Gb\ Gc + B\ G3\ Gb\ Gd} \ ----\ 5$$

SUBSTITUTING 5 INTO 3

$$Qo = G3\ \left(\ \frac{-Qi\ Ga}{1 - Gb\ Gc + B\ G3\ Gb\ Gd}\ \right)$$

$$Qo = \frac{-Qi\ Ga\ G3}{1 - Gb\ Gc + B\ G3\ Gb\ Gd}$$

TO ELIMINATE THE EFFECT ON THE OUTPUT, Qo BY G3(s)

$$1 - Gb\ Gc = 0 \quad ie \quad Gb\ Gc = 1$$

$$Qo = \frac{-Qi\ G3\ Ga}{B\ G3\ Gb\ Gd}$$

$$Qo = \frac{-Qi\ Ga}{B\ Gb\ Gd}$$

$$\frac{Qo}{Qi} = -\ \frac{Ga}{B\ Gb\ Gd}$$

$$Qc = -\ Qi\ G1(s)a + Qe\ G1(s)b = -\ Qi\ Ga + Qe\ Gb \ ---- 1$$

$$Qe = Qc\ G2(s)c + B\ Qo\ G2(s)d = Qc\ Gc + B\ Qo\ Gd \ ---- 2$$

$$Qo = -\ Qc\ G3(s) = -\ Qc\ G3 \ ---- 3$$

SUBSTITUTING 3 INTO 2

$$Qe = Qc\ Gc + B\ Gd\ (\ -\ Qc\ G3\ )$$

$$Qe = Qc\ Gc - Qc\ B\ G3\ Gd \ ---- 4$$

SUBSTITUTING 4 INTO 1

$$Qc = -\ Qi\ Ga + Gb\ (\ Qc\ Gc - Qc\ B\ G3\ Gd\ )$$

$$Qc = -\ Qi\ Ga + Qc\ Gb\ Gc - Qc\ B\ G3\ Gb\ Gd$$

$$Qc - Qc\ Gb\ Gd + Qc\ B\ G3\ Gb\ Gd = -\ Qi\ Ga$$

$$Qc\ (\ 1 - Gb\ Gc + B\ G3\ Gb\ Gd\ ) = -\ Qi\ Ga$$

$$Qc = \frac{-\ Qi\ Ga}{1 - Gb\ Gc + B\ G3\ Gb\ Gd} \ ---- 5$$

SUBSTITUTING 5 INTO 3

$$Qo = -\ G3\ \left(\ \frac{-\ Qi\ Ga}{1 - Gb\ Gc + B\ G3\ Gb\ Gd}\ \right)$$

$$Qo = \frac{Qi\ Ga\ G3}{1 - Gb\ Gc + B\ G3\ Gb\ Gd}$$

TO ELIMINATE THE EFFECT ON THE OUTPUT, Qo BY G3(s)

$$1 - Gb\ Gc = 0 \quad ie \quad Gb\ Gc = 1$$

$$Qo = \frac{Qi\ Ga\ G3}{B\ G3\ Gb\ Gd}$$

$$Qo = \frac{Qi\ Ga}{B\ Gb\ Gd}$$

$$\frac{Qo}{Qi} = \frac{Ga}{B\ Gb\ Gd}$$

$$Qc = Qi\ G1(s)a + Qe\ G1(s)b = Qi\ Ga + Qe\ Gb \quad ----- 1$$

$$Qe = Qc\ G2(s)c + B\ Qo\ G2(s)d = Qc\ Gc + B\ Qo\ Gd \quad --- 2$$

$$Qo = Qc\ G3(s) = -Qc\ G3 \quad ---- 3$$

SUBSTITUTING 3 INTO 2

$$Qe = Qc\ Gc + B\ Gd\ (-Qc\ G3)$$

$$Qe = Qc\ Gc - Qc\ B\ G3\ Gd \quad ---- 4$$

SUBSTITUTING 4 INTO 1

$$Qc = Qi\ Ga + Gb\ (\ Qc\ Gc - Qc\ B\ G3\ Gd\ )$$

$$Qc = Qi\ Ga + Qc\ Gb\ Gc - Qc\ B\ G3\ Gb\ Gd$$

$$Qc - Qc\ Gb\ Gc + Qc\ B\ G3\ Gb\ Gd = Qi\ Ga$$

$$Qc\ (\ 1 - Gb\ Gc + B\ G3\ Gb\ Gd\ ) = Qi\ Ga$$

$$Qc = \frac{Qi\ Ga}{1 - Gb\ Gc + B\ G3\ Gb\ Gd} \quad ---- 5$$

SUBSTITUTING 5 INTO 3

$$Qo = -\ G3\ (\ \frac{Qi\ Ga}{1 - Gb\ Gc + B\ G3\ Gb\ Gd}\ )$$

$$Qo = \frac{-\ Qi\ Ga\ G3}{1 - Gb\ Gc + B\ G3\ Gb\ Gd}$$

TO ELIMINATE THE EFFECT ON THE OUTPUT, Qo BY G3(s)

$$1 - Gb\ Gc = 0 \quad ie\quad Gb\ Gc = 1$$

$$Qo = \frac{-Qi\ Ga\ G3}{B\ G3\ Gb\ Gd}$$

$$Qo = \frac{-\ Qi\ Ga}{B\ Gb\ Gd}$$

$$\frac{Qo}{Qi} = \frac{-Ga}{B\ Gb\ Gd}$$

0188866

$$Qc = -Qr\ G1(s)a + Qe\ G1(s)b = -Qr\ Ga + Qe\ Gb \ ----\ 1$$

$$Qe = Qc\ G2(s)c + B\ Qo\ G2(s)d = Qc\ Gc + B\ Qo\ Gd \ ----\ 2$$

$$Qo = Qi\ G3(s)e - Qc\ G3(s)f = Qi\ Ge - Qc\ Gf\ ----\ 3$$

SUBSTITUTING 3 INTO 2

$$Qe = QcGc + B\ Gd\ (\ Qi\ Ge - Qc\ Gf\ )$$

$$Qe = Qc\ Gc + B\ Gd\ Qi\ Ge - Qc\ B\ Gd\ Gf \ ----\ 4$$

SUBSTITUTING 4 INTO 1

$$Qc = -Qr\ Ga + Gb\ (\ Qc\ Gc + Qi\ B\ Gd\ Ge - Qc\ B\ Gd\ Gf\ )$$

$$Qc = -Qr\ Ga + Qc\ Gb\ Gc + Qi\ B\ Gb\ Gd\ Ge - Qc\ B\ Gb\ Gd\ Gf$$

$$Qc - Qc\ Gb\ Gc + Qc\ B\ Gb\ Gd\ Gf = -Qr\ Ga + Qi\ B\ Gb\ Gd\ Ge$$

$$Qc\ (\ 1 - Gb\ Gc + B\ Gb\ Gd\ Gf\ ) = -Qr\ Ga + Qi\ B\ Gb\ Gd\ Ge$$

$$Qc = \frac{-Qr\ Ga + Qi\ B\ Gb\ Gd\ Ge}{1 - Gb\ Gc + B\ Gb\ Gd\ Gf} \ ----\ 5$$

SUBSTITUTING 5 INTO 3

$$Qo = Qi\ Ge - Gf\ \frac{(\ -Qr\ Ga + Qi\ B\ Gb\ Gd\ Ge\ )}{1 - Gb\ Gc + B\ Gb\ Gd\ Gf}$$

$$Qo = Qi\ Ge + \frac{Qr\ Ga\ Gf - Qi\ B\ Gb\ Gd\ Ge\ Gf}{1 - Gb\ Gc + B\ Gb\ Gd\ Gf}$$

TO ELIMINATE THE EFFECT ON THE OUTPUT Qo, BY Qi

$$1 - Gb\ Gc = 0 \quad ie \quad Gb\ Gc = 1$$

$$Qo = Qi\ Ge + \frac{Qr\ Ga\ Gf}{B\ Gb\ Gd\ Gf} - \frac{Qi\ B\ Gb\ Gd\ Ge\ Gf}{B\ Gb\ Gd\ Gf}$$

$$\frac{Qo}{Qr} = \frac{Ga}{B\ Gb\ Gd}$$

$$- Q_c = Q_r\, G_1(s)a + Q_e\, G_1(s)b = Q_r\, G_a + Q_e\, G_b - - - - 1$$

$$- Q_e = Q_c\, G_2(s)c + B\, Q_o\, G_2(s)d = Q_c\, G_c + B\, Q_o G_d - - 2$$

$$Q_o = Q_i\, G_3(s)e - Q_c\, G_3(s)f = Q_i\, G_e - Q_c\, G_f - - - - - 3$$

SUBSTITUTING  3  INTO  2

$$- Q_e = Q_c\, G_c + G_d B(\, Q_i\, G_e - Q_c\, G_f\,)$$

$$- Q_e = Q_c\, G_c + Q_i\, B\, G_d\, G_e - Q_c\, B\, G_d\, G_f - - - - 4$$

SUBSTITUTING  4  INTO  1

$$- Q_c = Q_r\, G_a + G_b\,(\, - Q_c\, G_c - Q_i\, B\, G_d\, G_e + Q_c\, B\, G_d\, G_f\,)$$

$$- Q_c = Q_r\, G_a - Q_c\, G_b\, G_c - Q_i\, B\, G_b\, G_d\, G_e + Q_c\, B\, G_b\, G_d\, G_f$$

$$Q_c = - Q_r\, G_a + Q_c\, G_b\, G_c + Q_i\, B\, G_b\, G_d\, G_e - Q_c\, B\, G_b\, G_d\, G_f$$

$$Q_c - Q_c\, G_b\, G_c + Q_c\, B\, G_b\, G_d\, G_f = - Q_r\, G_a + Q_i\, B\, G_b\, G_d\, G_e$$

$$Q_c\,(\,1 - G_b\, G_c + B\, G_b\, G_d\, G_f\,) = - Q_r\, G_a + Q_i\, B\, G_b\, G_d\, G_e$$

$$Q_c = \frac{- Q_r\, G_a + Q_i\, B\, G_b\, G_d\, G_e}{1 - G_b\, G_c + B\, G_b\, G_d\, G_f} - - - - 5$$

SUBSTITUTING  5  INTO  3

$$Q_o = Q_i\, G_e - G_f\,\left(\frac{- Q_r\, G_a + Q_i\, B\, G_b\, G_d\, G_e}{1 - G_b\, G_c + B\, G_b\, G_d\, G_f}\right)$$

$$Q_o = Q_i\, G_e + \frac{Q_r\, G_a\, G_f - Q_i\, B\, G_b\, G_d\, G_e\, G_f}{1 - G_b\, G_c + B\, G_b\, G_d\, G_f}$$

TO ELIMINATE  THE  EFFECT  ON  THE  OUTPUT  $Q_o$,  BY  $Q_i$

$$1 - G_b\, G_c = 0 \quad \text{ie} \quad G_b\, G_c = 1$$

$$Q_o = Q_i\, G_e + \frac{Q_r\, G_a\, G_f}{B\, G_b\, G_d\, G_f} - \frac{Q_i\, B\, G_b\, G_d\, G_e\, G_f}{B\, G_b\, G_d\, G_f}$$

$$\frac{Q_o}{Q_r} = \frac{G_a}{B\, G_b\, G_d}$$

$$Qc = Qr\, G1(s)a - Qe\, G1(s)b = Qr\, Ga - Qe\, Gb \quad ---- 1$$

$$- Qe = Qc\, G2(s)c + B\, Qo\, G2(s)d = Qc\, Gc + B\, Qo\, Gd \quad ---- 2$$

$$Qo = Qi\, G3(s)e - Qc\, G3(s)f = Qi\, Ge - Qc\, Gf \quad ------- 3$$

SUBSTITUTING 3 INTO 2

$$- Qe = Qc\, Gc + B\, Gd\, (\, Qi\, Ge - Qc\, Gf\, )$$

$$- Qe = Qc\, Gc + Qi\, B\, Gd\, Ge - Qc\, B\, Gd\, Gf \quad ---- 4$$

SUBSTITUTING 4 INTO 1

$$Qc = Qr\, Ga - Gb\, (\, - Qc\, Gc - Qi\, B\, Gd\, Ge + Qc\, B\, Gd\, Gf\, )$$

$$Qc = Qr\, Ga + Qc\, Gb\, Gc + Qi\, B\, Gb\, Gd\, Ge - Qc\, B\, Gb\, Gd\, Gf$$

$$Qc - Qc\, Gb\, Gc + Qc\, B\, Gb\, Gd\, Gf = Qr\, Ga + Qi\, B\, Gb\, Gd\, Ge$$

$$Qc\, (\, 1 - Gb\, Gc + B\, Gb\, Gd\, Gf\, ) = Qr\, Ga + Qi\, B\, Gb\, Gd\, Ge$$

$$Qc = \frac{Qr\, Ga + Qi\, B\, Gb\, Gd\, Ge}{1 - Gb\, Gc + B\, Gb\, Gd\, Gf} \quad ---- 5$$

SUBSTITUTING 5 INTO 3

$$Qo = Qi\, Ge - Gf\, \frac{(\, Qr\, Ga + Qi\, B\, Gb\, Gd\, Ge\, )}{1 - Gb\, Gc + B\, Gb\, Gd\, Gf}$$

$$Qo = Qi\, Ge - \frac{Qr\, Ga\, Gf - Qi\, B\, Gb\, Gd\, Ge\, Gf}{1 - Gb\, Gc + B\, Gb\, Gd\, Gf}$$

TO ELIMINATE THE EFFECT ON THE OUTPUT $Qo$, BY $Qi$

$$1 - Gb\, Gc = 0 \quad ie \quad Gb\, Gc = 1$$

$$Qo = Qi\, Ge - \frac{Qr\, Ga\, Gf}{B\, Gb\, Gd\, Gf} - \frac{Qi\, B\, Gb\, Gd\, Ge\, Gf}{B\, Gb\, Gd\, Gf}$$

$$\frac{Qo}{Qr} = \frac{- Ga}{B\, Gb\, Gd}$$

0188866

$$Qc = Qr\ G1(s)a + Qe\ G1(s)b = Qr\ Ga + Qe\ Gb \ ----\ 1$$

$$Qe = Qc\ G2(s)c + B\ Qo\ G2(s)d = Qc\ Gc + B\ Qo\ Gd \ --\ 2$$

$$Qo = Qi\ G3(s)e - Qc\ G3(s)f \quad = Qi\ Ge - Qc\ Gf \ ---\ 3$$

SUBSTITUTING 3 INTO 2

$$Qe = Qc\ Gc + B\ Gd\ (\ Qi\ Ge - Qc\ Gf\ )$$

$$Qe = Qc\ Gc + Qi\ B\ Gd\ Ge - Qc\ B\ Gd\ Gf \ ----\ 4$$

SUBSTITUTING 4 INTO 1

$$Qc = Qr\ Ga + Gb\ (\ Qc\ Gc + Qi\ B\ Gd\ Ge - Qc\ B\ Gd\ Gf\ )$$

$$Qc = Qr\ Ga + Qc\ Gb\ Gc + Qi\ B\ Gb\ Gd\ Ge - Qc\ B\ Gb\ Gd\ Gf$$

$$Qc - Qc\ Gb\ Gc + Qc\ B\ Gb\ Gd\ Gf = Qr\ Ga + Qi\ B\ Gb\ Gd\ Ge$$

$$Qc\ (\ 1 - Gb\ Gc + B\ Gb\ Gd\ Gf\ ) = Qr\ Ga + Qi\ B\ Gb\ Gd\ Ge$$

$$Qc = \frac{Qr\ Ga + Qi\ B\ Gb\ Gd\ Ge}{1 - Gb\ Gc + B\ Gb\ Gd\ Gf} \ ----\ 5$$

SUBSTITUTING 5 INTO 3

$$Qo = Qi\ Ge - Gf\ \left( \frac{Qr\ Ga + Qi\ B\ Gb\ Gd\ Ge}{1 - Gb\ Gc + B\ Gb\ Gd\ Gf} \right)$$

$$Qo = Qi\ Ge - \frac{Qr\ Ga\ Gf - Qi\ B\ Gb\ Gd\ Ge\ Gf}{1 - Gb\ Gc + B\ Gb\ Gd\ Gf}$$

TO ELIMINATE THE EFFECT ON THE OUTPUT $Qo$, BY $Qi$

$$1 - Gb\ Gc = 0 \quad \text{ie} \quad Gb\ Gc = 1$$

$$Qo = Qi\ Ge - \frac{Qr\ Ga\ Gf}{B\ Gb\ Gd\ Gf} - \frac{Qi\ B\ Gb\ Gd\ Ge\ Gf}{B\ Gb\ Gd\ Gf}$$

$$\frac{Qo}{Qr} = -\frac{Ga}{B\ Gb\ Gd}$$

$Qc = - Qr\ G1(s)a + Qe\ G1(s)b = - Qr\ Ga + Qe\ Gb\ ----1$

$Qe = Qc\ G2(s)c - B\ Qo\ G2(s)d = Qc\ Gc - B\ Qo\ Gd\ ----2$

$Qo = Qi\ G3(s)e + Qc\ G3(s)f = Qi\ Ge + Qc\ Gf\ ------3$

SUBSTITUTING  3  INTO  2

$Qe = Qc\ Gc - B\ Gd\ (\ Qi\ Ge +\ Qc\ Gf\ )$

$Qe = Qc\ Gc - Qi\ B\ Gd\ Ge - Qc\ B\ Gd\ Gf\ ----4$

SUBSTITUTING  4  INTO  1

$Qc = - Qr\ Ga + Gb\ (\ Qc\ Gc - Qi\ B\ Gd\ Ge - Qc\ B\ Gd\ Gf\ )$

$Qc = - Qr\ Ga + Qc\ Gb\ Gc - Qi\ B\ Gb\ Gd\ Ge - Qc\ B\ Gb\ Gd\ Gf$

$Qc - Qc\ Gb\ Gd + Qc\ B\ Gb\ Gd\ Gf = - Qr\ Ga - Qi\ B\ Gb\ Gd\ Ge$

$Qc\ (\ 1 - Gb\ Gd + B\ Gb\ Gd\ Gf\ ) = - Qr\ Ga - Qi\ B\ Gb\ Gd\ Ge$

$$Qc = \frac{- Qr\ Ga - Qi\ B\ Gb\ Gd\ Ge}{1 - Gb\ Gc + B\ Gb\ Gd\ Gf}\ ----5$$

SUBSTITUTING 5  INTO  3

$$Qo = Qi\ Ge + Gf\ \left(\frac{- Qr\ Ga - Qi\ B\ Gb\ Gd\ Ge}{1 - Gb\ Gc + B\ Gb\ Gd\ Gf}\right)$$

$$Qo = Qi\ Ge - \frac{QrGaGf- Qi\ B\ Gb\ Gd\ Ge\ Gf}{1 - Gb\ Gc + B\ Gb\ Gd\ Gf}$$

TO ELIMINATE  THE  EFFECT  ON  THE  OUTPUT  Qo,  BY  Qi

$1 - Gb\ Gc = 0$  ie  $Gb\ Gc = 1$

$$Qo = Qi\ Ge - \frac{Qr\ Ga\ Gf}{B\ Gb\ Gd\ Gf} - \frac{Qi\ B\ Gb\ Gd\ Ge\ Gf}{B\ Gb\ Gd\ Gf}$$

$$\frac{Qo}{Qr} = \frac{- Ga}{B\ Gb\ Gd}$$

$$Q_c = Q_r \, G_1(s)a + Q_e \, G_1(s)b = Q_r \, G_a + Q_e \, G_b \; ---- 1$$

$$Q_e = Q_c \, G_2(s)c - B \, Q_o \, G_2(s)d = Q_c \, G_c - B \, Q_o \, G_d \; ---- 2$$

$$Q_o = Q_i \, G_3(s)e + Q_c \, G_3(s)f = Q_i \, G_e + Q_c \, G_f \; ---- 3$$

SUBSTITUTING 3 INTO 2

$$Q_e = Q_c \, G_c - B \, G_d \, ( \, Q_i \, G_e + Q_c \, G_f \, )$$

$$Q_e = Q_c \, G_c - Q_i \, B \, G_d \, G_e - Q_c \, B \, G_d \, G_f \; ---- 4$$

SUBSTITUTING 4 INTO 1

$$Q_c = Q_r \, G_a + G_b \, ( \, Q_c \, G_c - Q_i \, B \, G_d \, G_e - Q_c \, B \, G_d \, G_f \, )$$

$$Q_c = Q_r \, G_a + Q_c \, G_b \, G_c - Q_i \, B \, G_b \, G_d \, G_e - Q_c \, B \, G_b \, G_d \, G_f$$

$$Q_c - Q_c \, G_b \, G_c + Q_c \, B \, G_b \, G_d \, G_f = Q_r \, G_a - Q_i \, B \, G_b \, G_d \, G_e$$

$$Q_c \, ( \, 1 - G_b \, G_c + B \, G_b \, G_d \, G_f \, ) = Q_r \, G_a - Q_i \, B \, G_b \, G_d \, G_e$$

$$Q_c = \frac{Q_r \, G_a - Q_i \, B \, G_b \, G_d \, G_e}{1 - G_b \, G_c + B \, G_b \, G_d \, G_f} \; ---- 5$$

SUBSTITUTING 5 INTO 3

$$Q_o = Q_i \, G_e + G_f \, \frac{( \, Q_r \, G_a - Q_i \, B \, G_b \, G_d \, G_e \, )}{1 - G_b \, G_c + B \, G_b \, G_d \, G_f}$$

$$Q_o = Q_i \, G_e + \frac{Q_r \, G_a \, G_f - Q_i \, B \, G_b \, G_d \, G_e \, G_f}{1 - G_b \, G_c + B \, G_b \, G_d \, G_f}$$

TO ELIMINATE THE EFFECT ON THE OUTPUT $Q_o$, BY $Q_i$

$$1 - G_b \, G_c = 0 \quad ie \quad G_b \, G_c = 1$$

$$Q_o = Q_i \, G_e + \frac{Q_r \, G_a \, G_f}{B \, G_b \, G_d \, G_f} - \frac{Q_i \, B \, G_b \, G_d \, G_e \, G_f}{B \, G_b \, G_d \, G_f}$$

$$\frac{Q_o}{Q_r} = \frac{G_a}{B \, G_b \, G_d}$$

$- Qc = Qr\ G1(s)a + Qe\ G1(s)b = Qr\ Ga + Qe\ Gb \ - - - - 1$

$Qe = - Qc\ G2(s)c + B\ Qo\ G2(s)d = - Qc\ Gc + B\ Qo\ Gd - - 2$

$Qo = Qi\ G3(s)e + Qc\ G3(s)f = Qi\ Ge + Qc\ Gf \ - - - - 3$

SUBSTITUTING  3  INTO  2

$Qe = - Qc\ Gc + B\ Gd\ (\ Qi\ Ge + Qc\ Gf\ )$

$Qe = - Qc\ Gc + Qi\ B\ Gd\ Ge + Qc\ B\ Gd\ Gf \ - - - - 4$

SUBSTITUTING  4  INTO  1

$- Qc = Qr\ Ga + Gb\ (\ - Qc\ Gc + Qi\ B\ Gd\ Ge + Qc\ B\ Gd\ Gf\ )$

$- Qc = Qr\ Ga - Qc\ Gb\ Gc + Qi\ B\ Gb\ Gd\ Ge + Qc\ B\ Gb\ Gd\ Gf$

$Qc = - Qr\ Ga + Qc\ Gb\ Gc - Qi\ B\ Gb\ Gd\ Ge - Qc\ B\ Gb\ Gd\ Gf$

$Qc - Qc\ Gb\ Gc + Qc\ B\ Gb\ Gd\ Gf = - Qr\ Ga - Qi\ B\ Gb\ Gd\ Ge$

$Qc\ (\ 1 - Gb\ Gc + B\ Gb\ Gd\ Gf\ ) = - Qr\ Ga - Qi\ B\ Gb\ Gd\ Ge$

$$Qc = \frac{- Qr\ Ga - Qi\ B\ Gb\ Gd\ Ge}{1 - Gb\ Gc + B\ Gb\ Gd\ Gf} \ - - - - 5$$

SUBSTITUTING  5  INTO  3

$$Qo = Qi\ Ge + Gf\ \left( \frac{- Qr\ Ga - Qi\ B\ Gb\ Gd\ Ge}{1 - Gb\ Gc + B\ Gb\ Gd\ Gf} \right)$$

$$Qo = Qi\ Ge - \frac{Qr\ Ga\ Gf - Qi\ B\ Gb\ Gd\ Ge\ Gf}{1 - Gb\ Gc + B\ Gb\ Gd\ Gf}$$

TO  ELIMINATE  THE  EFFECT  ON  THE  OUTPUT  Qo,  BY  Qi

$1 - Gb\ Gc = 0$   ie   $Gb\ Gc = 1$

$$Qo = Qi\ Ge - \frac{Qr\ Ga\ Gf}{B\ Gb\ Gd\ Gf} - \frac{Qi\ B\ Gb\ Gd\ Ge\ Gf}{B\ Gb\ Gd\ Gf}$$

$$\frac{Qo}{Qr} = \frac{- Ga}{B\ Gb\ Gd}$$

$$Qc = Qr\ G1(s)a - Qe\ G1(s)b = Qr\ Ga - Qe\ Gb - - - - 1$$

$$Qe = -\ Qc\ G2(s)c + B\ Qo\ G2(s)d = -\ Qc\ Gc + B\ Qo\ Gd - - 2$$

$$Qo = Qi\ G3(s)e + Qc\ G3(s)f = Qi\ Ge + Qc\ Gf - - - - 3$$

SUBSTITUTING 3 INTO 2

$$Qe = -\ Qc\ Gc + B\ Gd\ (\ Qi\ Ge + Qc\ Gf\ )$$

$$Qe = -\ Qc\ Gc + Qi\ B\ Gd\ Ge + Qc\ B\ Gd\ Gf - - - - 4$$

SUBSTITUTING 4 INTO 1

$$Qc = Qr\ Ga - Gb\ (\ -\ Qc\ Gc + B\ Gd\ Ge\ Qi + Qc\ B\ Gd\ Gf\ )$$

$$Qc = Qr\ Ga + Qc\ Gb\ Gd - Qi\ B\ Gb\ Gd\ Ge - Qc\ B\ Gb\ Gd\ Gf$$

$$Qc - Qc\ Gb\ Gc + Qc\ B\ Gb\ Gd\ Gf = Qr\ Ga - Qi\ B\ Gb\ Gd\ Ge$$

$$Qc\ (\ 1 - Gb\ Gc + B\ Gb\ Gd\ Gf\ ) = Qr\ Ga - Qi\ B\ Gb\ Gd\ Ge$$

$$Qc = \frac{Qr\ Ga - Qi\ B\ Gb\ Gd\ Ge}{1 - Gb\ Gc + B\ Gb\ Gd\ Gf}\ -\ -\ -\ 5$$

SUBSTITUTING 5 INTO 3

$$Qo = Qi\ Ge + Gf\ \frac{(\ Qr\ Ga - Qi\ B\ Gb\ Gd\ Ge\ )}{1 - Gb\ Gc + B\ Gb\ Gd\ Gf}$$

$$Qo = Qi\ Ge + \frac{Qr\ Ga\ Gf - Qi\ B\ Gb\ Gd\ Ge\ Gf}{1 - Gb\ Gc + B\ Gb\ Gd\ Gf}$$

TO ELIMINATE THE EFFECT ON THE OUTPUT $Qo$, BY $Qi$

$$1 - Gb\ Gc = 0 \quad ie \quad Gb\ Gc = 1$$

$$Qo = Qi\ Ge + \frac{Qr\ Ga\ Gf}{B\ Gb\ Gd\ Gf} - \frac{Qi\ B\ Gb\ Gd\ Ge\ Gf}{B\ Gb\ Gd\ Gf}$$

$$\frac{Qo}{Qr} = \frac{Ga}{B\ Gb\ Gd}$$

35    0188866

$$Qc = Qi\ G1(s)a + Qe\ G1(s)b = Qi\ Ga + Qe\ Gb\ -----1$$

$$Qe = Qc\ G2(s)c + B\ Qo\ G2(s)d = Qc\ Gc + B\ Qo\ Gd\ ---2$$

$$Qo = -\ Qe\ G3(s) = -\ Qe\ G3\ -----\ 3$$

SUBSTITUTING 3 INTO 2

$$Qe = Qc\ Gc + B\ Gd\ (\ -\ Qe\ G3\ )$$

$$Qe = Qc\ Gc - Qe\ B\ Gd\ G3\ -----4$$

SUBSTITUTING 1 INTO 4

$$Qe = Gc\ (\ Qi\ Ga + Qe\ Gb\ ) - Qe\ Gd\ B\ G3$$

$$Qe = Qi\ Ga\ Gc + Qe\ Gb\ Gc - Qe\ B\ Gd\ G3$$

$$Qe - Qe\ Gb\ Gc + Qe\ B\ Gd\ G3 = Qi\ Ga\ Gc$$

$$Qe\ (\ 1 - Gb\ Gc + B\ Gd\ G3\ ) = Qi\ Ga\ Gc$$

$$Qe = \frac{Qi\ Ga\ Gc}{1 - Gb\ Gc + B\ Gd\ G3}\ -----5$$

SUBSTITUTING 5 INTO 3

$$Qo = -\ G3\ \left(\ \frac{Qi\ Ga\ Gc}{1 - Gb\ Gc + B\ Gd\ G3}\ \right)$$

$$Qo = \frac{-Qi\ Ga\ Gc\ G3}{1 - Gb\ Gc + B\ Gd\ G3}$$

TO ELIMINATE THE EFFECT ON THE OUTPUT Qo, BY G3

$$1 - Gb\ Gc = 0\ \ ie\ Gb\ Gc = 1$$

$$Qo = \frac{-\ Qi\ Ga\ Gc\ G3}{B\ Gd\ G3}$$

$$\frac{Qo}{Qi} = \frac{-\ Ga\ Gc}{B\ Gd}$$

$$Qc = - Qi \, G1(s)a + Qe \, G1(s)b = - Qi \, Ga + Qe \, Gb \;----- 1$$

$$Qe = Qc \, G2(s)c + B \, Qo \, G2(s)d = Qc \, Gc + B \, Qo \, Gd \;----- 2$$

$$Qo = - Qe \, G3(s) = - Qe \, G3 \;----- 3$$

SUBSTITUTING  3 INTO  2

$$Qe = Qc \, Gc + B \, Gd \, ( - Qe \, G3 )$$

$$Qe = Qc \, Gc - Qe \, B \, Gd \, G3 \;---- 4$$

SUBSTITUTING  1  INTO  4

$$Qe = Gc \, ( - Qi \, Ga + Qe \, Gb ) - Qe \, B \, Gd \, G3$$

$$Qe = - Qi \, Ga \, Gc + Qe \, Gb \, Gc - Qe \, B \, Gd \, G3$$

$$Qe - Qe \, Gb \, Gc + Qe \, B \, Gd \, G3 = - Qi \, Ga \, Gc$$

$$Qe \, ( 1 - Gb \, Gc + B \, Gd \, G3 ) = - Qi \, Ga \, Gc$$

$$Qe = \frac{- Qi \, Ga \, Gc}{1 - Gb \, Gc + B \, Gd \, G3} \;---- 5$$

SUBSTITUTING  5  INTO  3

$$Qo = - G3 \, \left( \frac{- Qi \, Ga \, Gc}{1 - Gb \, Gc + B \, Gd \, G3} \right)$$

$$Qo = \frac{Qi \, Ga \, Gc \, G3}{1 - Gb \, Gc + B \, Gd \, G3}$$

TO  ELIMINATE  THE  EFFECT  ON  THE  OUTPUT  QO,  BY  G3

$$1 - Gb \, Gc = 0 \quad \text{ie} \quad Gb \, Gc = 1$$

$$Qo = \frac{Qi \, Ga \, Gc \, G3}{B \, Gd \, G3}$$

$$\frac{Qo}{Qi} = \frac{Ga \, Gc}{B \, Gd}$$

$$Q_c = Q_i \, G1 \, (s)a + Q_e \, G1 \, (s)b = Q_i \, G_a + Q_e \, G_b \; ---- \; 1$$

$$Q_e = Q_c \, G2(s) \, c - B \, Q_o \, G2(s)d = Q_c \, G_c - B \, Q_o \, G_d \; --- \; 2$$

$$Q_o = Q_e \, G3(s) = Q_e \, G3 \; ---- \; 3$$

SUBSTITUTING  3  INTO  2

$$Q_e = Q_c \, G_c - B \, G_d \, ( \, Q_e \, G3 \, )$$

$$Q_e = Q_c \, G_c - Q_e \, B \, G_d \, G3 \; ---- \; 4$$

SUBSTITUTING  1  INTO  4

$$Q_e = G_c \, ( \, Q_i \, G_a + Q_e \, G_b \, ) - Q_e \, B \, G_d \, G3$$

$$Q_e = Q_i \, G_a \, G_c + Q_e \, G_b \, G_c - Q_e \, B \, G_d \, G3$$

$$Q_e - Q_e \, G_b \, G_c + Q_e \, B \, G_d \, G3 = Q_i \, G_a \, G_c$$

$$Q_e \, ( \, 1 \, G_b \, G_c + B \, G_d \, G3 \, ) = Q_i \, G_a \, G_c$$

$$Q_e = \frac{G_a \, G_c \, Q_i}{1 - G_b \, G_c + B \, G_d \, G3} \; ---- \; 5$$

SUBSTITUTING  5  INTO  3

$$Q_o = G3 \, \left( \frac{G_a \, G_c \, Q_i}{1 - G_b \, G_c + B \, G_d \, G3} \right)$$

$$Q_o = \frac{Q_i \, G_a \, G_c \, G3}{1 - G_b \, G_c + B \, G_d \, G3}$$

TO  ELIMINATE  THE  EFFECT  ON  THE  OUTPUT  $Q_o$ ,  BY  G3

$$1 - G_b \, G_c = 0 \quad \text{ie} \quad G_b \, G_c = 1$$

$$Q_o = \frac{Q_i \, G_a \, G_c \, G3}{B \, G_d \, G3}$$

$$\frac{Q_o}{Q_i} = \frac{G_a \, G_c}{B \, G_d}$$

$$Qc = - Qi \; G1(s)a + Qe \; G1(s)b = -Qi \; Ga + Qe \; Gb \; ---- \; 1$$

$$Qe = Qc \; G2(s)c - B \; Qo(s)d = Qc \; Gc - B \; Qo \; Gd \; ---- \; 2$$

$$Qo = Qe \; G3(s) = Qe \; G3 \; ---- \; 3$$

SUBSTITUTING 3 INTO 2

$$Qe = Qc \; Gc - B \; Gd \; ( \; Qe \; G3 \; )$$

$$Qe = Qc \; Gc - Qe \; B \; Gd \; G3 \; ---- \; 4$$

SUBSTITUTING 1 INTO 4

$$Qe = Gc \; ( \; - Qi \; Ga + Qe \; Gb \; ) - Qe \; B \; Gd \; G3$$

$$Qe = -Qi \; Ga \; Gc + Qe \; Gb \; Gc - Qe \; B \; Gd \; G3$$

$$Qe - Qe \; Gb \; Gc + Qe \; B \; Gd \; G3 = - Qi \; Ga \; Gc$$

$$Qe \; ( \; 1 - Gb \; Gc + B \; Gd \; G3 \; ) = - Qi \; Ga \; Gc$$

$$Qe = \frac{- Qi \; Ga \; Gc}{1 - Gb \; Gc + B \; Gd \; G3} \; ---- \; 5$$

SUBSTITUTING 5 INTO 3

$$Qo = G3 \; \left( \frac{- Qi \; Ga \; Gc}{1 - Gb \; Gc + B \; Gd \; G3} \right)$$

$$Qo = \frac{- Qi \; Ga \; Gc \; G3}{1 - Gb \; Gc + B \; Gd \; G3}$$

TO ELIMINATE THE EFFECT ON THE OUTPUT QO , BY G3

$$1 - Gb \; Gc = 0 \quad ie \quad Gb \; Gc = 1$$

$$Qo = \frac{- Qi \; Ga \; Gc \; G3}{B \; Gd \; G3}$$

$$\frac{Qo}{Qi} = \frac{- Ga \; Gc}{B \; Gd}$$

$- Qc = Qi\ G1(s)a + Qe\ G1(s)b = Qi\ Ga + Qe\ Gb - - - - 1$

$Qe = - Qc\ G2(s)c + B\ Qo(s)d = - Qc\ Gc + B\ Qo\ Gd - - - 2$

$Qo = - Qe\ G3(s) = - Qe\ G3 - - - - 3$

SUBSTITUTING 3 INTO 2

$Qe = - Qc\ Gc + B\ Gd\ (\ - Qe\ G3\ )$

$Qe = - Qc\ Gc - Qe\ B\ Gd\ G3 - - - - 4$

SUBSTITUTING 1 into 4

$Qe = - Gc\ (\ - Qi\ Ga - Qe\ Gb\ ) - Qe\ B\ Gd\ G3$

$Qe = Qi\ Ga\ Gc + Qe\ Gb\ Gc - Qe\ B\ Gd\ G3$

$Qe - Qe\ Gb\ Gc + Qe\ B\ Gd\ G3 = Qi\ Ga\ Gc$

$Qe\ (\ 1 - Gb\ Gc + B\ Gd\ G3\ ) = Qi\ Ga\ Gc$

$$Qe = \frac{Qi\ Ga\ Gc}{1 - Gb\ Gc + B\ Gd\ G3} - - - - 5$$

SUBSTITUTING 5 INTO 3

$$Qo = - G3\ (\ \frac{Qi\ Ga\ Gc}{1 - Gb\ Gc + B\ Gd\ G3}\ )$$

$$Qo = \frac{- Qi\ Ga\ Gc\ G3}{1 - Gb\ Gc + B\ Gd\ G3}$$

TO ELIMINATE THE EFFECT ON THE OUTPUT Qo , BY G3

$1 - Gb\ Gc = 0$ ie $Gb\ Gc = 1$

$$Qo = \frac{- Qi\ Ga\ Gc\ G3}{B\ Gd\ G3}$$

$$\frac{Qo}{Qi} = \frac{-Ga\ Gc}{B\ Gd}$$

$$Qc = Qi\ G1(s)a - Qe\ G1(s)b = Qi\ Ga - Qe\ Gb \ - - - - 1$$

$$Qe = -\ Qc\ G2(s)c + B\ Qo\ G2(s)d = -\ Qc\ Gc + B\ Qo\ Gd \ - - 2$$

$$Qo = -\ Qe\ G3(s) = -\ Qe\ G3 \ - - - - 3$$

SUBSTITUTING 3 INTO 2

$$Qe = -\ Qc\ Gc + B\ Gd\ (\ -\ Qe\ G3\ )$$

$$Qe = -\ Qc\ Gc - Qe\ B\ Gd\ G3 \ - - - - 4$$

SUBSTITUTING 1 INTO 4

$$Qe = -\ Gc\ (\ Qi\ Ga - Qe\ Gb\ ) - Qe\ B\ Gd\ G3$$

$$Qe = -\ Qi\ Ga\ Gc + Qe\ Gb\ Gc - Qe\ B\ Gd\ G3$$

$$Qe - Qe\ Gb\ Gc + Qe\ B\ Gd\ G3v = -\ Qi\ Ga\ Gc$$

$$Qe\ (\ 1 - Gb\ Gc + B\ Gd\ G3\ ) = -\ Qi\ Ga\ Gc$$

$$Qe = \frac{-\ Qi\ Ga\ Gc}{1 - Gb\ Gc + B\ Gd\ G3} \ - - - - 5$$

SUBSTITUTING 5 INTO 3

$$Qo = -\ G3\ \left(\ \frac{-\ Qi\ Ga\ Gc}{1 - Gb\ Gc\ B\ Gd\ G3}\ \right)$$

$$Qo = \frac{Qi\ Ga\ Gc\ G3}{1 - Gb\ Gc + B\ Gd\ G3}$$

TO ELIMINATE THE EFFECT ON THE OUTPUT Qo , BY G3

$$1 - Gb\ Gc = 0 \quad ie \quad Gb\ Gc = 1$$

$$Qo = \frac{Qi\ Ga\ Gc\ G3}{B\ Gd\ G3}$$

$$\frac{Qo}{Qi} = \frac{Ga\ Gc}{B\ Gd}$$

$$- Q_c = Q_i G_1(s)a + Q_e G_1(s)c = Q_i G_a + Q_e G_b - - - - 1$$

$$- Q_e = Q_c G_2(s)c + B Q_o G_2(s)d = Q_c G_c + B Q_o G_d - - 2$$

$$Q_o = Q_e G_3(s) = Q_e G_3 - - - - 3$$

SUBSTITUTING 3 INTO 2

$$- Q_e = Q_c G_c + B G_d ( Q_e G_3 )$$

$$- Q_e = Q_c G_c + Q_e B G_d G_3 - - - - 4$$

SUBSTITUTING 1 INTO 4

$$- Q_e = G_c ( - Q_i G_a - Q_e G_b ) + Q_e B G_d G_3$$

$$- Q_e = - Q_i G_a G_c - Q_e G_b G_c + Q_e B G_d G_3$$

$$Q_e = Q_i G_a G_c + Q_e G_b G_c - Q_e B G_d G_3$$

$$Q_e - Q_e G_b G_c + B G_d G_3 Q_e = Q_i G_a G_c$$

$$Q_e ( 1 - G_b G_c + B G_d G_3 ) = Q_i G_a G_c$$

$$Q_e = \frac{Q_i G_a G_c}{1 - G_b G_c + B G_d G_3} - - - - 5$$

SUBSTITUTING 5 INTO 3

$$Q_o = G_3 \left( \frac{Q_i G_a G_c}{1 - G_b G_c + B G_d G_3} \right)$$

$$Q_o = \frac{Q_i G_a G_c G_3}{1 - G_b G_c + B G_d G_3}$$

TO ELIMINATE THE EFFECT ON THE OUTPUT $Q_o$ , BY $G_3$

$$1 - G_b G_c = 0 \quad \text{ie} \quad G_b G_c = 1$$

$$Q_o = \frac{Q_i G_a G_c G_3}{B G_d G_3}$$

$$\frac{Q_o}{Q_i} = \frac{G_a G_c}{B G_d}$$

$$Qc = Qi \; G1(s)a - Qe \; G1(s)b = Qi \; Ga - Qe \; Gb \;----1$$

$$Qe = - Qc \; G2(s)c - B \; Qo \; G2(s)d = - Qc \; Gc - B \; Qo \; Gd \;--2$$

$$Qo = Qe \; G3(s) = Qe \; G3 \;----3$$

SUBSTITUTING  3  INTO  2

$$Qe = - Qc \; Gc - B \; Gd \; ( \; Qe \; G3 \; )$$

$$Qe = - Qc \; Gc - Qe \; B \; Gd \; G3 \;----3$$

SUBSTITUTING  1  INTO  4

$$Qe = - Gc \; ( \; Qi \; Ga - Qe \; Gb \; ) - Qe \; B \; Gd \; G3$$

$$Qe = - Qi \; Ga \; Gc + Qe \; Gb \; Gc - Qe \; B \; Gd \; G3$$

$$Qe - Qe \; Gb \; Gc + Qe \; B \; Gd \; G3 = - Qi \; Ga \; Gc$$

$$Qe \; ( \; 1 - Gb \; Gc + B \; Gd \; G3 \; ) = - Qi \; Ga \; Gc$$

$$Qe = \frac{- \; Ga \; Gc}{1 - Gb \; Gc + B \; Gd \; G3} \;----5$$

SUBSTITUTING  5  INTO  3

$$Qo = G3 \; \left( \frac{- \; Qi \; Ga \; Gc}{1 - Gb \; Gc + B \; Gd \; G3} \right)$$

$$Qo = \frac{- Qi \; Ga \; Gc \; G3}{1 - Gb \; Gc + B \; Gd \; G3}$$

TO  ELIMINATE  THE  EFFECT  ON  THE  OUTPUT  Qo  ,  BY  G3

$$1 - Gb \; Gc = 0 \quad ie \quad Gb \; Gc = 1$$

$$Qo = \frac{- Qi \; Ga \; Gc \; G3}{B \; Gd \; G3}$$

$$\frac{Qo}{Qi} = \frac{- Ga \; Gc}{B \; Gd}$$

$$Qc = Qr\ G1(s)a + Qe\ G1(s)b = Qr\ Ga + Qe\ Gb \;-\;-\;-\;-\;1$$

$$Qe = Qc\ G2(s)c + B\ Qo\ G2(s)d = Qc\ Gc + B\ Qo\ Gd \;-\;-\;2$$

$$Qo = Qi\ G3(s)e + Qe\ G3(s)f = Qi\ Ge - Qe\ Gf \;-\;-\;-\;-\;3$$

SUBSTITUTING 3 INTO 2

$$Qe = Qc\ Gc + B\ Gd\ (\ Qi\ Ge - Qe\ Gf\ )$$

$$Qe = Qc\ Gc + Qi\ B\ Gd\ Ge \quad Qe\ B\ Gd\ Gf \;-\;-\;-\;-\;4$$

SUBSTITUTING 1 INTO 4

$$Qe = Gc\ (\ Qr\ Ga + Qe\ Gb\ ) + Qi\ B\ Gd\ Ge - Qe\ B\ Gd\ Gf$$

$$Qe = Qr\ Ga\ Gc + Qe\ Gb\ Gc + Qi\ B\ Gd\ Ge - Qe\ B\ Gd\ Gf$$

$$Qe - Qe\ Gb\ Gc + Qe\ B\ Gd\ Gf = Qr\ Ga\ Gc + Qi\ B\ Gd\ Ge$$

$$Qe\ (\ 1 - Gb\ Gc + B\ Gd\ Gf\ ) = Qr\ Ga\ Gc + Qi\ B\ Gd\ Ge$$

$$Qe = \frac{Qr\ Ga\ Gc + Qi\ B\ Gd\ Ge}{1 - Gb\ Gc + B\ Gd\ Gf} \;-\;-\;-\;-\;5$$

SUBSTITUTING 5 INTO 3

$$Qo = Qi\ Ge - Gf\ \frac{(\ Qr\ Ga\ Gc + Qi\ B\ Gd\ Ge\ )}{1 - Gb\ Gc + B\ Gd\ Gf}$$

$$Qo = Qi\ Ge - \frac{Qr\ Ga\ Gc\ Gf - Qi\ B\ Gd\ Ge\ Gf}{1 - Gb\ Gc + B\ Gd\ Gf}$$

TO ELIMINATE THE EFFECT ON THE OUTPUT Qo, BY Qi

$$1 - Gb\ Gc = 0 \quad ie \quad Gb\ Gc = 1$$

$$Qo = Qi\ Ge - \frac{Qr\ Ga\ Gc\ Gf}{B\ Gd\ Gf} - \frac{Qi\ B\ Gd\ Ge\ Gf}{B\ Gd\ Gf}$$

$$\frac{Qo}{Qr} = - \frac{Ga\ Gc}{B\ Gd}$$

$$Qc = - Qr \ G1(s)a + Qe \ G1(s)b = - Qr \ Ga + Qe \ Gb \quad ----- 1$$

$$Qe = Qc \ G2(s)c + B \ Qo \ G2(s)d = Qc \ Gc + B \ Qo \ Gd \quad ---- 2$$

$$Qo = Qi \ G3(s)e - Qe \ G3(s)f = Qi \ Ge - Qe \ Gf \quad ------ 3$$

SUBSTITUTING 3 INTO 2

$$Qe = Qc \ Gc + B \ Gd \ ( \ Qi \ Ge - Qe \ Gf \ )$$

$$Qe = Qc \ Gc + Qi \ B \ Gd \ Ge - Qe \ B \ Gd \ Gf \quad ---- 4$$

SUBSTITUTING 1 INTO 4

$$Qe = Gc \ ( \ - Qr \ Ga + Qe \ Gb \ ) + Qi \ B \ Gd \ Ge - Qe \ B \ Gd \ Gf$$

$$Qe = - Qr \ Ga \ Gc + Qe \ Gb \ Gc + Qi \ B \ Gd \ Ge - Qe \ B \ Gd \ Gf$$

$$Qe - Qe \ Gb \ Gc + Qe \ B \ Gd \ Gf = - Qr \ Ga \ Gc + Qi \ B \cdot Gd \ Ge$$

$$Qe \ ( \ 1 - Gb \ Gc + B \ Gd \ Gf \ ) = - Qr \ Ga \ Gc + Qi \ B \ Gd \ Ge$$

$$Qe = \frac{- Qr \ Ga \ Gc + Qi \ B \ Gd \ Ge}{1 - Gb \ Gc + B \ Gd \ Gf} \quad ---- 5$$

SUBSTITUTING 5 INTO 3

$$Qo = Qi \ Ge - Gf \ \frac{( \ - Qr \ Ga \ Gc + Qi \ B \ Gd \ Ge \ )}{1 - Gb \ Gc + B \ Gd \ Gf}$$

$$Qo = Qi \ Ge + \frac{Qr \ Ga \ Gc \ Gf - Qi \ B \ Gd \ Ge \ Gf}{1 - Gb \ Gc + B \ Gd \ Gf}$$

TO ELIMINATE THE EFFECT ON THE OUTPUT Qo, BY Qi

$$1 - Gb \ Gc = 0 \quad ie \quad Gb \ Gc = 1$$

$$Qo = Qi \ Ge + \frac{Qr \ Ga \ Gc \ Gf}{B \ Gd \ Gf} - \frac{Qi \ B \ Gd \ Ge \ Gf}{B \ Gd \ Gf}$$

$$\frac{Qo}{Qi} = \frac{Ga \ Gc}{B \ Gd}$$

$$Qc = Qr\,G1(s)a + Qe\,G1(s)b = Qr\,Ga + Qe\,Gb \; ---- 1$$

$$Qe = Qc\,G2(s)c - B\,Qo\,G2(s)d = Qc\,Gc - B\,Qo\,Gd \; -- 2$$

$$Qo = Qi\,G3(s)e + Qe\,G3(s)f = Qi\,Ge + Qe\,Gf \; ---- 3$$

SUBSTITUTING 3 INTO 2

$$Qe = Qc\,Gc - B\,Gd\,(\,Qi\,Ge + Qe\,Gf\,)$$

$$Qe = Qc\,Gc - Qi\,B\,Gd\,Ge + Qe\,B\,Gd\,Gf \; ---- 4$$

SUBSTITUTING 1 INTO 4

$$Qe = Gc\,(\,Qr\,Ga + Qe\,Gb\,) - Qi\,B\,Gd\,Ge + Qe\,B\,Gd\,Gf$$

$$Qe = Qr\,Ga\,Gc + Qe\,Gb\,Gc - Qi\,B\,Gd\,Ge + Qe\,B\,Gd\,Gf$$

$$Qe - Qe\,Gb\,Gc + Qe\,B\,Gd\,Gf = Qr\,Ga\,Gc - Qi\,B\,Gd\,Ge$$

$$Qe\,(\,1 - Gb\,Gc + B\,Gd\,Gf\,) = Qr\,Ga\,Gc - Qi\,B\,Gd\,Ge$$

$$Qe = \frac{Qr\,Ga\,Gc - Qi\,B\,Gd\,Ge}{1 - Gb\,Gc + B\,Gd\,Gf} \; ----5$$

SUBSTITUTING 5 INTO 3

$$Qo = Qi\,Ge + Gf\,\left(\frac{Qr\,Ga\,Gc - Qi\,B\,Gd\,Ge}{1 - Gb\,Gc + B\,Gd\,Gf}\right)$$

$$Qo = Qi\,Ge + \frac{Qr\,Ga\,Gc\,Gf - Qi\,B\,Gd\,Ge\,Gf}{1 - Gb\,Gc + B\,Gd\,Gf}$$

TO ELIMINATE THE EFFECT ON THE OUTPUT Qo , BY Qi , Ge , Gf

$$1 - Gb\,Gc = 0 \quad ie \quad Gb\,Gc = 1$$

$$Qo = Qi\,Ge + \frac{Qr\,Ga\,Gc\,Gf}{B\,Gd\,Gf} - \frac{Qi\,B\,Gd\,Ge\,Gf}{B\,Gd\,Gf}$$

$$\frac{Qo}{Qr} = \frac{Ga\,Gc}{B\,Gd}$$

$$Qc = - Qr\, G1(s)a + Qe\, G1(s)b = - Qr\, Ga + Qe\, Gb \,-\,-\,-\,-\,1$$

$$Qe = Qc\, G2(s)c - B\, Qo\, G2(s)d = Qc\, Gc - B\, Qo\, Gd \,-\,-\,-\,-\,2$$

$$Qo = Qi\, G3(s)e + Qe\, G3(s)f = Qi\, Ge + Qe\, Gf \,-\,-\,-\,-\,-\,-\,3$$

SUBSTITUTING   3   INTO   2

$$Qe = Qc\, Gc - B\, Gd\, (\, Qi\, Ge + Qe\, Gf\, )$$

$$Qe = Qc\, Gc - Qi\, B\, Gd\, Ge - Qe\, B\, Gd\, Gf \,-\,-\,-\,-\,4$$

SUBSTITUTING   1   INTO   4

$$Qe = Gc\, (\, - Qr\, Ga + Qe\, Gb\, ) - Qi\, B\, Gd\, Ge - Qe\, B\, Gd\, Gf$$

$$Qe = - Qr\, Ga\, Gc + Qe\, Gb\, Gc - Qi\, B\, Gd\, Ge - Qe\, B\, Gd\, Gf$$

$$Qe - Qe\, Gb\, Gc + Qe\, B\, Gd\, Gf = - Qr\, Ga\, Gc - Qi\, B\, Gd\, Ge$$

$$Qe\, (\, 1 - Gb\, Gc + B\, Gd\, Gf\, ) = - Qr\, Ga\, Gc - Qi\, B\, Gd\, Ge$$

$$Qe = \frac{- Qr\, Ga\, Gc - Qi\, B\, Gd\, Ge}{1 - Gb\, Gc + B\, Gd\, Gf} \,-\,-\,-\,-\,5$$

SUBSTITUTING   5   INTO   3

$$Qo = Qi\, Ge + Gf\, \left( \frac{- Qr\, Ga\, Gc - Qi\, B\, Gd\, Ge}{1 - Gb\, Gc + B\, Gd\, Gf} \right)$$

$$Qo = Qi\, Ge - \frac{Qr\, Ga\, Gc\, Gf - Qi\, B\, Gd\, Ge\, Gf}{1 - Gb\, Gc + B\, Gd\, Gf}$$

TO ELIMINATE THE EFFECT ON THE OUTPUT Qo , BY Qi , Ge , Gf

$$1 - Gb\, Gc = 0 \quad ie \quad Gb\, Gc = 1$$

$$Qo = Qi\, Ge - \frac{Qr\, Ga\, Gc\, Gf}{B\, Gd\, Gf} - \frac{Qi\, B\, Gd\, Ge\, Gf}{B\, Gd\, Gf}$$

$$\frac{Qo}{Qr} = \frac{- Ga\, Gc}{B\, Gd}$$

$$- Qc = Qr\, G1(s)a + Qe\, G1(s)b = Qr\, Ga + Qe\, Gb - - - - 1$$

$$Qe = - Qc\, G2(s)c + B\, Qo\, G2(s)d = - Qc\, Gc + B\, Qo\, Gd - 2$$

$$Qo = Qi\, G3(s)e - Qe\, G3(s)f = Qi\, Ge - Qe\, Gf - - - - 3$$

SUBSTITUTING 3 INTO 2

$$Qe = - Qc\, Gc + B\, Gd\, (\quad Qi\, Ge - Qe\, Gf )$$

$$Qe = - Qc\, Gc + Qi\, B\, Gd\, Ge - Qe\, B\, Gd\, Gf - - - - 4$$

SUBSTITUTING 1 INTO 4

$$Qe = - Gc\, (-Qr\, Ga - Qe\, Gb ) + Qi\, B\, Gd\, Ge - Qe\, B\, Gd\, Gf$$

$$Qe = Qr\, Ga\, Gc + Qe\, Gb\, Gc + Qi\, B\, Gd\, Ge - Qe\, B\, Gd\, Gf$$

$$Qe - Qe\, Gb\, Gc + Qe\, B\, Gd\, Gf = Qr\, Ga\, Gc + Qi\, B\, Gd\, Ge$$

$$Qe\, (\, 1 - Gb\, Gc + B\, Gd\, Gf ) = Qr\, Ga\, Gc + Qi\, B\, Gd\, Ge$$

$$Qe = \frac{Qr\, Ga\, Gc + Qi\, B\, Gd\, Ge}{1 - Gb\, Gc + B\, Gd\, Gf} - - - - 5$$

SUBSTITUTING 5 INTO 3

$$Qo = Qi\, Ge - Gf\, \left( \frac{Qr\, Ga\, Gc + Qi\, B\, Gd\, Ge}{1 - Gb\, Gc + B\, Gd\, Gf} \right)$$

$$Qo = Qi\, Ge - \frac{Qr\, Ga\, Gc\, Gf - Qi\, B\, Gd\, Ge\, Gf}{1 - Gb\, Gc + B\, Gd\, Gf}$$

TO ELIMINATE THE EFFECT ON THE OUTPUT Qo , BY Qi , Ge , Gf

$$1 - Gb\, Gc = 0 \quad ie \quad Gb\, Gc = 1$$

$$Qo = Qi\, Ge - \frac{Qr\, Ga\, Gc\, Gf}{B\, Gd\, Gf} - \frac{Qi\, B\, Gd\, Ge\, Gf}{B\, Gd\, Gf}$$

$$\frac{Qo}{Qr} = - \frac{Ga\, Gc}{B\, Gd}$$

$$Qc = Qr\ G1(s)a - Qe\ G1(s)b = Qr\ Ga - Qe\ Gb \text{ --- } 1$$

$$Qe = -\ Qc\ G2(s)c + B\ Qo\ G2(s)d = -\ Qc\ Gc + B\ Qo\ Gd \text{ -- } 2$$

$$Qo = Qi\ G3(s)e - Qe\ G3(s)f = Qi\ Ge - Qe\ Gf \text{ ----- } 3$$

SUBSTITUTING 3 INTO 2

$$Qe = -\ Qc\ Gc + B\ Gd\ (\ Qi\ Ge - Qe\ Gf\ )$$

$$Qe = -\ Qc\ Gc + Qi\ B\ Gd\ Ge - Qe\ B\ Gd\ Gf \text{ ---- } 4$$

SUBSTITUTING 1 INTO 4

$$Qe = -\ Gc\ (\ Qr\ Ga - Qe\ Gb\ ) + Qi\ B\ Gd\ Ge - Qe\ B\ Gd\ Gf$$

$$Qe = -QrGa\ Gc + Qe\ Gb\ Gc + Qi\ B\ Gd\ Ge - Qe\ B\ Gd\ Gf$$

$$Qe - Qe\ Gb\ Gc + Qe\ B\ Gd\ Gf = -\ Qr\ Ga\ Gc + Qi\ B\ Gd\ Ge$$

$$Qe\ (\ 1 - Gb\ Gc + B\ Gd\ Gf\ ) = -\ Qr\ Ga\ Gc + Qi\ B\ Gd\ Ge$$

$$Qe = \frac{-\ Qr\ Ga\ Gc + B\ Gd\ Ge\ Qi}{1 - Gb\ Gc + B\ Gd\ Gf} \text{ --- } 5$$

SUBSTITUTING 5 INTO 3

$$Qo = Qi\ Ge - Gf\ \left(\ \frac{-\ Qr\ Ga\ Gc + B\ Gd\ Ge\ Qi}{1 - Gb\ Gc + B\ Gd\ Gf}\ \right)$$

$$Qo = Qi\ Ge + \frac{Qr\ Ga\ Gc\ Gf - Qi\ Gd\ Ge\ Gf\ B}{1 - Gb\ Gc + B\ Gd\ Gf}$$

TO ELIMINATE THE EFFECT ON THE OUTPUT Qo , BY Qi , Ge , Gf

$$1 - Gb\ Gc = 0 \quad ie \quad Gb\ Gc = 1$$

$$Qo = Qi\ Ge + \frac{Qr\ Ga\ Gc\ Gf}{B\ Gd\ Gf} - \frac{Qi\ B\ Gd\ Ge\ Gf}{B\ Gd\ Gf}$$

$$\frac{Qo}{Qr} = \frac{Ga\ Gc}{B\ Gd}$$

$$- Qc = Qr\ G1(s)a + Qe\ G1(s)b = Qr\ Ga + Qe\ Gb ----- 1$$

$$- Qe = Qc\ G2(s)c + B\ Qo\ G2(s)d = Qc\ Gc + B\ Qo\ Gd -- 2$$

$$Qo = Qi\ G3(s)e + Qe\ G3(s)f = Qi\ Ge + Qe\ Gf ----- 3$$

SUBSTITUTING  3  INTO  2

$$- Qe = Qc\ Gc + B\ Gd\ (\quad Qi\ Ge + Qe\ Gf\ )$$

$$- Qe = Qc\ Gc + Qi\ B\ Gd\ Ge + Qe\ B\ Gd\ Gf ---- 4$$

SUBSTITUTING  1  INTO  4

$$- Qe = Gc\ (\ - Qr\ Ga - Qe\ Gb\ ) + Qi\ B\ Gd\ Ge + Qe\ B\ Gd\ Gf$$

$$- Qe = - Qr\ Ga\ Gc - Qe\ Gb\ Gc + Qi\ B\ Gd\ Ge + Qe\ B\ Gd\ Gf$$

$$Qe = Qr\ Ga\ Gc + Qe\ Gb\ Gc - Qi\ B\ Gd\ Ge - Qe\ B\ Gd\ Gf$$

$$Qe - Qe\ Gb\ Gc + Qe\ B\ Gd\ Gf = Qr\ Ga\ Gc - Qi\ B\ Gd\ Ge$$

$$Qe\ (\ 1 - Gb\ Gc + B\ Gd\ Gf\ ) = Qr\ Ga\ Gc - Qi\ B\ Gd\ Ge$$

$$Qe = \frac{Qr\ Ga\ Gc - Qi\ B\ Gd\ Ge}{1 - Gb\ Gc + B\ Gd\ Gf} ---- 5$$

SUBSTITUTING  5  INTO  3

$$Qo = Qi\ Ge + Gf\ \left( \frac{Qr\ Ga\ Gc - Qi\ B\ Gd\ Ge}{1 - Gb\ Gc + B\ Gd\ Gf} \right)$$

$$Qo = Qi\ Ge + \frac{Qr\ Ga\ Gc\ Gf - Qi\ B\ Gd\ Ge\ Gf}{1 - Gb\ Gc + B\ Gd\ Gf}$$

TO  ELIMINATE  THE  EFFECT  ON  THE  OUTPUT  Qo  ,  BY  Qi , Ge , Gf

$$1 - Gb\ Gc = 0\quad ie\quad Gb\ Gc = 1$$

$$Qo = Qi\ Ge + \frac{Qr\ Ga\ Gc\ Gf}{B\ Gd\ Gf} - \frac{Qi\ B\ Gd\ Ge\ Gf}{B\ Gd\ Gf}$$

$$\frac{Qo}{Qr} = \frac{Ga\ Gc}{B\ Gd}$$

$$Qc = Qr\ G1(s)a - Qe\ G1(s)b = Qr\ Ga - Qe\ Gb ----1$$

$$- Qe = Qc\ G2(s)c + B\ Qo\ G2(s)d = Qc\ Gc + B\ Qo\ Gd - 2$$

$$Qo = Qi\ G3(s)e + Qe\ G3(s)f = Qi\ Ge + Qe\ Gf ----3$$

SUBSTITUTING 3 INTO 2

$$- Qe = Qc\ Gc + B\ Gd\ (\ Qi\ Ge + Qe\ Gf\ )$$

$$- Qe = Qc\ Gc + Qi\ B\ Gd\ Ge + Qe\ B\ Gd\ Gf ----4$$

SUBSTITUTING 1 INTO 4

$$- Qe = Gc\ (\ Qr\ Ga - Qe\ Gb\ ) + Qi\ B\ Gd\ Ge + Qe\ B\ Gd\ Gf$$

$$- Qe = Qr\ Ga\ Gc - Qe\ Gb\ Gc + Qi\ B\ Gd\ Ge + Qe\ B\ Gd\ Gf$$

$$Qe = - Qr\ Ga\ Gc + Qe\ Gb\ Gc - Qi\ B\ Gd\ Ge - Qe\ B\ Gd\ Gf$$

$$Qe - Qe\ Gb\ Gc + Qe\ B\ Gd\ Gf = - Qr\ Ga\ Gc - Qi\ B\ Gd\ Ge$$

$$Qe\ (\ 1 - Gb\ Gc + B\ Gd\ Gf\ ) = - Qr\ Ga\ Gc - Qi\ B\ Gd\ Ge$$

$$Qe = \frac{- Qr\ Ga\ Gc - Qi\ B\ Gd\ Ge}{1 - Gb\ Gc + B\ Gd\ Gf} ----5$$

SUBSTITUTING 5 INTO 3

$$Qo = Qi\ Ge + Gf\ \left( \frac{- Qr\ Ga\ Gc - Qi\ B\ Gd\ Ge}{1 - Gb\ Gc + B\ Gd\ Gf} \right)$$

$$Qo = Qi\ Ge - \frac{Qr\ Ga\ Gc\ Gf - Qi\ B\ Gd\ Ge\ Gf}{1 - Gb\ Gc + B\ Gd\ Gf}$$

TO ELIMINATE THE EFFECT ON THE OUTPUT $Qo$ , BY $Qi$ , $Ge$ , $Gf$

$$1 - Gb\ Gc = 0 \quad ie \quad Gb\ Gc = 1$$

$$Qo = Qi\ Ge - \frac{Qr\ Ga\ Gc\ Gf}{B\ Gd\ Gf} - \frac{Qi\ B\ Gd\ Ge\ Gf}{B\ Gd\ Gf}$$

$$\frac{Qo}{Qr} = - \frac{Ga\ Gc}{B\ Gd}$$

### Derivation of vc Fig 48

$i1 + i6 = i2$

$vo = -A \; v' \quad , \quad v' = - \dfrac{vc}{A}$

$v'' = vio1 + v'$

$\dfrac{vi - v''}{R1} + \dfrac{ve - v''}{R6} = \dfrac{v'' - vc}{R2}$

$\dfrac{vi}{R1} - \dfrac{v''}{R1} + \dfrac{ve}{R6} - \dfrac{v''}{R6} = \dfrac{v''}{R2} - \dfrac{vc}{R2}$

SUDSTITUTING $v'' = vio1 + v'$ INTO ABOVE

$\dfrac{vi}{R1} - \dfrac{vio1}{R1} - \dfrac{v'}{R1} + \dfrac{ve}{R6} - \dfrac{vio1}{R6} - \dfrac{v'}{R6} = \dfrac{vio1}{R2} + \dfrac{v'}{R2} - \dfrac{vc}{R2}$

SUBSTITUTING $v' = -vc/A$ INTO ABOVE

$\dfrac{Vi}{R1} - \dfrac{vio1}{R1} + \dfrac{vc}{A \, R1} + \dfrac{ve}{R6} - \dfrac{vio1}{R6} + \dfrac{vc}{A \, R6} = \dfrac{vio1}{R2} - \dfrac{vc}{A \, R2} - \dfrac{Vc}{R2}$

$0 = \dfrac{vio1}{R2} + \dfrac{vio1}{R1} + \dfrac{vio1}{R6} - \dfrac{vi}{R1} - \dfrac{ve}{R6} - \dfrac{vc}{A \, R1} - \dfrac{vc}{A \, R6} - \dfrac{vc}{A \, R2} - \dfrac{vc}{R2}$

$0 = vio\left(\dfrac{1}{R1} + \dfrac{1}{R2} + \dfrac{1}{R6}\right) - \dfrac{vi}{R1} - \dfrac{ve}{R6} - vc\left(\dfrac{1}{AR1} + \dfrac{1}{AR2} + \dfrac{1}{AR6} + \dfrac{1}{R2}\right)$

$-vc = \dfrac{\dfrac{vi}{R1} + \dfrac{ve}{R6} - vio1\left(\dfrac{1}{R1} + \dfrac{1}{R6} + \dfrac{1}{R2}\right)}{\dfrac{1}{AR1} + \dfrac{1}{AR2} + \dfrac{1}{AR6} + \dfrac{1}{R2}}$

$-vc = \dfrac{vi}{\dfrac{R1}{R2} + \dfrac{1}{A}\left(1 + \dfrac{R1}{R2} + \dfrac{R1}{R6}\right)} + \dfrac{ve}{\dfrac{R6}{R2} + \dfrac{1}{A}\left(1 + \dfrac{R6}{R1} + \dfrac{R6}{R2}\right)} - \dfrac{vio1\left(\dfrac{1}{R1} + \dfrac{1}{R6} + \dfrac{1}{R2}\right)}{\dfrac{1}{A}\left(\dfrac{1}{R1} + \dfrac{1}{R2} + \dfrac{1}{R6}\right) + \dfrac{1}{R2}}$

ASSUMING (A) IS INFINITE AT ZERO FREQUENCY

$-ve = vi \, K1 + ve \, K2 - vio1 \, K3 \quad$ WHERE,

$K1 = \dfrac{1}{\dfrac{R1}{R2} + \dfrac{1}{A}\left(1 + \dfrac{R1}{R2} + \dfrac{R1}{R6}\right)}$

$K3 = 1 + \dfrac{R2}{R1} + \dfrac{R2}{R6}$

$K2 = \dfrac{1}{\dfrac{R6}{R2} + \dfrac{1}{A}\left(1 + \dfrac{R6}{R1} + \dfrac{R6}{R2}\right)}$

## Derivation of ve Fig 49

$$i4 + i5 = i3$$

$$ve = -A\,v' \qquad v' = -ve/A$$

$$v'' = vio2 + v'$$

$$\frac{vo - v''}{R4} + \frac{vc - v''}{R5} = \frac{v'' - ve}{R3}$$

$$\frac{vo}{R4} - \frac{v''}{R4} + \frac{vc}{R5} - \frac{v''}{R5} = \frac{v''}{R3} - \frac{ve}{R3}$$

SUBSTITUTING $v'' = vio + v'$ INTO ABOVE

$$\frac{vo}{R4} - \frac{vio}{R4} - \frac{v'}{R4} + \frac{vc}{R5} - \frac{vio}{R5} - \frac{v'}{R5} = \frac{vio}{R3} + \frac{v'}{R3} - \frac{ve}{R3}$$

SUBSTITUTING $v' = -ve/A$

$$0 = -\frac{vo}{R4} - \frac{vc}{R5} - ve\left(\frac{1}{AR3} + \frac{1}{AR4} + \frac{1}{AR5} + \frac{1}{R3}\right) + vio2\left(\frac{1}{R3} + \frac{1}{R4} + \frac{1}{R5}\right)$$

$$-ve = \frac{\dfrac{vo}{R4} + \dfrac{vc}{R5} - vio2\left(\dfrac{1}{R3} + \dfrac{1}{R4} + \dfrac{1}{R5}\right)}{\dfrac{1}{AR3} + \dfrac{1}{AR4} + \dfrac{1}{AR5} + \dfrac{1}{R3}}$$

$$-ve = \frac{vo}{\dfrac{R4}{R3} + \dfrac{1}{A}\left(1 + \dfrac{R4}{R3} + \dfrac{R4}{R5}\right)} + \frac{vc}{\dfrac{R5}{R3} + \dfrac{1}{A}\left(1 + \dfrac{R5}{R3} + \dfrac{R5}{R4}\right)} - \frac{vio2\left(\dfrac{1}{R3} + \dfrac{1}{R4} + \dfrac{1}{R5}\right)}{\dfrac{1}{A}\left(\dfrac{1}{R3} + \dfrac{1}{R4} + \dfrac{1}{R5}\right) + \dfrac{1}{R3}}$$

ASSUMING (A) IS INFINITE AT ZERO FREQUENCY

$$-ve = vo\,K4 + vc\,K5 - vio^2 K6 \quad \text{WHERE,}$$

$$K4 = \frac{1}{\dfrac{R4}{R3} + \dfrac{1}{A}\left(1 + \dfrac{R4}{R3} + \dfrac{R4}{R5}\right)}$$

$$K5 = \frac{1}{\dfrac{R5}{R3} + \dfrac{1}{A}\left(1 + \dfrac{R5}{R3} + \dfrac{R5}{R4}\right)}$$

$$K6 = 1 + \frac{R3}{R4} + \frac{R3}{R5}$$

Derivation of ve Fig 50

$i3 = i4 + i5$

$$v' = -\frac{ve}{A2}$$

$v'' = vio2 + v'$

$$\frac{v'' - ve}{R3} = i4 + \frac{vc - v''}{R5} \quad ---- 1$$

Now $i4 = \dfrac{v8 - v''}{R4}$

Substituting $v8 = (i7 - i4)R8$ into above

$$i4 = \frac{(i7 - i4)R8 - v''}{R4}$$

$$i4 = \frac{i7R8}{R4} - \frac{i4\,R8}{R4} - \frac{v''}{R4} \quad ---- 2$$

Now $vo = i7\,R7 + (i7 - i4)R8$

$vo = i7\,R7 + .\ i7\,R8 - i4\,R8$

$vo = i7\,(R7 + R8) - i4\,R8$

$$i7 = \frac{vo + i4\,R8}{(R7 + R8)} \quad ----- 3$$

Substituting 3 into 2

$$i4 = \frac{\dfrac{vo + i4\,R8}{(R7 + R8)} \cdot R8}{R4} - \frac{i4\,R8}{R4} - \frac{v''}{R4}$$

$$i4 = \frac{vo\,R8}{(R7 + R8)R4} + \frac{i4\,R8^2}{(R7 + R8)R4} - \frac{i4\,R8}{R4} - \frac{v''}{R4}$$

$$i4\left(1 - \frac{R8^2}{(R7 + R8)R4} + \frac{R8}{R4}\right) = \frac{vo\,R8}{(R7 + R8)R4} - \frac{v''}{R4}$$

$$i4 = \frac{\dfrac{vo\,R8}{(R7 + R8)R4} - \dfrac{v''}{R4}}{1 - \dfrac{R8^2}{(R7 + R8)R4} + \dfrac{R8}{R4}}$$

$$i4 = \cfrac{vo\ R8}{(R7 + R8)\ R4 \left[1 - \cfrac{R8^2}{(R7 + R8)\ R4} + \cfrac{R8}{R4}\right]}$$

$$-\cfrac{v''}{R4 \left[1 - \cfrac{R8^2}{(R7 + R8)\ R4} + \cfrac{R8}{R4}\right]}$$

$$i4 = \cfrac{vo\ R8}{(R7 + R8)\ R4 - \cfrac{((R7 + R8)\ R4)\ R8^2}{(R7 + R8)\ R4} + \cfrac{((R7 + R8)\ R4)\ R8}{R4}}$$

$$-\cfrac{v''}{R4 - \cfrac{R8^2\ R4}{(R7 + R8)\ R4} + \cfrac{R4\ R8}{R4}}$$

$$i4 = \cfrac{vo}{(\frac{R7}{R8} + 1)\ R4 - R8 + R7 + R8} \qquad -\cfrac{v''}{R4 - R8 + \cfrac{R8}{\frac{R7 + 1}{R8}} + R8}$$

$$i4 = \cfrac{vo}{(\frac{R7}{R8} + 1)\ R4 + R7} \qquad \cfrac{-v''\ (R7\ /\ R8 + 1)}{R4\ (\frac{R7}{R8} + 1) - R8 + R8\ (\frac{R7}{R8} + 1)}$$

$$i4 = \cfrac{vo}{(\frac{R7}{R8} + 1)\ R4 + R7} \qquad \cfrac{-v''\ (R7\ /\ R8 + 1)}{R4\ (\frac{R7}{R8} + 1) + R7}$$

$$i4 = \cfrac{vo\ R8}{(R7 + R8)\ R4 + R7\ R8} \qquad -\cfrac{v''\ (R7 + R8)}{(R7 + R8)\ R4 + R7\ R8}$$

$$i4 = vo.f - v''.y \qquad \underline{\qquad\qquad} 4$$

Where $f = R8\ /\ (R7 + R8)\ R4 + R7\ R8$

$$y = (R7 + R8)\ /\ (R7 + R8)\ R4 + R7\ R8$$

Substituting　4　into　1

$$\frac{v'' - ve}{R3} = vo\ f - v''y + \frac{vc - v''}{R5}$$

Substituting　$v'' = vio2 + v'$　into　above

$$\frac{vio2}{R3} + \frac{v'}{R3} - \frac{ve}{R3} = vo\ f - vio2\ y - v'\ y + \frac{vc}{R5} - \frac{vio2}{R5} - \frac{v'}{R5}$$

Substituting　$v' = -ve / A2$　into　above

$$\frac{vio2}{R3} - \frac{ve}{A2\ R3} - \frac{ve}{R3} = vo\ f - vio2\ y + \frac{ve\ y}{A2} + \frac{vc}{R5} - \frac{vio2}{R5} + \frac{ve}{A2\ R5}$$

$$0 = vo\ f + \frac{vc}{R5} + ve\left(\frac{1}{R3} + \frac{1}{A2\ R5} + \frac{1}{A2\ R3} + \frac{y}{A2}\right) - vio2\left(y + \frac{1}{R3} + \frac{1}{R5}\right)$$

$$-ve = \frac{vo\ f + \frac{vc}{R5} - vio2\left(y + \frac{1}{R3} + \frac{1}{R5}\right)}{\left(\frac{1}{R3} + \frac{1}{A2\ R5} + \frac{1}{A2\ R3} + \frac{y}{A2}\right)}$$

$$-ve = \frac{vo\ f}{\frac{1}{R3} + \frac{1}{A2}\left(\frac{1}{R5} + \frac{1}{R3} + y\right)} + \frac{vc}{\frac{R5}{R3} + \frac{1}{A2}\left(1 + \frac{R5}{R3} + yR5\right)}$$

$$- \frac{vio2\left(y + \frac{1}{R3} + \frac{1}{R5}\right)}{\left(\frac{1}{R3} + \frac{1}{A2\ R5} + \frac{1}{A2\ R3} + \frac{y}{A2}\right)}$$

$$-ve = vo\ K4 + vc\ K5 - vio2\ K6$$

Where
$$K4 = f / \frac{1}{R3} + \frac{1}{A2}\left(\frac{1}{R5} + \frac{1}{R3} + y\right)$$

$$K5 = 1 / \frac{R5}{R3} + \frac{1}{A2}\left(1 + \frac{R5}{R3} + yR5\right)$$

$$K6 = \left(y + \frac{1}{R3} + \frac{1}{R5}\right) / \frac{1}{R3} + \frac{1}{A2}\left(\frac{1}{R5} + \frac{1}{R3} + y\right)$$

Type A system voltage/power amplifier  Fig 51

$$- ve = vo\ K4 + vc\ K5 - vio2\ K6 \text{ --- } 1$$

$$- vc = vi\ K1 + ve\ K2 - vio1\ K3 \text{ --- } 2$$

$$vo' = - A3\ vc + vos3 \text{ --- } 3$$

$$vo = vo' - io\ Ro \quad , \quad io = \frac{vo}{ZL}$$

$$\therefore\ vo = vo' - vo\ \frac{Ro}{ZL}$$

$$vo' = \left( 1 + \frac{Ro}{ZL} \right) vo \text{ --- } 4$$

SUBSTITUTING 4 INTO 3

$$\left( 1 + \frac{Ro}{ZL} \right) vo = - A3\ vc + vos3$$

$$vo = \frac{- A3vc + vos3}{1 + \frac{Ro}{ZL}} \text{ --- } 5$$

SUBSTITUTING 5 INTO 1

$$- ve = \left( \frac{- A3vc + vos3}{1 + \frac{Ro}{ZL}} \right) K4 + vc\ K5 - vio2\ K6$$

$$- ve = \frac{-A3\ vc\ K4}{1 + \frac{Ro}{ZL}} + \frac{vos3\ K4}{1 + \frac{Ro}{ZL}} + vc\ K5 - vio2\ K6 \text{ --- } 6$$

SUBSTITUTING 6 INTO 2

$$- vc = vi\ K1 + \left( \frac{+ A3\ vc\ K4}{1 + \frac{Ro}{ZL}} - \frac{vos3\ K4}{1 + \frac{Ro}{ZL}} - vc\ K5 + vio2\ K6 \right)K2 - vio1\ K3$$

$$- vc = vi\ K1 + \frac{vc\ A3\ K4\ K2}{1 + \frac{Ro}{ZL}} - \frac{vos3\ K2\ K4}{1 + \frac{Ro}{ZL}} - vc\ K2\ K5 + vio2\ K6\ K2 - vio1\ K3$$

$$- vc \left(1 + \dfrac{A3\ K4\ K2 - K5\ K2}{1 + \dfrac{Ro}{ZL}}\right) = vi\ K1 - \dfrac{vos3\ K4\ K2 + vio2\ K6\ K2 - vio1\ K3}{1 + \dfrac{Ro}{ZL}}$$

$$- vc = \dfrac{vi\ K1 - \dfrac{vos3\ K2\ K4 + vio2\ K2\ K6 - vio1\ K3}{1 + \dfrac{Ro}{ZL}}}{1 - K2\ K5 + \dfrac{A3\ K2\ K4}{1 + \dfrac{Ro}{ZL}}} \quad ---- 7$$

SUBSTITUTING 7 INTO 5

$$vo = \dfrac{- A3}{1 + \dfrac{Ro}{ZL}} \left[\dfrac{- vi\ K1 + \dfrac{vos3\ K2\ K4 - vio2\ K2\ K6 + vio1\ K3}{1 + \dfrac{Ro}{ZL}}}{1 - K2\ K5 + \dfrac{A3\ K2\ K4}{1 + \dfrac{Ro}{ZL}}}\right] + \dfrac{vos3}{1 + \dfrac{Ro}{ZL}}$$

$$vo = \dfrac{vi\ K1\ A3 - \dfrac{vos3\ K2\ K4\ A3 + vio2\ K2\ K6\ A3 - vio1\ K3\ A3}{1 + \dfrac{Ro}{ZL}} + \dfrac{vos3}{1 + \dfrac{Ro}{ZL}}}{\dfrac{(1 - K2\ K5)(1 + Ro) + A3\ K2\ K4}{ZL}}$$

TO ELIMINATE THE EFFECTS ON THE OUTPUT vo, BY A3,vos3,Ro,ZL

$$1 - K2\ K5 = 0 \quad ie \quad K2\ K5 = 1$$

THEREFORE

$$(1 - K2\ K5)\left(1 + \dfrac{Ro}{ZL}\right) = 0$$

$$v_o = \frac{v_i\ K1\ A3}{K2\ K4\ A3} - \frac{vos3\ K2\ K4\ A3}{\dfrac{(1 + \frac{Ro}{ZL})}{K2\ K4\ A3}} + \frac{vio2\ K2\ K6\ A3}{K2\ K4\ A3} - \frac{vio1\ K3\ A3}{K2\ K4\ A3} + \frac{vos3}{1 + \frac{Ro}{ZL}}$$

$$v_o = \frac{v_i\ K1}{K2\ K4} - \frac{vos3}{1 + \frac{Ro}{ZL}} + \frac{vio2\ K6}{K4} - \frac{vio1\ K3}{K2\ K4} + \frac{vos3}{1 + \frac{Ro}{ZL}}$$

$$v_o = \frac{v_i\ K1}{K2\ K4} + \frac{vio2\ K6}{K4} - \frac{vio1\ K3}{K4\ K2}$$

$$v_o = \frac{v_i\ K1}{K2\ K4} + \frac{1}{K4}\left( vio2\ K6 - \frac{vio1\ K3}{K2} \right) \quad ----\ 8$$

For the above equation to valid $K2\ K5 = 1$ ie

$$\frac{1}{\frac{R6}{R2} + \frac{1}{A1}\left( 1 + \frac{R6}{R1} + \frac{R6}{R2} \right)} \cdot \frac{1}{\frac{R5}{R3} + \frac{1}{A2}\left( 1 + \frac{R5}{R3} + \frac{R5}{R4} \right)} = 1$$

If A1 and A2 are large gain values then

$$\frac{1}{\frac{R6}{R2}} \cdot \frac{1}{\frac{R5}{R3}} = 1 = \frac{R2}{R6}\ \frac{R3}{R5}$$

For example all resistor value can be made equal ie

$$R2 = R3 = R5 = R6$$

If A1 and A2 are not sufficiently large gain values then one of the resistors (R2,R3 R5,R6) can be a preset to adjust K2 K5 to equal unity.

Refering to the output equation 8, the first term ditermines the overall gain of the amplifier. The ERROR FEEDBACK SYSTEM only eliminates the harmonic components , noise etc introduced by A3 so all the voltage gain is provided by A3.

Ignoring the second term in equation 8 for the moment,

0188866

$$vo = \frac{vi\ K1}{K2\ K4}$$

With  A1  and  A2  assumed  very  large,

$$K1 = \frac{R2}{R1}\ ,\qquad K2 = \frac{R2}{R6}\qquad therefore$$

$$vo = \frac{vi\ R2\ /\ R1}{\dfrac{R2}{R6}\ K4}\ ,\ To\ minimise\ the\ voltage\ swing\ of\ vc$$

R1 = R2  also  R2 = R6 ,    vo = vi / K4

To  obtain  gain  K4  must  be  ◀1 .  Now  K4 = R3 / R4

$$\frac{Vo}{Vi} = \frac{1}{R3\ /\ R4}$$

$$\frac{Vo}{Vi} = \frac{R4}{R3}$$

As  R2 = R3 = R5 = R6 ,  R4 is  chosen  to  be  greater  than  R3  so as  to  provide  the  gain .

**With B network**

$$vo = \frac{vi\ K1\ A3 - \dfrac{vos3\ K2\ K4\ A3}{1 + \dfrac{Ro}{ZL}} + vio2\ K2\ K6\ A3 - vio1\ K3\ A3 + \dfrac{vos3}{1 + \dfrac{Ro}{ZL}}}{( 1 - K2\ K5 )( 1 + \dfrac{Ro}{ZL} ) + A3\ K2\ K4}$$

TO ELIMINATE THE EFFECTS ON THE OUTPUT vo, BY A3,vos3,Ro,ZL

$1 - K2\ K5 = 0$ ie $K2\ K5 = 1$

$$vo = \frac{vi\ K1}{K2\ K4} + \frac{1}{K4}( vio2\ K6 - \frac{vio1\ K3}{K2} ) \quad ---- 1$$

For the above equation to be valid $K2\ K5 = 1$ ie

$$\frac{1}{\dfrac{R6}{R2} + \dfrac{1}{A1}( 1 + \dfrac{R6}{R1} + \dfrac{R6}{R2} )} \quad . \quad \frac{1}{\dfrac{R5}{R3} + \dfrac{1}{A2}( 1 + \dfrac{R5}{R3} + y\ R5 )} = 1$$

If A1 and A2 are large gain values then

$$\frac{1}{\dfrac{R6}{R2}} \quad . \quad \frac{1}{\dfrac{R5}{R3}} = 1 = \frac{R2\ R3}{R6\ R5}$$

If for example all resistor values are equal ie

$$R2 = R3 = R5 = R6$$

If A1 and A2 are not sufficiently large gain values then one of the resistors (R2,R3,R5,R6) can be a preset to adjust K2 . K5 to equal unity .

Refering to the output equation 1, the first term ditermines the overall gain of the amplifier. The ERROR FEEDBACK SYSTEM only eliminates the harmonic components , noise etc introduced by A3 so all the gain is provided by A3. With A3 giving the overall gain , the voltage swing at the output of A1 and A2 is minimised so A1 and A2 operate more linearly

Ignoring the second term in equation 1 for the moment,

$$vo = \frac{vi\ K1}{K2\ K4}$$

With A1 and A2 assumed large,

$$K1 = \frac{R2}{R1} \quad , \quad K2 = \frac{R2}{R6} \quad \text{therefore}$$

$$vo = \frac{vi\ .\ R2\ /\ R1}{\dfrac{R2}{R6}\ K4}$$

To minimise the voltage swing of A1 and A2, R1 = R2 = R6

$$vo = vi\ /\ K4$$

Now K4 = f R3 if A2 is assumed large, therefore

$$vo = vi \quad /\ f\ R3$$

$$f = \frac{R8}{(\ R7 + R8\ )\ R4 + R7\ R8}$$

$$vo = vi\ \frac{}{\dfrac{R8\ R3}{(\ R7 + R8\ )\ R4 + R7\ R8}} = vi\ \frac{}{\dfrac{R3}{(\ R7 + 1\ )\ R4 + R7}{R8}}$$

If $(\ R7 + 1\ )\ R4 > R7$ then
$$\frac{}{R8}$$

$$\frac{vo}{vi} = 1\ /\ \frac{R3}{R4}\ .\ \frac{R8}{R7 + R8} = 1\ /\ \frac{R3}{R4}\ .\ B \quad \text{where}\quad B = \frac{R8}{R7 + R8}$$

With R3 = R4

$$\frac{vo}{vi} = \frac{1}{B}$$

Derivation of Output impedance for Type A system
voltage/power amplifier   Fig 51

$R_{out} = \dfrac{vo}{io}$ ,    io in the sense shown

vi = 0 ,   Offset voltages are all zero

$-vc = ve\ K2\ ----\ 1$

$-ve = vo\ K4 + vc\ K5\ ----\ 2$

$vo = vo' + ioRo\ ------\ 3$

$vo' = -A3\ vc\ -------\ 4$

SUBSTITUTING  2  INTO  1

$-vc = K2\ (\ -vo\ K4 - vc\ K5\ )$

$-vc = -vo\ K2\ K4 - vc\ K2\ K5\ ----\ 5$

SUBSTITUTING  3  INTO  5

$-vc = -K2\ K4\ (\ vo' + ioRo\ ) - vc\ K2\ K5$

$-vc = -vo'\ K2\ K4 - ioRo\ K2\ K4 - Vc\ K2\ K5\ ----\ 6$

SUBSTITUTING  4  INTO  6

$-vc = vc\ A3\ K2\ K4 - ioRo\ K2\ K4 - vc\ K2\ K5$

$vc = -vc\ A3\ K2\ K4 + ioRo\ K2\ K4 + vc\ K2\ K5$

$$vc = \frac{ioRo\ K2\ K4}{1 - K2\ K5 + A3\ K2\ K4}\ ----\ 7$$

COMBINING  3 & 4

$ioRo = vo + A3\ vc$

SUBSTITUTING  7  INTO  ABOVE

$$ioRo = vo + A3\ \left(\ \frac{ioRo\ K2\ K4}{1 - K2\ K5 + A3\ K2\ K4}\ \right)$$

$$ioRo = vo + \frac{ioRo\ A3\ K2\ K4}{1 - K2\ K5\ A3\ K2\ K4}$$

$$ioRo - \frac{ioRo\ A3\ K2\ K4}{1 - K2\ K5 + A3\ K2\ K4} = vo$$

$$\text{io Ro} \left( 1 - \frac{\text{A3 K2 K4}}{1 - \text{K2 K5} + \text{A3 K2 K4}} \right) = \text{vo}$$

$$\text{Now Rout} = \frac{\text{vo}}{\text{io}} = \text{Ro} \left( 1 - \frac{\text{A3 K2 K4}}{1 - \text{K2 K5} + \text{A3 K2 K4}} \right)$$

For zero output resistance

$1 - \text{K2 K5} = 0$ ie $\text{K2 K5} = 1$

$$\text{Rout} = \text{Ro} \left( 1 - \frac{\text{A3 K2 K4}}{\text{A3 K2 K4}} \right)$$

$$\underline{\underline{\text{Rout} = 0 \text{ Ohms}}}$$

$$\underline{\text{With B network}}$$

With R7 and R8 the variables K4 and K5 modified ie

$$\text{K4} = \text{f} \left/ \frac{1}{\text{R3}} + \frac{1}{\text{A2}} \left( \frac{1}{\text{R5}} + \frac{1}{\text{R3}} + \text{y} \right) \right.$$

$$\text{K5} = 1 \left/ \frac{\text{R5}}{\text{R3}} + \frac{1}{\text{A2}} \left( 1 + \frac{\text{R5}}{\text{R3}} + \text{yR5} \right) \right.$$

As before

$$\text{Rout} = \text{Ro} \left( 1 - \frac{\text{A3 K2 K4}}{1 - \text{K2 K5} + \text{A3 K2 K4}} \right)$$

If $\text{K2 K5} = 1$

$$\underline{\underline{\text{Rout} = 0 \text{ Ohms}}}$$

## Minimisation of voltage offset at output , Type A
### voltage/power amplfier Fig 51

### Without B network

It is desirable for the voltage offsets of A1 and A2 not to appear at the output ie,

$$\frac{1}{K4} \left( vio2\ K6 - \frac{vio1\ K3}{K2} \right) = 0$$

or

$$\left( vio2\ K6 - \frac{vio1\ K3}{K2} \right) = 0$$

At zero frequency A1 and A2 can be assumed to be very large,

$$K2 = \frac{1}{\dfrac{R6}{R2} + \dfrac{1}{A1}\left( 1 + \dfrac{R6}{R1} + \dfrac{R6}{R2} \right)} = \frac{R2}{R6}$$

$$K3 = 1 + \frac{R2}{R1} + \frac{R2}{R6}$$

$$K6 = 1 + \frac{R3}{R4} + \frac{R3}{R5}$$

With reasonably large gain for A1 and A2 and with K2.K5 = 1 R1=R2=R3=R5=R6 , therefore K2 = 1 , K3 = 3 , K6 = 2 + R3 / R4

Which gives :

$$vio2 \left( 2 + \frac{R3}{R4} \right) - vio1 \cdot 3 = 0$$

Now to obtain overall voltage gain for the amplifier R3 is greater than R4 so if vio1 = vio2 the above equation will not be valid and an offset voltage will appear at the output.

Therefore for zero offset vio2 must be increased or vio1 reduced.

### With B network

As before for zero output voltage offset,

$$\left( vio2\ K6 - \frac{vio1\ K3}{K2} \right) = 0$$

At zero frequency A1 and A2 can be assumed to be very large therefore,

$$K2 = R2 / R6$$

$$K3 = 1 + \frac{R2}{R1} + \frac{R2}{R6}$$

$$K6 = ( y R3 + 1 + \frac{R3}{R5} )$$

With large gain for A1 and A2 and with K2 . K5 = 1 , R = R1 = R2 = R3 = R5 = R6 , therefore K2 = 1 , K3 = 3 Which gives :  vio2 K6 − vio1 . 3 = 0

Now  $$y = \frac{R7 + R8}{( R7 + R8 ) R4 + R7 R8}$$

If ( R7 + R8 ) R4 ≫ R7 R8  then

$$y = \frac{1}{R4}$$

Also if K4 = R

K6 = 3

Which gives :  vio2 . 3 − vio1 . 3 = 0

The above equation is valid ie no voltage offset appears at the output of the amplifierifR1 to R6 are all equal and ( R7 + R8 ) R4 ≫ R7 R8 .

DERIVATION OF LOAD VOLTAGE FOR SERIES CONTROL ELEMENT

(COMMON COLLECTOR AMPLIFIER) Fig 52

$vL = iL\ RL\ \_\ \_\ \_\ \_\ 1$

$iL = ib + ib\ hfe + hoe\ vce\ \_\ \_\ \_\ \_\ 2$

$ib = vi - vL\ /\ hie\ \_\ \_\ \_\ \_\ 3$

SUBSTITUTE 2 INTO 1

$vL = ibRL + ibhfeRL + hoevceRL$

SUBSTITUTE 3 INTO ABOVE

$vL = viRL/hie - vLRL/hie + viRL\ hfe/hie - vL\ hfe\ RL/\ hie + hoe\ vceRL\ \_\ \_\ \_\ 4$

$vce = vs - vL\ \_\ \_\ \_\ \_\ 5$

SUBSTITUTE 5 INTO 4 AND REARRANGING

$vL\ (\ 1 + RL/hie + hfe\ RL/hie + hoe\ RL\ ) = vi\ RL/hie + vi\ RL\ hfe/hie$
$\qquad\qquad\qquad\qquad\qquad\qquad\qquad + vs\ hoe\ RL$

$$vL = \frac{vi\ (\ RL/hie + RL\ hfe/hie\ ) + vs\ hoe\ RL}{1 + RL/hie + hfe\ RL/\ hie + hoeRL}$$

$$vL = \frac{viRL\ hfe/hie + vs\ hoe\ RL}{1 + RL/hie + hfe\ RL/hie + hoe\ RL}\qquad (\ hfe \gg 1\ )$$

$$vL = \frac{vi\ RL\ hfe}{hie + RL\ (\ 1 + hfe + hoe\ hie\ )} + \frac{vs\ hoe\ RL}{1 + RL\ (\ 1\quad + hfe + hoe\ )}$$
$$\qquad\qquad\qquad\qquad\qquad\qquad\qquad\qquad \frac{}{hie}\quad \frac{}{hie}$$

WITH

$hfe \gg hoe\ hie$ , ALSO $hfe \gg 1$ , $hfe/hie > hoe$

$$vL = \frac{vi\ RL\ hfe}{hie + RL\ hfe} + \frac{vs\ hoe\ RL}{1 + RL\ (\ 1\quad + hfe\ )}$$
$$\qquad\qquad\qquad\qquad\qquad \frac{}{hie}\quad \frac{}{hie}$$

$$vL = \frac{vi\ RL\ hfe}{hie + RL\ hfe} + \frac{vs\ hoe\ RL\ hie}{hie + RL\ hfe}$$

$vl = vi\ Ka + vs\ Kb$

WHERE $Ka = \dfrac{RL\ hfe}{hie + RL\ hfe}$ , $Kb = \dfrac{hoe\ RL\ hie}{RLhfe + hie}$

Derivation of vc Fig 53

1936 $v_c = ( va - vb ) A ---- 1$

$ve = i2 ( R1 + R2 )$ , $va = i2 R2$

$$\frac{va}{ve} = \frac{R2}{R1 + R2} ---- 2$$

1940 $i3 = i4$

$$i3 = \frac{vi - vb}{R3} \quad , \quad i4 = \frac{vb - vc}{R4}$$

$$\frac{vi - vb}{R3} = \frac{vb - vc}{R4}$$

1944

$$\frac{vi}{R3} - \frac{vb}{R3} = \frac{vb}{R4} - \frac{vc}{R4}$$

MULTIPLING EACH TERM BY R4 R3,

1948 $vi R4 - vb R4 = Vb R3 - Vc R3$

$vi R4 + vc R3 = Vb R4 + R4 vb$

$vi R4 + Vc R3 = vb ( R3 + R4 )$

$$vb = \frac{vi R4 + Vc R3}{R3 + R4} ---- 3$$

1952

SUBSTITUTING 3 AND 2 INTO 1

$$vc = ( \frac{ve R2}{R1 + R2} - \frac{vi R4 - vc R3}{R3 + R4} ) A$$

1956 $$vc = \frac{ve \, A \, R2}{R1 + R2} - \frac{vi R4 \, A}{R3 + R4} - \frac{vc R3 \, A}{R3 + R4}$$

$$vc + \frac{Vc R3 \, A}{R3 + R4} = \frac{ve R2 \, A}{R1 + R2} - \frac{vi R4 \, A}{R_3 + R4}$$

$$vc \left( 1 + \frac{A\ R3}{R3 + R4} \right) = \frac{ve\ R2\ A}{R1 + R2} - \frac{vi\ R4\ A}{R3 + R4}$$

$$vc = \frac{\dfrac{ve\ R2\ A}{R1 + R2} - \dfrac{vi\ R4\ A}{R3 + R4}}{1 + \dfrac{A\ R3}{R3 + R4}}$$

$$vc = \frac{ve\ R2\ A}{(R1 + R2) \left( 1 + \dfrac{A\ R3}{R3 + R4} \right)} - \frac{vi\ R4\ A}{(R3 + R4) \left( 1 + \dfrac{A\ R3}{R3 + R4} \right)}$$

$$vc = \frac{ve\ R2\ A}{R1 + R2 + \dfrac{A\ R3\ (R1 + R2)}{R3 + R4}} - \frac{vi\ R4\ A}{R3 + R4 + \dfrac{A\ R3\ (R3 + R4)}{R3 + R4}}$$

$$vc = \frac{ve\ R2}{\dfrac{1}{A}(R1 + R2) + \dfrac{R3\ (R1 + R2)}{R3 + R4}} - \frac{vi\ R4}{\dfrac{1}{A}(R3 + R4) + R3}$$

$$vc = ve\ K11 - vi\ K12$$

WHERE,

$$K11 = \frac{R2}{\dfrac{1}{A}(R1 + R2) + \dfrac{R3\ (R1 + R2)}{R3 + R4}}$$

$$K12 = \frac{R4}{\dfrac{1}{A}(R3 + R4) + R3}$$

Type A system voltage regulator Fig 54

$$vO = \frac{vi'RL\ hfe}{hie + RL\ hfe} + \frac{vi\ hoe\ RL\ hie}{hie + RL\ hfe}$$

$$vo = vi'K7 + K8vi = -A\ vc\ K7 + vi\ K8\ -\ -\ -\ -\ -\ -\ -\ -\ -\ 1$$

$$-vc = vr\ K1 + ve\ K2 - vio1\ K3\ -\ -\ -\ -\ -\ -\ -\ -\ -\ -\ 2$$

$$-ve = vo\ K4 + vc\ K5 - vio2\ K6\ -\ -\ -\ -\ -\ -\ -\ -\ -\ -\ 3$$

SUBSTITUTE 3 INTO 2

$$-vc = vr\ K1 +( -vo\ K4 - vc\ K5 +vio2\ K6 )\ K2 - vio1\ K3$$

$$-vc = vr\ K1 - vo\ K4\ K2 - vc\ K5K2 + vio2\ K6\ K2 - vio1\ K3\ -\ -\ -\ -\ 4$$

SUBSTITUTE 1 INTO 4

$$-vc = vrK1-(-AvcK7+viK8)K2K4 -vc\ K5\ K2 +vio2\ K6\ K2 - vio1\ K3$$

$$-vc = vr\ K1 + A\ vc\ K7\ K2\ K4 - vi\ K8\ K2\ K4 - vc\ K5\ K2 + vio2\ K6\ K2 - vio1\ K3$$

$$vc + A\ vc\ K7\ K2\ K4 - vc\ K5\ K2 = -vr\ K1 +vi\ K8\ K2\ K4 -vio2\ K6\ K2 + vio1\ K3$$

$$vc = - \frac{vr\ K1 + vi\ K8\ K2\ K4 - vio2\ K6\ K2 +vio1\ K3}{1 - K5\ K2 + A\ K7\ K2\ K4}\ -\ -\ -\ -\ -\ -\ 5$$

SUBSTITUTING 5 INTO 1

$$vo = \frac{vr\ A\ K1\ K7 - vi\ A\ K8\ K7\ K4\ K2 + vio2\ A\ K7\ K6\ K2 - vio1\ A\ K7\ K3+vi\ K8}{1 - K5\ K2 + K7\ K4\ K2\ A}$$

TO ELIMINATE THE EFFECTS ON THE OUTPUT vo, BY A , K7 , K8

$$1 - K5\ K2 = 0\quad ie\quad K2\ K5 = 1$$

$$vo = \frac{vr\ A\ K1\ K7 - vi\ A\ K8\ K7\ K4\ K2 + vio2\ A\ K7\ K6\ K2 - vio1\ A\ K7\ K3 + vi\ K8}{K7\ K4\ K2\ A}$$

$$vo = \frac{vr\ K1}{K2\ K4} + \frac{vio2\ K6}{K4} - \frac{vio1\ K3}{K4\ K2}$$

NOW K2 K5 = 1

$$\frac{1}{\frac{R6}{R2} + \frac{1}{A1}\left( 1 + \frac{R6}{R1} + \frac{R6}{R2} \right)} \cdot \frac{1}{\frac{R5}{R3} + \frac{1}{A2}\left( + \frac{R5}{R3} + \frac{R5}{R4} \right)} = 1$$

If A1 and A2 are large gain values then

$$\frac{1}{\dfrac{R6}{R2}} \cdot \frac{1}{\dfrac{R5}{R3}} = 1 = \frac{R2\ R3}{R6\ R5} = K2\ K5$$

For example all resistor values can be made equal ie,

$$R2 = R3 = R5 = R6 = R$$

If A1 And A2 are not sufficiently large gain values then one of the resistors (R2,R3,R5,R6) can be a preset to adjust K2.K5 to equal unity. With the above assumptions in gain and resistor values ,

$$K2 = 1$$

Therefore $$vo = \frac{vr\ K1}{K4} + \frac{vio2\ K6}{K4} - \frac{vio1\ K3}{K4}$$

Also if R1 = R4 = R

$$K1 = K4 = 1$$

Which gives $$vo = vr + vio2\ K6 - vio1\ K3$$

Now $$K3 = 1 + \frac{R2}{R1} + \frac{R2}{R6} = 3$$

$$K6 = 1 + \frac{R3}{R4} + \frac{R3}{R5} = 3$$

Substituting into the output equation

$$vo = vr + vio2 \cdot 3 - vio1 \cdot 3$$

If
vio2 = vio1    $$\underline{vo = vr}$$

## With B network

With the B network and A1 , A2 assumed large gain values ,

$$K4 = f \cdot R3$$

$$K5 = \frac{R3}{R5}$$

$$K6 = y\ R3 + 1 + \frac{R3}{R5}$$

Now with K2 K5 = 1 and R1 to R6 = R,

$$vo = \frac{vr}{K4} + \frac{vio2\ K6}{K4} - \frac{vio1.\ 3}{K4}$$

$$K4 = f\ .\ R3 = \frac{R8\ R3}{(\ R7 + R8\ )\ R4 + R7\ R8}$$

If ( R7 + R8 ) R4    R7 R8    then

$$K4 = \frac{R8}{R7 + R8}\ .\ \frac{R3}{R4}$$

$$K4 = B\ .\ \frac{R3}{R4}$$

$$K4 = B$$

Therefore

$$vo = \frac{vr}{B} + \frac{vio2\ K6}{B} - \frac{vio1\ .\ 3}{B}$$

Now

$$K6 = y\ R3 + 1 + \frac{R3}{R5}$$

$$K6 = y\ R3 + 2$$

$$K6 = \frac{(\ R7 + R8\ )\ R3}{(\ R7 + R8\ )\ R4 + R7\ R8}$$

If    $(\ R7 + R8\ )\ R4 \gg R7\ R8$    then

$$K6 = \frac{R3 + 2}{R4}$$

$$K6 = 3$$

Therefore

$$vo = \frac{vr}{B} + \frac{vio2\ .\ 3}{B} - \frac{vio1\ .\ 3}{B}$$

If vio1 = vio2

$$vo = \frac{1}{B}$$

## Derivation of ve Fig 55 and Fig 56

$$i6 = i5 - i1$$

$$i5 = \frac{vc - ve}{R5} \quad , \quad i1 = \frac{ve}{R1 + R2} \quad , \quad i6 = \frac{ve - vo}{R6}$$

$$\therefore \; i6 = \frac{vc - ve}{R6} - \frac{ve}{R1 + R2}$$

$$\frac{ve - vo}{R6} = \frac{vc - ve}{R5} - \frac{ve}{R1 + R2}$$

$$R1 + R2 = R$$

$$\frac{ve - vo}{R6} = \frac{vc - ve}{R5} - \frac{ve}{R}$$

$$\frac{ve}{R6} - \frac{vo}{R6} = \frac{vc}{R5} - \frac{ve}{R5} - \frac{ve}{R}$$

$$ve\left( \frac{1}{R6} + \frac{1}{R5} + \frac{1}{R} \right) = \frac{vc}{R5} + \frac{v0}{R6}$$

$$ve = \frac{vc}{\frac{R5 + R5}{R6} + 1} + \frac{vo}{\frac{R6 + R6}{R5} + 1}$$

$$ve = vc \, K9 + vo \, K10$$

WHERE,

$$K9 = \frac{1}{\frac{R5 + R5}{R6} + 1}$$

$$K10 = \frac{1}{\frac{R6 + R6}{R5} + 1}$$

Type B system voltage/power amplifier Fig 55

$$vc = ve\ K11 - vi\ K12\ ----- 1$$

$$ve = vc\ K9 + vo\ K10\ ----- 2$$

$$vo = vo' - io\ Ro\ ,\ io = \frac{vo}{ZL}$$

$$vo = vo' - \frac{vo\ Ro}{ZL}$$

$$vo' = vo\ \left(1 + \frac{Ro}{ZL}\right)$$

SUBSTITUTING $vo' = -A3\ ve$ IN TO ABOVE ,

$$vo = \frac{-A3\ ve}{1 + \frac{Ro}{ZL}}\ ---- 3$$

SUBSTITUTING 3 INTO 2

$$ve = vc\ K9 + K10\ \frac{(-ve\ A3)}{1 + \frac{Ro}{ZL}}$$

$$ve = vc\ K9 - \frac{ve\ A3\ K10}{1 + \frac{Ro}{Zl}}\ ---- 4$$

SUBSTITUTING 1 INTO 4

$$ve = K9\ (ve\ K11 - vi\ K12) - \frac{ve\ A3\ K10}{1 + \frac{Ro}{ZL}}$$

$$ve = ve\ K9\ K11 - vi\ K9\ K12 - \frac{ve\ A3\ K10}{1 + \frac{Ro}{ZL}}$$

$$ve - ve\ K9\ K11 + \frac{ve\ K10\ A3}{1 + \frac{Ro}{ZL}} = -\ vi\ K9\ K12$$

$$2124 \quad ve\ (\ 1 - K9\ K11 + \frac{A3\ K10}{1 + \frac{Ro}{ZL}}\ ) = -\ vi\ K9\ K12$$

$$2128 \quad ve = \frac{-\ vi\ K9\ K12}{1 - K9\ K11 + \frac{A3\ K10}{1 + \frac{Ro}{ZL}}} \ - - - - 5$$

SUBSTITUTING 5 INTO 3

$$2132 \quad vo = \frac{-\ A3}{1 + \frac{Ro}{ZL}} \cdot \frac{(\ -\ vi\ K9\ K12\ )}{1 - K9\ K11 + \frac{A3\ K10}{1 + \frac{Ro}{ZL}}}$$

$$2136 \quad vo = \frac{vi\ A3\ K9\ K12}{(\ 1 + \frac{Ro}{ZL}\ )\ (\ 1 - K9\ K11\ ) + A3\ K10}$$

TO ELIMINATE THE EFFECT ON vo BY A3,

$$2140 \quad 1 - K9\ K11 = 0 \quad ie \quad K9\ K11 = 1$$

$$vo = \frac{vi\ K9\ K12}{K10}$$

$$2144 \quad \frac{vo}{vi} = \frac{K9\ K12}{K10}$$

## Type B system voltage regulator Fig 56

$$vc = ve\ K11 - vr\ K12 - - - - - 1$$

$$ve = vc\ K9 + vo\ K10 - - - - - 2$$

$$vo = \frac{vi'\ RL\ hfe}{hie + RL\ hfe} + \frac{vi\ hoe\ RL\ hie}{hie + RL\ hfe}$$

$$vo = vi'\ K7 + vi\ K8 = -\ ve\ A3\ K7 + vi\ K8 - - - - - 3$$

SUBSTITUTING  3  INTO  2

$$ve = vc\ K9 + K10\ (\ -\ ve\ A3\ K7 + vi\ K8\ )$$

$$ve = vc\ K9 - ve\ A3\ K7\ K10 + vi\ K8\ K10 - - - - - 4$$

SUBSTITUTING  1  INTO  4

$$ve = K9\ (\ ve\ K11 - vr\ K12\ ) - ve\ A3\ K7\ K10 + vi\ K8\ K10$$

$$ve = ve\ K9\ K11 - vr\ K9\ K12 - ve\ A3\ K7\ K10 + vi\ K8\ K10$$

$$ve - ve\ K9\ K11 + ve\ A3\ K7\ K10 = -\ vr\ K9\ K12 + vi\ K8\ K10$$

$$ve\ (\ 1 - K9\ K11 + A3\ K7\ K10\ ) = -\ vr\ K9\ K12 + vi\ K8\ K10$$

$$ve = \frac{-\ vr\ K9\ K12 + vi\ K8\ K10}{1 - K9\ K11 + A3\ K7\ K10} - - - - - 5$$

SUBSTITUTING  5  INTO  3

$$vo = \frac{-\ A3\ K7\ (\ -\ vr\ K9\ K12 + vi\ K8\ K10\ )}{1 - K9\ K11 + A3\ K7\ K10} + vi\ K8$$

$$vo = \frac{vr\ A3\ K7\ K9\ K12 - vi\ A3\ K7\ K8\ K10}{1 - K9\ K11 + A3\ K7\ K10} + vi\ K8$$

TO  ELIMINATE  THE  EFFECT  vo  BY  vi , A3 , K7 , K8

$$1 - K9\ K11 = 0\ \ ie\ \ K9\ K11 = 1$$

$$vo = \frac{vr\ A3\ K7\ K9\ K12}{A3\ K7\ K10} - \frac{vi\ A3\ K7\ K8\ K10}{A3\ K7\ K10} + vi\ K8$$

$$\frac{vo}{vr} = \frac{K9\ K12}{K10}$$

Calculation of resistor values For Type B systems

Now

$$K9 = 1 \Big/ \frac{R5}{R6} + \frac{R5}{R} + 1$$

$$K10 = 1 \Big/ \frac{R6}{R5} + \frac{R6}{R} + 1$$

$$K11 = R2 \Big/ \frac{1}{A1} ( R1 + R2 ) + \frac{R3 ( R1 + R2 )}{R3 + R4}$$

$$K12 = R4 \Big/ \frac{1}{A1} ( R3 + R4 ) + R3$$

K9 K11 = 1   ie

$$\frac{1}{\frac{R5}{R6} + \frac{R5}{R} + 1} \cdot \frac{R2}{\frac{1}{A1} ( R1 + R2 ) + \frac{R3 ( R1 + R2 )}{R3 + R4}} = 1$$

If  R1 = R3 = Ra  ,  R2 = R4 = Rb  and  A1  is  very  large

$$\frac{1}{\frac{R5}{R6} + \frac{R5}{R} + 1} \cdot \frac{Rb}{\frac{Ra ( Ra + Rb )}{Ra + Rb}} = 1$$

$$\frac{1}{\frac{R5}{R6} + \frac{R5}{R} + 1} \cdot \frac{Rb}{Ra} = 1$$

$$\frac{R6 R}{R5 R + R5 R6 + R R6} \cdot \frac{Rb}{Ra} = 1$$

$$\frac{Rb}{Ra} = \frac{R5 R + R5 R6 + R R6}{R6 R} = \frac{R5}{R6} + \frac{R5}{R} + 1 \quad ---- 1$$

Now

$$\frac{vo}{vi} = 1 \Big/ \frac{R5}{R6} + \frac{R5}{R} + 1 \cdot \frac{R4 \Big/ \frac{1}{A1} ( R3 + R4 ) + R3}{1 \Big/ \frac{R6}{R5} + \frac{R6}{R} + 1}$$

If A1 is very large,

$$\frac{vo}{vi} = \frac{1}{\dfrac{R5}{R6} + \dfrac{R5}{R} + 1} \cdot \frac{R4}{R3} = \frac{R6\,R}{(R\,R5 + R5\,R6 + R\,R6)} \cdot \frac{R4}{R3}$$

$$\frac{\dfrac{R5\,R}{1}}{\dfrac{R6}{R5} + \dfrac{R6}{R} + 1} \qquad \frac{R5\,R}{R6\,R + R6\,R5 + R5\,R}$$

$$\frac{vo}{vi} = \frac{R6\,R}{R5\,R} \cdot \frac{(R6\,R + R5\,R6 + R5\,R)}{(R\,R5 + R5\,R6 + R\,R6)} \cdot \frac{R4}{R3} = \frac{R6}{R5} \cdot \frac{R4}{R3}$$

$$\frac{vo}{vi} = \frac{R6}{R5} \cdot \frac{Rb}{Ra}$$

Substituting 1 into above

$$\frac{vo}{vi} = \frac{R6}{R5} \cdot \left( \frac{R5}{R6} + \frac{R5}{R} + 1 \right)$$

$$\frac{vo}{vi} = 1 + \frac{R6}{R5} + \frac{R6}{R}$$

Transposing the above equation to make R the subject of the formula :

$$R = \frac{R5\,R6}{R5\,(G - 1) - R6} \qquad \text{where} \quad G = \frac{vo}{vi} \qquad \text{---- 2}$$

Now From 1

$$K = \frac{Rb}{Ra} = \frac{R5}{R6} + \frac{R5}{R} + 1 \qquad \text{---- 3}$$

Also $\quad \dfrac{Rb}{Ra} = K$

$$Rb = K\,Ra \qquad \text{---------- 4}$$

Assuming a value for R5 , R6 and G and by using eq 2 will give R , this can be sustituted into 2 to give K which in turn given Ra can be placed in 4 to give Rb ( R2 , R4 ).

CLAIMS

1    A Multiple loop feebback system arrangment which may be used to construct a control system (see Ref 1 ), a electronic amplifier or electronic regulator comprising:

an output amplifier ( or control unit ) G3(s) , a feedback network ( or element )B(s) whose input is coupled to the output of the said output amplifier ( or control unit ) , a signal combining block G2(s) having two inputs Gc and Gd respectively coupled to the input of said output amplifier ( or control unit ) and to the output of said feedback network ( or element ) B(s) , a combining block G1(s) having a input Gb coupled to the output of said combining block G2(s) and a input Ga forming the signal input Qi of said arrangment and a output coupled to the input of said output amplifier ( or control unit ) , the output of said amplifier ( or control unit ) forming the output of said arrangment.

2    A Multiple loop feedback system arrangment which may be used to constuct a control system (see Ref 1 ), a electronic amplifier or electronic regulator comprising:

an output amplifier ( or control unit ) G3(s) having two inputs Ge and Gf, a feedback network ( or element ) B(s) whose input is coupled to the output of the said output amplifier ( or control unit ) , a signal combining block G2(s) having two inputs Gc and Gd respectively coupled to the Gf input of said output amplifier ( or control unit ) and to the output of said feedback network ( or element ) B(s), a signal combining block G1(s) having two inputs Gb and Ga respectively coupled to the output of said signal combining block G2(s) and a signal input forming the first input Qr to said arrangment and a output which is coupled to the Gf input of said output amplifier ( or control unit ) , the Ge input of said output amplifier ( or control unit ) forming the second input Qi to the said arrangment , the output of said output amplifier ( or control unit ) forming the output of said arrangment.

3     A Multiple loop feedback system arrangment which may be used to construct a control system ( see Ref 1 ) , an electronic amplifier or electronic regulator Comprising:

    an output amplifier ( or control unit ) $G3(s)$ , a feedback network ( or element ) $B(s)$ whose input is coupled to the output of the said output amplifier ( or control unit ) , a signal combining block $G1(s)$ having an input Gb coupled to the input of said output amplifier ( or control unit ) and a input Ga forming the signal input Qi of said arrangment , a signal combining block $G2(s)$ having two inputs Gc and Gd respectively coupled to the output of said signal combining block $G1(s)$ and to the output of said feedback network ( or element ) $B(s)$ and a output coupled to the input of said amplifier ( or control unit ) , the output of said amplifier ( or control unit ) forming the output of said arrangment.

4     A Multiple loop feedback system arrangment which may be used to construct a control system ( se Ref 1 ) an electronic amplifier or electronic regulator comprising: an output amplifier (or control unit) $G3(s)$ having two inputs Ge and Gf a feedback network ( or element ) $B(s)$ whose input is coupled to the output of said output amplifier ( or control unit ) , a signal combining block $G1(s)$ having a input Gb coupled to the said input Gf of the output amplifier ( or control unit ) and a input Ga forming the signal input Qr of said arrangment , a signal combining block $G2(s)$ having two inputs Gc and Gd respectively coupled to the output of said combining block $G1(s)$ and to the output of the said feedback network ( or element ) $B(s)$ and a output coupled to the said input Gf of the output amplifier ( or control unit ), the Ge input of said output amplifier ( or control unit ) forming the second signal input Qi to said arrangment , the output of said output amplifier ( or control unit) forming the output of said arrangment .

5     A Multiple loop feedback system arrangment as claimed in claims 1 or 2 or 3 or 4 where the signal path around the loop formed by $Gb(s) . Gc(s)$ is non inverting:

$$\underline{/Gb(s)} + \underline{/Gc(s)} = \underline{/0^o}$$

Therefore positive feedback loop is formed with a net phase shift around the loop of zero degrees.

6     A Multiple loop feedback system arrangment as claimed in claim 1 where the signal path around the loop formed by $Gb(s) . G3(s) . B(s) . Gd(s)$ is inverting:

$$\angle Gb(s) + \angle G3(s) + \angle B(s) + \angle Gd(s) = \angle 180^{o} = -1$$

Therefore a negative feedback loop is formed with a net phase shift around the loop of 180 degrees.

7     A Multiple loop feedback system arrangment as claimed in claim 2 where the signal path around the loop formed by $Gb(s) . Gf(s) . B(s) . Gd(s)$ is inverting:

$$\angle Gb(s) + \angle Gf(s) + \angle B(s) + \angle Gd(s) = \angle 180^{o} = -1$$

Therefore a negative feedback loop is formed with a net phase shift around the loop of 180 degrees.

8     A Multiple loop feedback system arrangment as claimed in claim 3 where the signal path around the loop formed by $Gd(s) . G3(s) . B(s)$ is inverting:

$$\angle Gd(s) + \angle G3(s) + \angle B(s) = \angle 180^{o} = -1$$

Therefore a negative feedback loop is formed with a net phase shift around the loop of 180 degrees.

9     A Multiple loop feedback system arrangment as claimed in claim 4 where the signal path around the loop formed by $Gd(s) . Gf(s) . B(s)$ is inverting:

$$\angle Gd(s) + \angle Gf(s) + \angle B(s) = \angle 180^{o} = -1$$

Therefore negative feedback loop is formed with a net phase shift around the loop of 180 degrees.

10     A Multiple loop feedback system arrangment as claimed in claim 6 where the output and input of the said arrangment is described by the following equation:

$$\frac{Qo}{Qi} = \frac{\pm Ga(s) \, G3(s)}{1 - Gb(s) \, Gc(s) + B(s) \, Gb(s) \, Gd(s) \, G3(s)}$$

11     A Multiple loop feedback system arrangment as claimed in claim 7 where the output and input of the said arrangment is related by the following equation:

$$Qo = \frac{Qi Ge(s) \pm Qr Ga(s)Gf(s) - Qi B(s)Gb(s)Gd(s)Ge(s)Gf(s)}{1 - Gb(s) \, Gc(s) + B(s) \, Gb(s) \, Gd(s) \, Gf(s)}$$

12    A Multiple loop feedback system arrangment as claimed in claim 8 where the output and input of the said arrangment is related by the following equation:

$$\frac{Qo}{Qi} = \frac{\pm\ Ga(s)\ Gc(s)\ G3(s)}{1 - Gb(s)\ Gc(s) + B(s)\ Gd(s)\ G3(s)}$$

13    A Multiple loop feedback system arrangment as claimed in claim 9 where the output and input of the said arrangment is related by the following equation:

$$Qo = \frac{QiGe(s)\pm QrGa(s)Gc(s)Gf(s) - QiB(s)Gd(s)Ge(s)Gf(s)}{1 - Gb(s)\ Gc(s) + B(s)\ Gd(s)\ Gf(s)}$$

14    A Multiple loop feedback system arrangment as claimed in claims 10 or 11 or 12 or 13 where $1 - Gb(s).Gc(s) = 0$

15    A Multiple loop feedback system arrangment as claimed in claims 10or11or12or13 where G1(s)&G2(s) are electronic amplifiers , G3(s) is an electronic amplifier and B(s) is a resistor attenuator.

16    A Multiple loop feedback system arrangment as claimed in claim 10 or 11 or 12 or 13 where one signal combiner is a electronic amplifier and the other is a resistor summing network.

17    A multiple loop feedback system arrangment substantially as described with reference to the accompanying drawings.

FIG.1.

FIG.2.

0188866

FIG.5.

FIG.6.

FIG.7.

FIG.8.

FIG.9.

0188866

G1s

G3s

θi○

θC

○θo

θE

βθo

β

G2s

FIG.10.

G1s

G3s

θi○

θC

○θo

θE

βθo

β

G2s

FIG.11.

FIG.12.

FIG.13.

0188866

FIG.14

FIG.15.

FIG.16.

FIG.17.

FIG.18.

FIG.19.

FIG.20.

FIG.21.

0188866

FIG.22.

FIG.23.

0188866

FIG.24.

FIG.25.

FIG.26.

FIG.27.

FIG.28.

FIG.29.

0188866

FIG.30.

FIG.31.

FIG.32.

FIG.33.

0188866

FIG.34.

FIG.35.

0188866

16/30

FIG.36.

FIG.37.

FIG.38.

FIG.39.

FIG.40.

FIG.41.

18/30 0188866

FIG.42.

0188866

FIG.43.

FIG.44.

21/30

0188866

θo

θi

θr

G3as

G1as

G2as

Ba

G3bs

G1bs

G2bs

Bb

FIG.45.

FIG.46.

FIG.47.

FIG.48.

FIG.49.

FIG.50.

FIG.51.

27/30

0188866

FIG.52.

FIG.53.

FIG.54.

FIG.55.

FIG.56.